# EUROPEAN PATENT SPECIFICATION

(11) **EP 4 351 302 B1**
(45) Date of publication and mention of the grant of the patent: **29.04.2026**
(21) Application number: 23200517.3
(22) Date of filing: 28.09.2023
(51) Int. Cl.: H10K 85/60, C09K 11/06, H10K 101/00, H10K 50/12, H10K 85/30

(54) **LIGHT-EMITTING DEVICE INCLUDING CONDENSED CYCLIC COMPOUND, ELECTRONIC APPARATUS AND ELECTRONIC EQUIPMENT INCLUDING THE LIGHT-EMITTING DEVICE, AND THE CONDENSED CYCLIC COMPOUND**
LICHTEMITTIERENDE VORRICHTUNG MIT KONDENSIERTER CYCLISCHER VERBINDUNG, ELEKTRONISCHE VORRICHTUNG UND ELEKTRONISCHES GERÄT MIT DER LICHTEMITTIERENDEN VORRICHTUNG UND KONDENSIERTE CYCLISCHE VERBINDUNG
DISPOSITIF ÉLECTROLUMINESCENT COMPRENANT UN COMPOSÉ CYCLIQUE CONDENSÉ, APPAREIL ÉLECTRONIQUE ET ÉQUIPEMENT ÉLECTRONIQUE COMPRENANT LE DISPOSITIF ÉLECTROLUMINESCENT, ET LE COMPOSÉ CYCLIQUE CONDENSÉ

(30) Priority: 07.10.2022 KR 20220129052
(43) Date of publication of application: 10.04.2024
(73) Proprietor: Samsung Display Co., Ltd., Yongin-si, Gyeonggi-do 17113 (KR)
(72) Inventor: JUNG, Minjung, 17113 Yongin-si (KR); KIM, Taeil, 17113 Yongin-si (KR); PAK, Sunyoung, 17113 Yongin-si (KR); SUNWOO, Kyoung, 17113 Yongin-si (KR); SIM, Munki, 17113 Yongin-si (KR); OH, Chanseok, 17113 Yongin-si (KR)
(74) Representative: Marks & Clerk LLP

(56) References cited:
- WO-A1-2021/020942
- CN-A- 112 940 023
- KR-A- 20210 023 254
- KR-A- 20210 055 873
- KR-A- 20220 069 352
- US-A1- 2021 277 026
- US-A1- 2022 306 655

## Description

### BACKGROUND

### 1. Field

One or more embodiments of the present disclosure relate to a light-emitting device including a condensed cyclic compound, electronic equipment and an electronic apparatus that include the light-emitting device, and the condensed cyclic compound.

### 2. Description of the Related Art

Light-emitting devices are self-emissive devices that have wide viewing angles, high contrast ratios, short response times, and excellent or suitable characteristics in terms of brightness, driving voltage, and response speed.

Light-emitting devices may include a first electrode on a substrate, and a hole transport region, an emission layer, an electron transport region, and a second electrode sequentially stacked on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons transition and decay from an excited state to a ground state to thus generate light.
US 2022/306655 A1 relates to an organic compound, an application thereof, and an organic electroluminescent device. KR 2021 0023254 A relates to a compound and an organic light emitting device comprising the same. WO 2021/020942 A1 relates to an organic light-emitting element. KR 2022 0069352 A relates to a heterocyclic compound based on spiro acridine and an organic light emitting device comprising the same. CN 112 940 023 A relates to an organic compound, the application thereof and an organic light emitting device adopting the organic compound.

### SUMMARY

One or more aspects of embodiments of the present disclosure are directed toward a light-emitting device including a condensed cyclic compound, an electronic apparatus and electronic equipment including the light-emitting device, and the condensed cyclic compound.

Additional aspects will be set forth in part in the description which follows and, in part, will be apparent from the description, or may be learned by practice of the presented embodiments of the disclosure.

According to one or more embodiments of the present disclosure, a light-emitting device may include:
a first electrode;
a second electrode facing the first electrode; and
an interlayer between the first electrode and the second electrode and including an emission layer,
wherein the light-emitting device may include a condensed cyclic compound represented by Formula 1: 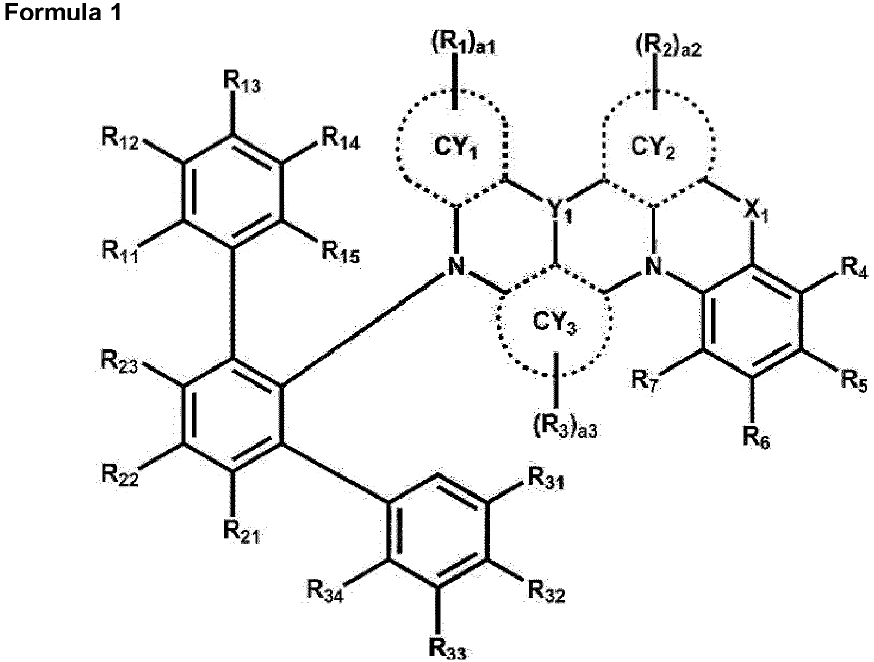
wherein, in Formula 1,
X₁ may be a single bond,
Y₁ may be N, B, P(=O), or P(=S),
ring CY₁ to ring CY₃ may each independently be a C₅-C₆₀ carbocyclic group or a C₂-C₆₀ heterocyclic group,
a1 to a3 are each independently an integer from 0 to 10,
R₁ to R₉, R₁₁ to R₁₅, R₂₁ to R₂₃, and R₃₁ to R₃₄ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁),-S(=O)₂(Q₁), or -P(=O)(Q₁)(Q₂),
at least two groups selected from R₁ to R₉, R₁₁ to R₁₅, R₂₁ to R₂₃, and R₃₁ to R₃₄ may optionally be bound to each other to form a C₅-C₃₀ carbocyclic group unsubstituted or substituted with at least one R₁₀ₐ or a C₂-C₃₀ heterocyclic group unsubstituted or substituted with at least one R₁₀ₐ, wherein R₃ and R₇ are not bound to each other to form a C₅-C₃₀ carbocyclic group unsubstituted or substituted with at least one R₁₀ₐ or a C₂-C₃₀ heterocyclic group unsubstituted or substituted with at least one R₁₀ₐ, and
R₁₀ₐ may be:
   deuterium, -F, -Cl, -Br, -I, a hydroxyl group, or a nitro group;
   a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃),-N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
   a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group,-Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁),-P(=O)(Q₂₁)(Q₂₂), or any combination thereof; or
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or-P(=O)(Q₃₁)(Q₃₂),
   wherein Q₁ to Q₃, Q₁₁ to Q₁₃, Q₂₁ to Q₂₃, and Q₃₁ to Q₃₃ may each independently be:
      hydrogen, deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, or a C₁-C₆₀ alkoxy group; or
      a C₃-C₆₀ carbocyclic group, a C₁-C₆₀ heterocyclic group, a C₇-C₆₀ aryl alkyl group, or a C₂-C₆₀ heteroaryl alkyl group, each unsubstituted or substituted with deuterium, -F, a cyano group, a C₁-C₆₀ alkyl group, a C₁-C₆₀ alkoxy group, a phenyl group, a biphenyl group, or any combination thereof.

According to one or more embodiments of the present disclosure, an electronic apparatus may include the light-emitting device.

According to one or more embodiments of the present disclosure, electronic equipment may include the light-emitting device.

According to one or more embodiments of the present disclosure, the condensed cyclic compound represented by Formula 1 is provided.

At least some of the above and other features of the invention are set out in the claims.

### BRIEF DESCRIPTION OF THE DRAWINGS

The accompanying drawings are included to provide a further understanding of the present disclosure and are incorporated in and constitute a part of the present disclosure. The drawings illustrate embodiments of the present disclosure and, together with the description, serve to explain principles of the present disclosure. The above and other aspects, features, and advantages of certain embodiments of the disclosure will be more apparent from the following description taken in conjunction with the accompanying drawings, in which:
FIG. 1 is a schematic view of a light-emitting device according to one or more embodiments of the present disclosure;
FIG. 2 is a schematic view of an electronic apparatus according to one or more embodiments of the present disclosure;
FIG. 3 is a schematic view of an electronic apparatus according to one or more embodiments of the present disclosure;
FIG. 4 is a perspective view schematically illustrating electronic equipment including a light-emitting device according to one or more embodiments of the present disclosure;
FIG. 5 is a schematic view illustrating an exterior of a vehicle as electronic equipment including a light-emitting device according to one or more embodiments of the present disclosure; and
FIGs. 6A-6C are each a schematic view illustrating an interior of a vehicle according to one or more embodiments of the present disclosure.

### DETAILED DESCRIPTION

Reference will now be made in more detail to embodiments, examples of which are illustrated in the accompanying drawings, wherein like reference numerals refer to like elements throughout the present disclosure, and duplicative descriptions thereof may not be provided for conciseness. In this regard, the embodiments of the present disclosure may have different forms and should not be construed as being limited to the descriptions set forth herein. Accordingly, the embodiments of the present disclosure are merely described, by referring to the drawings, to explain aspects of the present disclosure. As utilized herein, the term "and/or" or "or" may include any and all combinations of one or more of the associated listed items. Throughout the disclosure, the expression "at least one of a, b, or c" indicates only a, only b, only c, both (e.g., simultaneously) a and b, both (e.g., simultaneously) a and c, both (e.g., simultaneously) b and c, all of a, b, and c, or variations thereof.

In one or more embodiments, a light-emitting device may include:
a first electrode;
a second electrode facing the first electrode; and
an interlayer between the first electrode and the second electrode and including an emission layer,
wherein the light-emitting device may include a condensed cyclic compound represented by Formula 1: 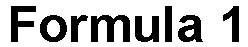 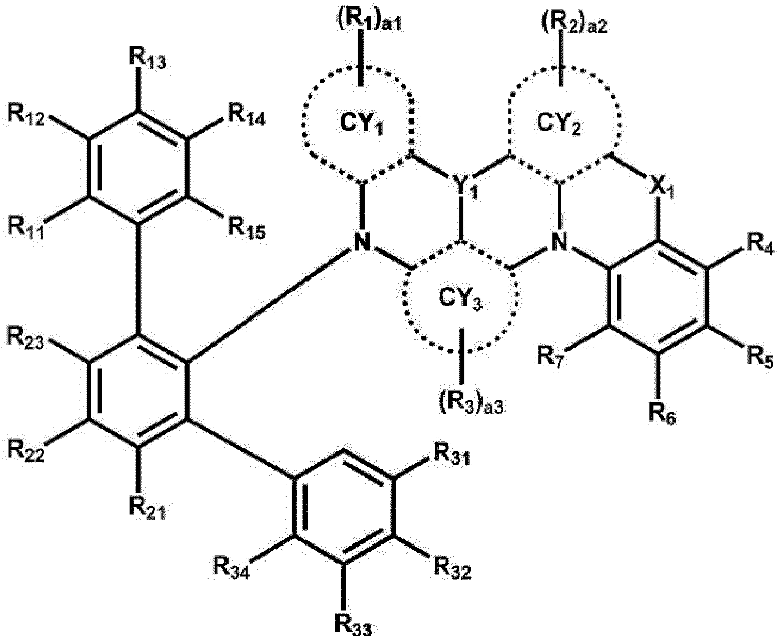
wherein, in Formula 1,
X₁ may be a single bond,
Y₁ may be N, B, P(=O), or P(=S),
ring CY₁ to ring CY₃ may each independently be a C₅-C₆₀ (e.g. C₅-C₃₀) carbocyclic group or a C₂-C₆₀ (e.g. C₂-C₂₀) heterocyclic group,
a1 to a3 are each independently an integer from 0 to 10,
R₁ to R₉, R₁₁ to R₁₅, R₂₁ to R₂₃, and R₃₁ to R₃₄ may each independently be hydrogen, deuterium, -F, -Cl, -Br, -I, a hydroxyl group, a cyano group, a nitro group, a C₁-C₆₀ (*e.g.* C₁-C₂₀) alkyl group unsubstituted or substituted with at least one R₁₀ₐ, a C₂-C₆₀ (*e.g.* C₂-C₂₀) alkenyl group unsubstituted or substituted with at least one R₁₀ₐ, a C₂-C₆₀ (*e.g.* C₂-C₂₀) alkynyl group unsubstituted or substituted with at least one R₁₀ₐ, a C₁-C₆₀ (*e.g.* C₁-C₂₀) alkoxy group unsubstituted or substituted with at least one R₁₀ₐ, a C₁-C₆₀ (*e.g.* C₁-C₂₀) alkylthio group unsubstituted or substituted with at least one R₁₀ₐ, a C₃-C₆₀ (*e.g*. C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ, a C₆-C₆₀ (*e.g.* C₆-C₃₀) aryloxy group unsubstituted or substituted with at least one R₁₀ₐ, a C₆-C₆₀ (*e.g.* C₆-C₃₀) arylthio group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁),-S(=O)₂(Q₁), or -P(=O)(Q₁)(Q₂),
at least two groups selected from R₁ to R₉, R₁₁ to R₁₅, R₂₁ to R₂₃, and R₃₁ to R₃₄ may optionally be bound to each other to form a C₅-C₃₀ (*e.g.* C₅-C₂₀) carbocyclic group unsubstituted or substituted with at least one R₁₀ₐ or a C₂-C₃₀ (*e.g.* C₂-C₂₀) heterocyclic group unsubstituted or substituted with at least one R₁₀ₐ, wherein R₃ and R₇ are not bound to each other to form a C₅-C₃₀ carbocyclic group unsubstituted or substituted with at least one R₁₀ₐ or a C₂-C₃₀ heterocyclic group unsubstituted or substituted with at least one R₁₀ₐ, and
R₁₀ₐ may be:
   deuterium, -F, -Cl, -Br, -I, a hydroxyl group, or a nitro group;
   a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, or a C₁-C₆₀ (e.g. C₁-C₂₀) alkoxy group, each unsubstituted or substituted with deuterium, -F, -Cl, -Br, -I, a hydroxyl group, a cyano group, a nitro group, a C₃-C₆₀ (*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, a C₆-C₆₀ (*e.g.* C₆-C₃₀) arylthio group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁),-P(=O)(Q₁₁)(Q₁₂), or any combination thereof;
   a C₃-C₆₀ (*e.g*. C₃-C₃₀) carbocyclic group, a C₁-C₆₀ (e.g. C₁-C₂₀) heterocyclic group, a C₆-C₆₀ (*e.g.* C₆-C₃₀) aryloxy group, or a C₆-C₆₀ (e.g. C₆-C₃₀) arylthio group, each unsubstituted or substituted with deuterium, -F, -Cl, -Br, -I, a hydroxyl group, a cyano group, a nitro group, a C₁-C₆₀ (*e.g.* C₁-C₂₀) alkyl group, a C₂-C₆₀ (e.g. C₂-C₂₀) alkenyl group, a C₂-C₆₀ (*e.g.* C₂-C₂₀) alkynyl group, a C₁-C₆₀ (e.g. C₁-C₂₀) alkoxy group, a C₃-C₆₀ (*e.g*. C₃-C₃₀) carbocyclic group, a C₁-C₆₀ (*e.g.* C₁-C₂₀) heterocyclic group, a C₆-C₆₀ (e.g. C₆-C₃₀) aryloxy group, a C₆-C₆₀ (e.g. C₆-C₃₀) arylthio group,-Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁),-P(=O)(Q₂₁)(Q₂₂), or any combination thereof; or
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or-P(=O)(Q₃₁)(Q₃₂),
   wherein Q₁ to Q₃, Q₁₁ to Q₁₃, Q₂₁ to Q₂₃, and Q₃₁ to Q₃₃ may each independently be:
      hydrogen, deuterium, -F, -Cl, -Br, -I, a hydroxyl group, a cyano group, a nitro group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, or a C₁-C₆₀ (*e.g.* C₁-C₂₀) alkoxy group; or
      a C₃-C₆₀ (*e.g*. C₃-C₃₀) carbocyclic group, a C₁-C₆₀ (*e.g.* C₁-C₂₀) heterocyclic group, a C₇-C₆₀ (*e.g.* C₇-C₃₀) aryl alkyl group, or a C₂-C₆₀ (*e.g.* C₂-C₂₀) heteroaryl alkyl group, each unsubstituted or substituted with deuterium, -F, a cyano group, a C₁-C₆₀ (*e.g.* C₁-C₂₀) alkyl group, a C₁-C₆₀ (*e.g.* C₁-C₂₀) alkoxy group, a phenyl group, a biphenyl group, or any combination thereof.

In the light-emitting device according to one or more embodiments, the interlayer may include the condensed cyclic compound represented by Formula 1.

In the light-emitting device according to one or more embodiments, the emission layer may include the condensed cyclic compound represented by Formula 1.

In the light-emitting device according to one or more embodiments, the emission layer may include a host and a dopant, and the dopant may include the condensed cyclic compound.

In the light-emitting device according to one or more embodiments, the condensed cyclic compound may be a fluorescent dopant.

In the light-emitting device according to one or more embodiments, the host may include a first host and a second host, the first host may be an electron transporting host, and the second host may be a hole transporting host.

In the light-emitting device according to one or more embodiments, the first host may include at least one azine moiety, and the second host may include at least one carbazole moiety.

In the light-emitting device according to one or more embodiments, the first host may be represented by Formula 5: 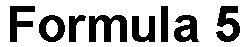 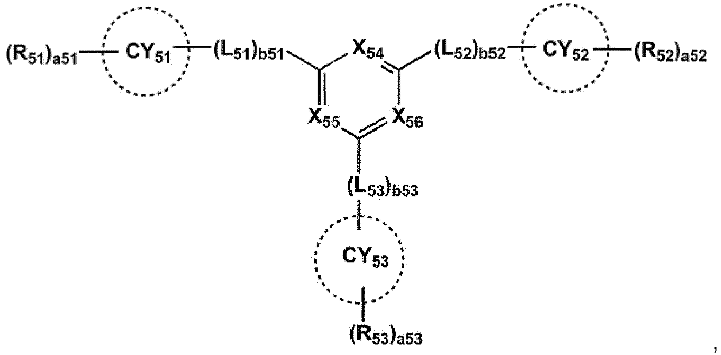 wherein, in Formula 5,
X₅₄ to X₅₆ may each independently be C(R₅₀), CH, or N, and at least one selected from among X₅₄ to X₅₆ may be N,
ring CY₅₁ to ring CY₅₃ may each independently be a C₅-C₆₀ (*e.g.* C₅-C₃₀) carbocyclic group or a C₁-C₆₀ (*e.g.* C₁-C₂₀) heterocyclic group,
L₅₁ to L₅₃ may each independently be a C₃-C₆₀ (*e.g.* C₃-C₃₂) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
b51 to b53 may each independently be an integer from 0 to 3,
when b51 is 0, *-(L₅₁)_{b51}-*' may be a single bond,
when b52 is 0, *-(L₅₂)_{b52}-*' may be a single bond,
when b53 is 0, *-(L₅₃)_{b53}-*' may be a single bond,
R₅₀ to R₅₃ may each be the same as the description of R₁₀ₐ in Formula 1, and
a51 to a53 may each independently be an integer from 0 to 10.

In the light-emitting device according to one or more embodiments, ring CY₅₁ to ring CY₅₃ in Formula 5 may each independently be i) a first ring, ii) a second ring, iii) a condensed ring in which at least two first rings are condensed, iv) a condensed ring in which at least two second rings are condensed, or v) a condensed ring in which at least one first ring is condensed with at least one second ring,
the first ring may be a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group, and
the second ring may be a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, or an azadibenzofuran group.

In the light-emitting device according to one or more embodiments, in Formula 5, ring CY₅₁ to ring CY₅₃ may each independently be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

In the light-emitting device according to one or more embodiments, in Formula 5, L₅₁ to L₅₃ may each independently be a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group.

In the light-emitting device according to one or more embodiments, the first host may be at least one selected from among Formulae ET-1 to ET-3:

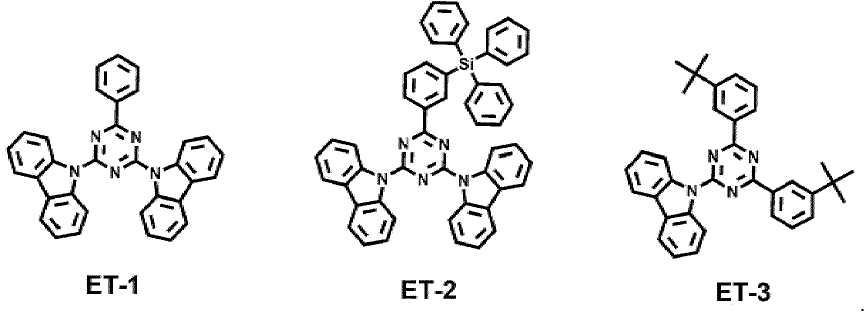

In the light-emitting device according to one or more embodiments, the second host may include a moiety represented by Formula 7: 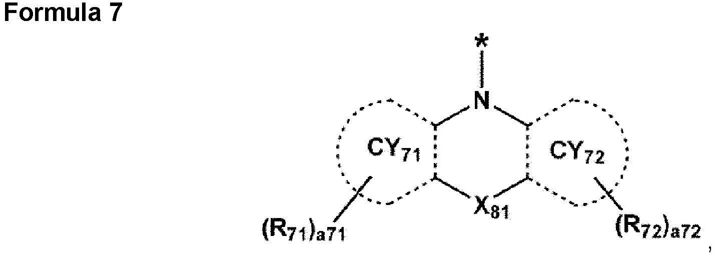 wherein, in Formula 7,
ring CY₇₁ and ring CY₇₂ may each independently be a C₅-C₆₀ (e.g. C₅-C₃₃) carbocyclic group or a C₁-C₆₀ (e.g. C₁-C₂₀) heterocyclic group,
X₈₁ may be a single bond, O, S, N(R₈₁), B(R₈₁), C(R₈₁ₐ)(R_{81b}), or Si(R₈₁ₐ)(R_{81b}),
R₇₁, R₇₂, R₈₁, R₈₁ₐ, and R_{81b} may each be the same as the description of R₁₀ₐ in Formula 1, and
a71 and a72 may each independently be an integer from 0 to 10.

In the light-emitting device according to one or more embodiments, ring CY₇₁ and ring CY₇₂ in Formula 7 may each independently be i) a first ring, ii) a second ring, iii) a condensed ring in which at least two first rings are condensed, iv) a condensed ring in which at least two second rings are condensed, or v) a condensed ring in which at least one first ring is condensed with at least one second ring,
the first ring may be a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group, and
the second ring may be a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, or an azadibenzofuran group.

In the light-emitting device according to one or more embodiments, in Formula 7, ring CY₇₁ and ring CY₇₂ may each independently be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

In the light-emitting device according to one or more embodiments, the second host may be represented by one selected from among Formulae 7-1 to 7-5: 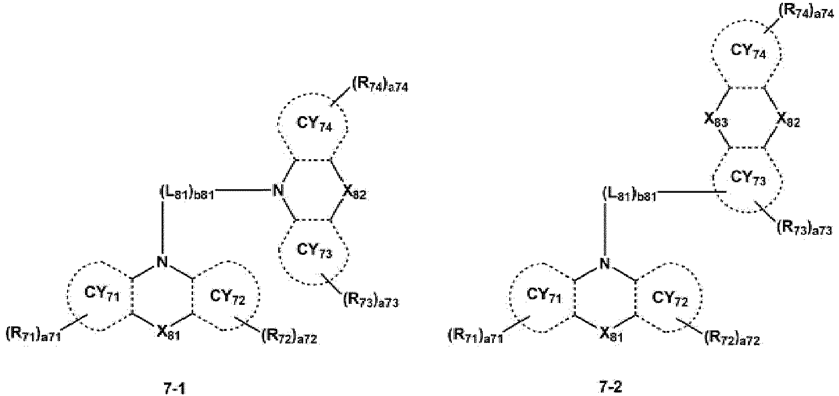 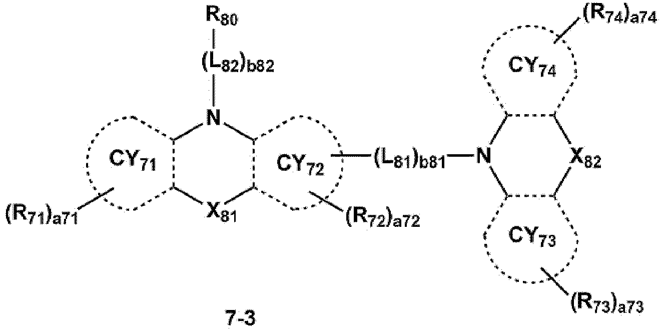 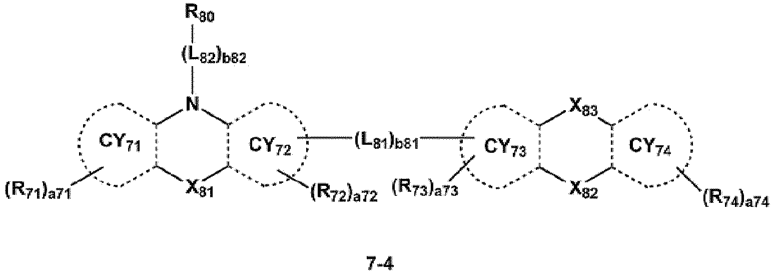 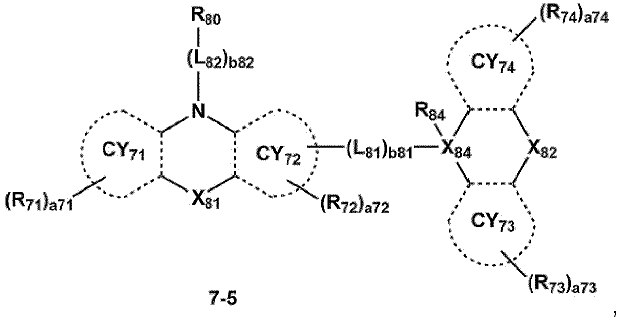 wherein, in Formulae 7-1 to 7-5,
ring CY₇₁, ring CY₇₂, X₈₁, R₇₁, R₇₂, a71, and a72 may respectively be understood by referring to the descriptions of ring CY₇₁, ring CY₇₂, X₈₁, R₇₁, R₇₂, a71, and a72 provided herein,
ring CY₇₃, ring CY₇₄, R₇₃, R₇₄, a73, and a74 may respectively be the same as the descriptions of ring CY₇₁, ring CY₇₂, R₇₁, R₇₂, a71, and a72 provided herein,
L₈₁ and L₈₂ may each independently be selected from *-C(Q₄)(Q₅)-*', *-Si(Q₄)(Q₅)-*', a substituted or unsubstituted C₅-C₃₀ (e.g. C₅-C₂₀) carbocyclic group, and a substituted or unsubstituted C₁-C₃₀ (e.g. C₁-C₂₀) heterocyclic group,
Q₄ and Q₅ may each be the same as the description of Q₁ provided herein,
b81 and b82 may each independently be an integer from 0 to 5, when b81 is 0, *-(L₈₁)_{b81}-*' may be a single bond, when b81 is 2 or greater, at least two L₈₁(s) may be identical to or different from each other, when b82 is 0, *-(L₈₂)_{b82}-*' may be a single bond, and when b82 is 2 or greater, at least two L₈₂(s) may be identical to or different from each other,
X₈₂ may be a single bond, O, S, N(R₈₂), B(R₈₂), C(R₈₂ₐ)(R_{82b}), or Si(R₈₂ₐ)(R_{82b}),
X₈₃ may be a single bond, O, S, N(R₈₃), B(R₈₃), C(R₈₃ₐ)(R_{83b}), or Si(R₈₃ₐ)(R_{83b}),
In Formulae 7-2 and 7-4, X₈₂ and X₈₃ may not both (e.g., simultaneously) be a single bond,
X₈₄ may be C or Si,
R₈₀, R₈₂, R₈₃, R₈₂ₐ, R_{82b}, R₈₃ₐ, R_{83b}, and R₈₄ may each be the same as the description of R₈₁ provided herein, and
* and *' each indicate a binding site to an adjacent atom.

In the light-emitting device according to one or more embodiments,
a moiety represented by 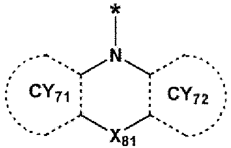 in Formulae 7-1 and 7-2 may be selected from groups represented by Formulae CY71-1(1) to CY71-1(8),
a moiety represented by 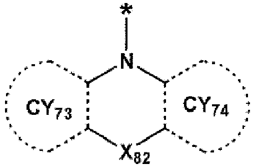 in Formulae 7-1 and 7-3 may be selected from groups represented by Formulae CY71-2(1) to CY71-2(8),
a moiety represented by 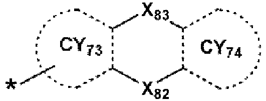 in Formulae 7-2 and 7-4 may be selected from groups represented by Formulae CY71-3(1) to CY71-3(32),
a moiety represented by 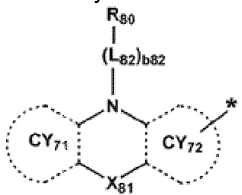 in Formulae 7-3 to 7-5 may be selected from groups represented by Formulae CY71-4(1) to CY71-4(32), and
a moiety represented by 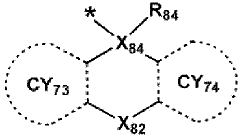 in Formula 7-5 may be selected from groups represented by Formulae CY71-5(1) to CY71-5(8): 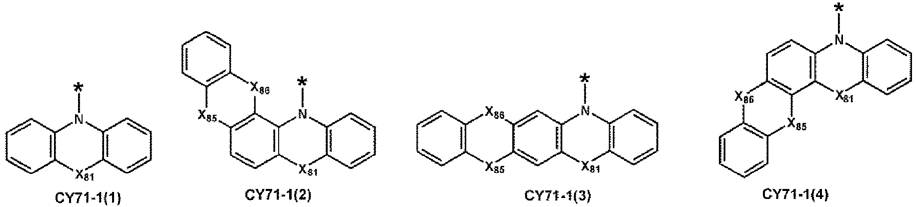 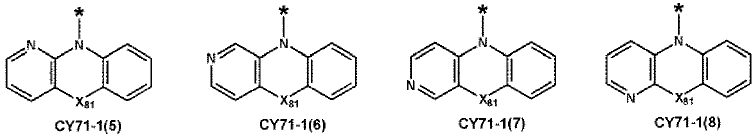 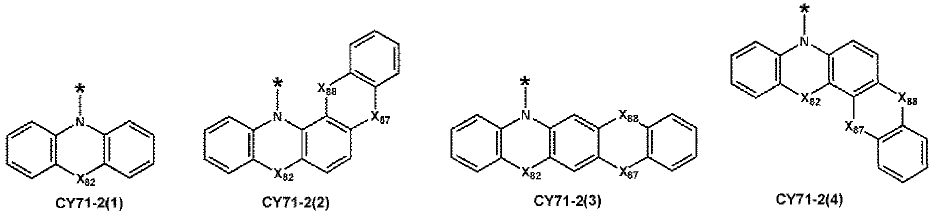 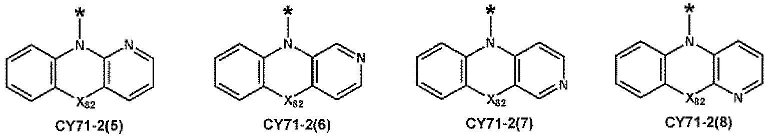 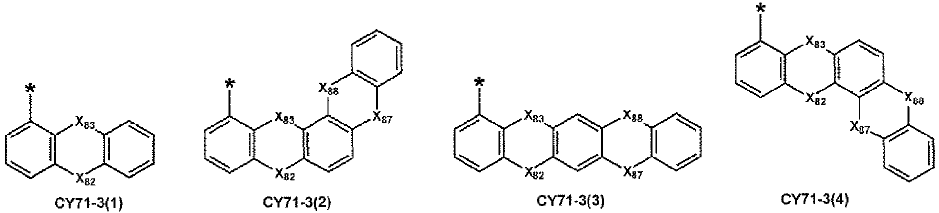 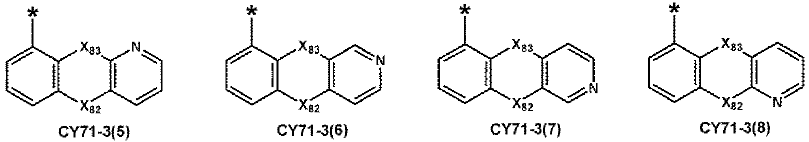 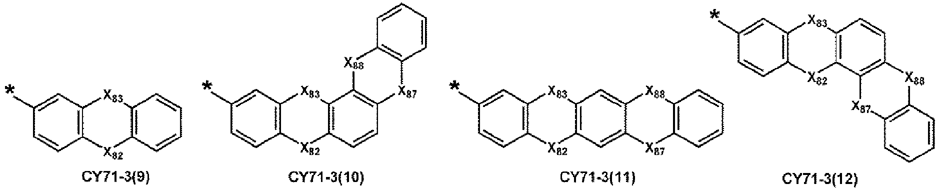 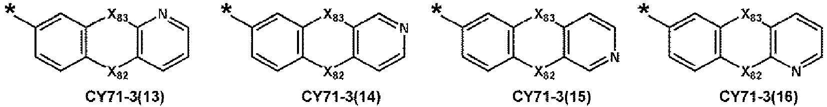 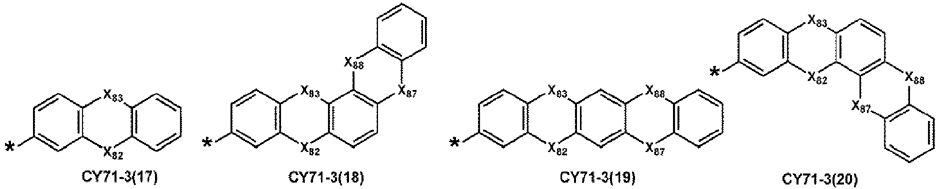 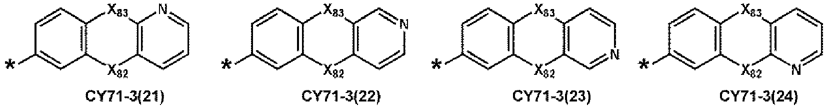 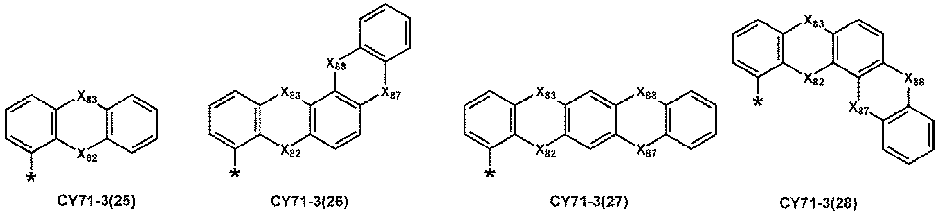 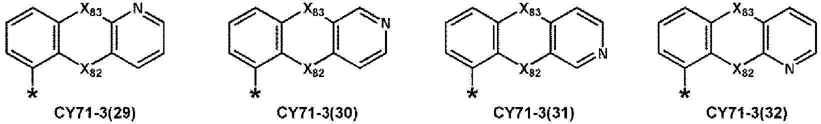 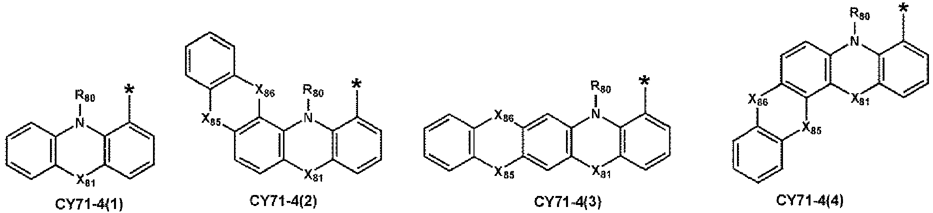 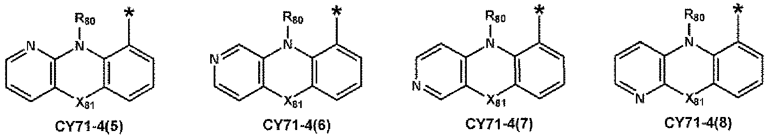 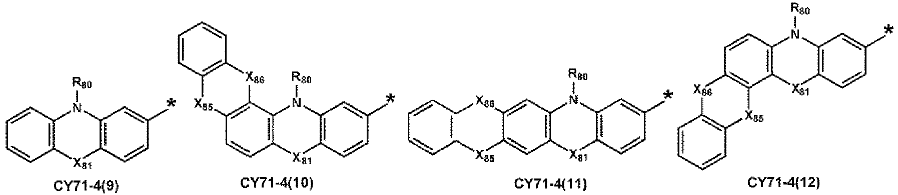 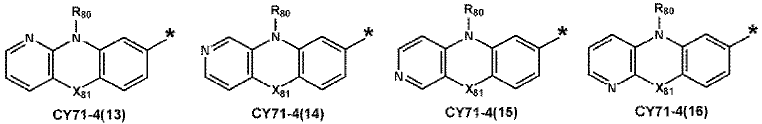 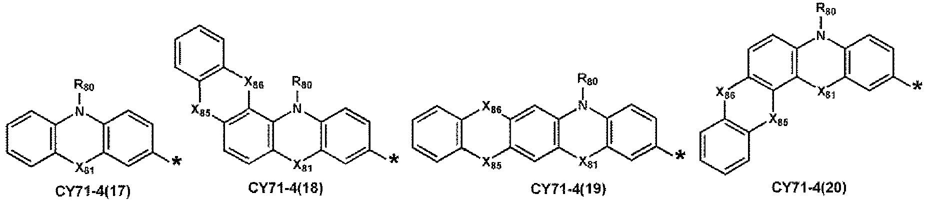 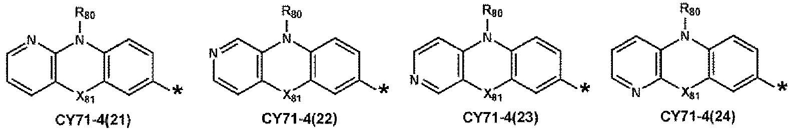 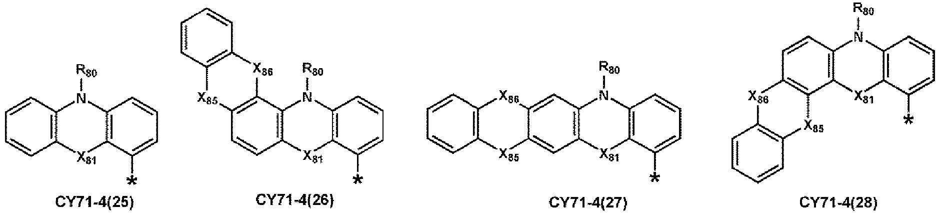 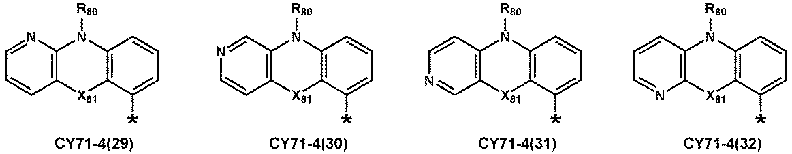 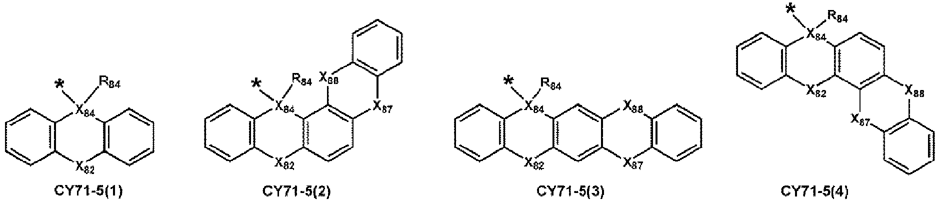 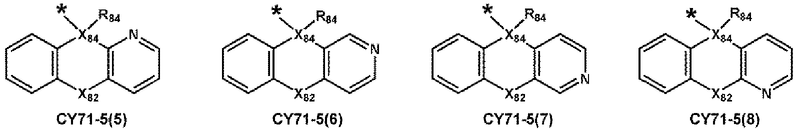
In Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
X₈₁ to X₈₄, R₈₀, and R₈₄ may respectively be understood by referring to the descriptions of X₈₁ to X₈₄, R₈₀, and R₈₄ provided herein,
X₈₅ may be a single bond, O, S, N(R₈₅), B(R₈₅), C(R₈₅ₐ)(R_{85b}), or Si(R₈₅ₐ)(R_{85b}),
X₈₆ may be a single bond, O, S, N(R₈₆), B(R₈₆), C(R₈₆ₐ)(R_{86b}), or Si(R₈₆ₐ)(R_{86b}),
in Formulae CY71-1(1) to CY71-1(8) and CY71-4(1) to CY71-4(32), X₈₅ and X₈₆ may not be a single bond at the same time,
X₈₇ may be a single bond, O, S, N(R₈₇), B(R₈₇), C(R₈₇ₐ)(R_{87b}), or Si(R₈₇ₐ)(R_{87b}),
X₈₈ may be a single bond, O, S, N(R₈₈), B(R₈₈), C(R₈₈ₐ)(R_{88b}), or Si(R₈₈ₐ)(R_{88b}),
in Formulae CY71-2(1) to CY71-2(8), CY71-3(1) to CY71-3(32), and CY71-5(1) to CY71-5(8), X₈₇ and X₈₈ may not be a single bond at the same time, and
R₈₅ to R₈₈, R₈₅ₐ, R_{85b}, R₈₆ₐ, R_{86b}, R₈₇ₐ, R_{87b}, R₈₈ₐ, and R_{88b} may each be the same as the description of R₈₁ provided herein.

In the light-emitting device according to one or more embodiments, the second host may be at least one selected from among Formulae HT-1 to HT-4:

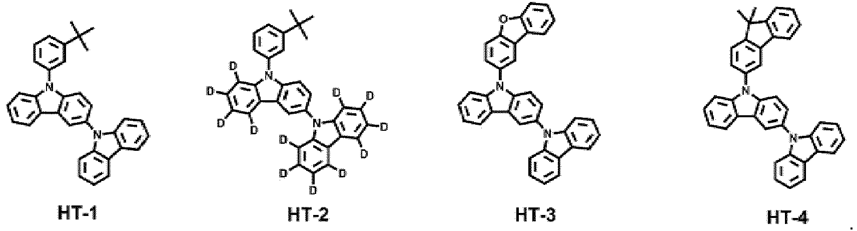

In the light-emitting device according to one or more embodiments, the first host and the second host may form an exciplex, the condensed cyclic compound of Formula 1 and the first host or the condensed cyclic compound of Formula 1 and the second host may not form an exciplex.

In the light-emitting device according to one or more embodiments, the emission layer may further include a sensitizer.

In the light-emitting device according to one or more embodiments, the sensitizer may be at least one selected from PS-1 and PS-2:

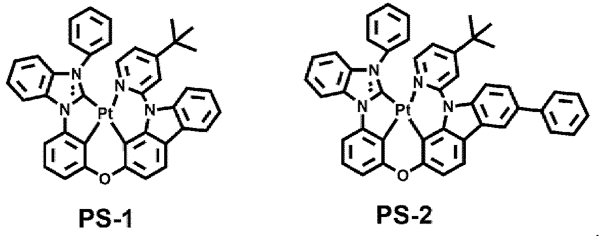

In the light-emitting device according to one or more embodiments, a content (e.g., amount) of the sensitizer may be equal to or greater than a content (e.g., amount) of the condensed cyclic compound of Formula 1, based on the total weight of the emission layer.

In the light-emitting device according to one or more embodiments, the emission layer may be to emit fluorescence.

In the light-emitting device according to one or more embodiments, the emission layer may be to emit delayed fluorescence.

In the light-emitting device according to one or more embodiments, the emission layer may be to emit blue light having a maximum emission wavelength in a range of about 410 nanometers (nm) to about 490 nm.

In the light-emitting device according to one or more embodiments, the first electrode may be an anode, the second electrode may be a cathode, and the interlayer may further include a hole transport region between the first electrode and the emission layer and an electron transport region between the emission layer and the second electrode, wherein the hole transport region may include a hole injection layer, a hole transport layer, an emission auxiliary layer, an electron blocking layer, or a combination thereof, and the electron transport region may include a hole blocking layer, an electron transport layer, an electron injection layer, or a combination thereof.

In the light-emitting device according to one or more embodiments, the light-emitting device may further include a first capping layer or a second capping layer, the first capping layer may be on one surface of the first electrode, and the second capping layer may be on one surface of the second electrode.

In the light-emitting device according to one or more embodiments, at least one selected from the first capping layer and the second capping layer may include the condensed cyclic compound represented by Formula 1.

According to one or more embodiments of the present disclosure, an electronic apparatus may include the light-emitting device.

The electronic apparatus according to one or more embodiments may further include: a thin-film transistor; and a color filter, a color-conversion layer, a touchscreen layer, a polarizing layer, or any combination thereof. The thin-film transistor may include a source electrode and a drain electrode, and the first electrode of the light-emitting device may be electrically connected to the source electrode or the drain electrode of the thin-film transistor.

According to one or more embodiments of the present disclosure, electronic equipment may include the light-emitting device.

The electronic equipment may be at least one selected from a flat panel display, a curved display, a computer monitor, a medical monitor, a television, an advertisement board, an indoor or outdoor lighting, and/or signaling light, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a microdisplay, a 3D display, a virtual or augmented reality display, a vehicle, a video wall including multiple displays tiled together, a theater or stadium screen, a phototherapy device, and a signage.

According to one or more embodiments, a condensed cyclic compound may be represented by Formula 1: 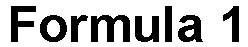 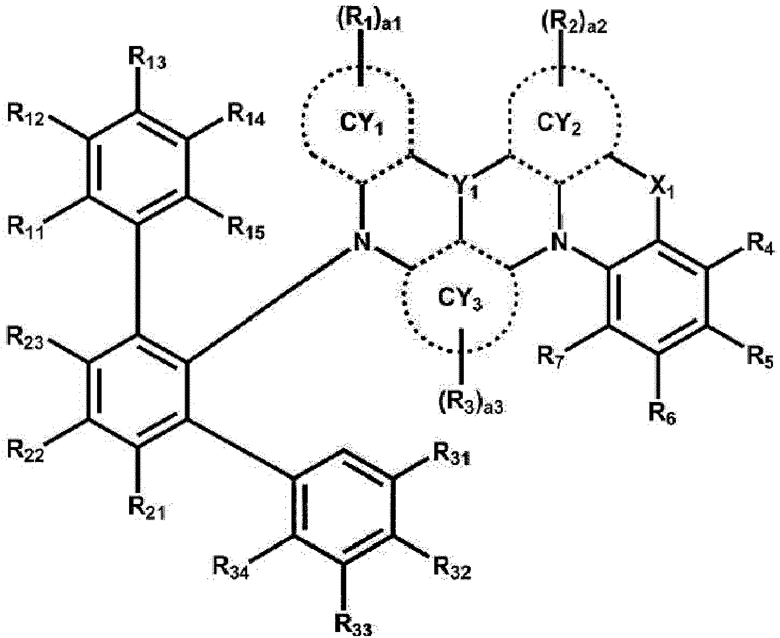 wherein, in Formula 1,
X₁ may be a single bond,
Y₁ may be N, B, P(=O), or P(=S),
ring CY₁ to ring CY₃ may each independently be a C₅-C₆₀ (e.g. C₅-C₃₀) carbocyclic group or a C₂-C₆₀ (e.g. C₂-C₂₀) heterocyclic group,
a1 to a3 are each independently an integer from 0 to 10,
R₁ to R₉, R₁₁ to R₁₅, R₂₁ to R₂₃, and R₃₁ to R₃₄ may each independently be hydrogen, deuterium, -F, -Cl, -Br, -I, a hydroxyl group, a cyano group, a nitro group, a C₁-C₆₀ (*e.g.* C₁-C₂₀) alkyl group unsubstituted or substituted with at least one R₁₀ₐ, a C₂-C₆₀ (*e.g.* C₂-C₂₀) alkenyl group unsubstituted or substituted with at least one R₁₀ₐ, a C₂-C₆₀ (*e.g.* C₂-C₂₀) alkynyl group unsubstituted or substituted with at least one R₁₀ₐ, a C₁-C₆₀ (*e.g.* C₁-C₂₀) alkoxy group unsubstituted or substituted with at least one R₁₀ₐ, a C₁-C₆₀ (*e.g.* C₁-C₂₀) alkylthio group unsubstituted or substituted with at least one R₁₀ₐ, a C₃-C₆₀ (*e.g*. C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ, a C₆-C₆₀ (*e.g.* C₆-C₃₀) aryloxy group unsubstituted or substituted with at least one R₁₀ₐ, a C₆-C₆₀ (*e.g.* C₆-C₃₀) arylthio group unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁),-S(=O)₂(Q₁), or -P(=O)(Q₁)(Q₂),
at least two groups selected from R₁ to R₉, R₁₁ to R₁₅, R₂₁ to R₂₃, and R₃₁ to R₃₄ may optionally be bound to each other to form a C₅-C₃₀ (*e.g.* C₅-C₂₀) carbocyclic group unsubstituted or substituted with at least one R₁₀ₐ or a C₂-C₃₀ (*e.g.* C₂-C₂₀) heterocyclic group unsubstituted or substituted with at least one R₁₀ₐ, R₃ and R₇ are not bound to each other to form a C₅-C₃₀ carbocyclic group unsubstituted or substituted with at least one R₁₀ₐ or a C₂-C₃₀ heterocyclic group unsubstituted or substituted with at least one R_{10a'} and
R₁₀ₐ may be:
   deuterium, -F, -Cl, -Br, -I, a hydroxyl group, or a nitro group;
   a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, or a C₁-C₆₀ (*e.g.* C₁-C₂₀) alkoxy group, each unsubstituted or substituted with deuterium, -F, -Cl, -Br, -I, a hydroxyl group, a cyano group, a nitro group, a C₃-C₆₀ (*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, a C₆-C₆₀ (*e.g.* C₆-C₃₀) arylthio group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁),-P(=O)(Q₁₁)(Q₁₂), or any combination thereof;
   a C₃-C₆₀ (*e.g*. C₃-C₃₀) carbocyclic group, a C₁-C₆₀ (*e.g.* C₁-C₂₀) heterocyclic group, a C₆-C₆₀ (*e.g.* C₆-C₃₀) aryloxy group, or a C₆-C₆₀ (*e.g.* C₆-C₃₀) arylthio group, each unsubstituted or substituted with deuterium, -F, -Cl, -Br, -I, a hydroxyl group, a cyano group, a nitro group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₆₀ (*e.g*. C₃-C₃₀) carbocyclic group, a C₁-C₆₀ (*e.g.* C₁-C₂₀) heterocyclic group, a C₆-C₆₀ (*e.g.* C₆-C₃₀) aryloxy group, a C₆-C₆₀ (*e.g.* C₆-C₃₀) arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁),-P(=O)(Q₂₁)(Q₂₂), or any combination thereof; or
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or-P(=O)(Q₃₁)(Q₃₂),
   wherein Q₁ to Q₃, Q₁₁ to Q₁₃, Q₂₁ to Q₂₃, and Q₃₁ to Q₃₃ may each independently be:
      hydrogen, deuterium, -F, -Cl, -Br, -I, a hydroxyl group, a cyano group, a nitro group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, or a C₁-C₆₀ (*e.g.* C₁-C₂₀) alkoxy group; or
      a C₃-C₆₀ (*e.g*. C₃-C₃₀) carbocyclic group, a C₁-C₆₀ (*e.g.* C₁-C₂₀) heterocyclic group, a C₇-C₆₀ (e.g. C₇-C₃₀) aryl alkyl group, or a C₂-C₆₀ (*e.g.* C₂-C₂₀) heteroaryl alkyl group, each unsubstituted or substituted with deuterium, -F, a cyano group, a C₁-C₆₀ (*e.g.* C₁-C₂₀) alkyl group, a C₁-C₆₀ (*e.g.* C₁-C₂₀) alkoxy group, a phenyl group, a biphenyl group, or any combination thereof.

In the condensed cyclic compound according to the claimed invention, X₁ is a single bond.

In the condensed cyclic compound according to one or more embodiments, Y₁ may be B.

In the condensed cyclic compound according to one or more embodiments, ring CY₁ to ring CY₃ may be identical to each other.

In the condensed cyclic compound according to one or more embodiments, ring CY₁ and ring CY₂ may be different from each other.

In the condensed cyclic compound according to one or more embodiments, ring CY₁ and CY₃ may be different from each other.

In the condensed cyclic compound according to one or more embodiments, ring CY₂ and CY₃ may be different from each other.

In the condensed cyclic compound according to one or more embodiments, ring CY₁ to CY₃ may each independently be a benzene group or a naphthalene group.

In the condensed cyclic compound according to one or more embodiments, ring CY₁ may be a group represented by Formula CY1-1: 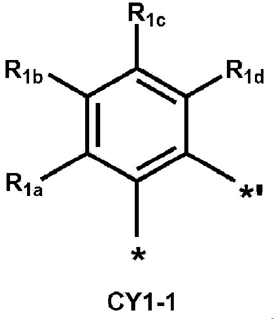 wherein, in Formula CY1-1,
* indicates a binding site to an adjacent N,
*' indicates a binding site to an adjacent Y₁,
R₁ₐ to R_{1d} may each independently be the same as the description of R₁ provided herein, and
Y₁ and R₁ may respectively be understood by referring to the descriptions of Y₁ and R₁ provided herein.

In the condensed cyclic compound according to one or more embodiments, ring CY₂ may be a group represented by Formula CY2-1: 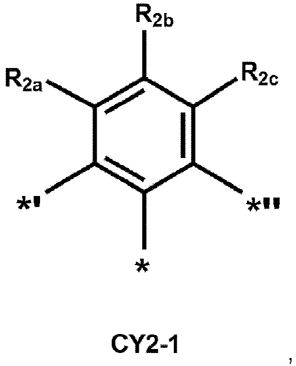 wherein, in Formula CY2-1,
* indicates a binding site to an adjacent N,
*' indicates a binding site to an adjacent Y₁,
*" indicates a binding site to an adjacent X₁,
R₂ₐ to R_{2c} may each independently be the same as the description of R₂ provided herein, and
Y₁, X₁, and R₂ may respectively be understood by referring to the descriptions of Y₁, X₁, and R₂ provided herein.

In the condensed cyclic compound according to one or more embodiments, ring CY₃ may be a group represented by Formula CY3-1: 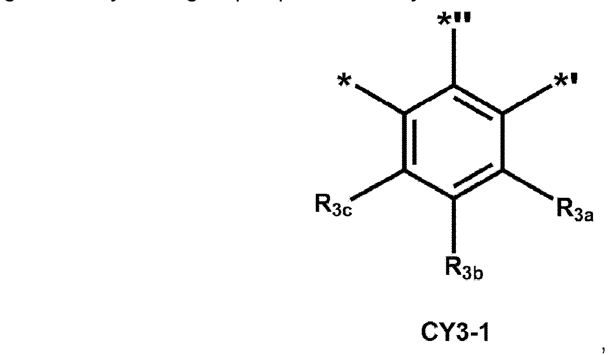 wherein, in Formula CY3-1,
* and *' may each independently be a binding site to an adjacent N,
*" indicates a binding site to an adjacent Y₁,
R₃ₐ to R_{3c} may each independently be the same as the description of R₃ provided herein, and
Y₁ and R₃ may respectively be understood by referring to the descriptions of Y₁ and R₃ provided herein.

In the condensed cyclic compound according to one or more embodiments, a1 to a3 may each independently be an integer from 0 to 3.

In the condensed cyclic compound according to one or more embodiments, the sum of a1 to a3 may be 1 or greater, and at least one selected from among R₁ to R₃ may be a C₃-C₆₀ (*e.g*. C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ, or -N(Q₁)(Q₂).

In the condensed cyclic compound according to one or more embodiments, the sum of a1 to a3 may be 1 or greater, at least one selected from among R₁ to R₃ may be a group represented by one selected from Formulae 2-1 to 2-4: 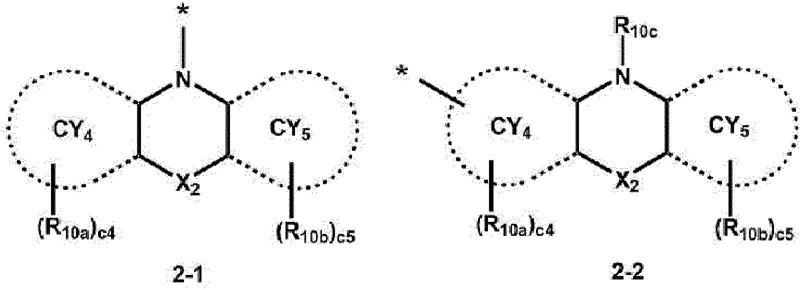 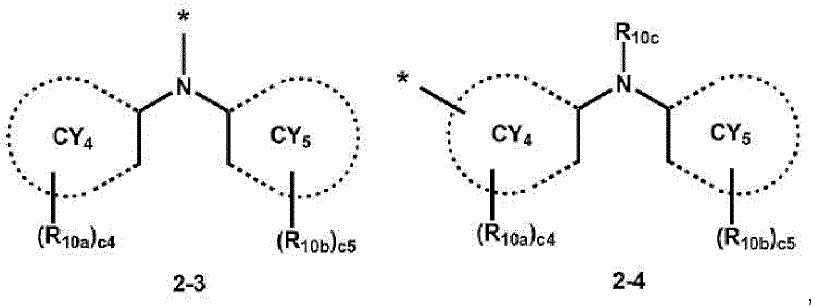 wherein, in Formulae 2-1 to 2-4,
X₂ may be a single bond, O, S, Se, C(R₈)(R₉), Si(R₈)(R₉), or N(R₈),
CY₄ and CY₅ may each independently be a C₅-C₃₀ (e.g. C₅-C₂₀) carbocyclic group or a C₂-C₃₀ (*e.g.* C₂-C₂₀) heterocyclic group,
c4 and c5 may each independently be an integer from 0 to 10,
R_{10b} and R_{10c} may each independently be the same as the description of R₁₀ₐ provided herein,
* indicates a binding site to an adjacent atom, and
R₈, R₉, and R₁₀ₐ may respectively be understood by referring to the descriptions of R₈, R₉, and R₁₀ₐ provided herein.
In the condensed cyclic compound according to one or more embodiments, the sum of a1 to a3 may be 1 or greater, and
at least one selected from among R₁ to R₃ may be represented by one selected from Formulae 2-5 to 2-8: 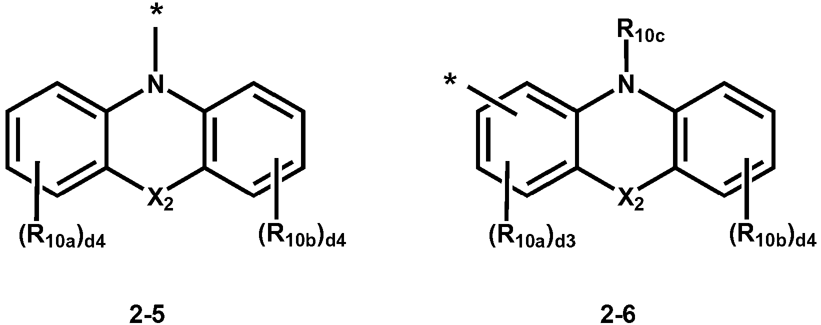 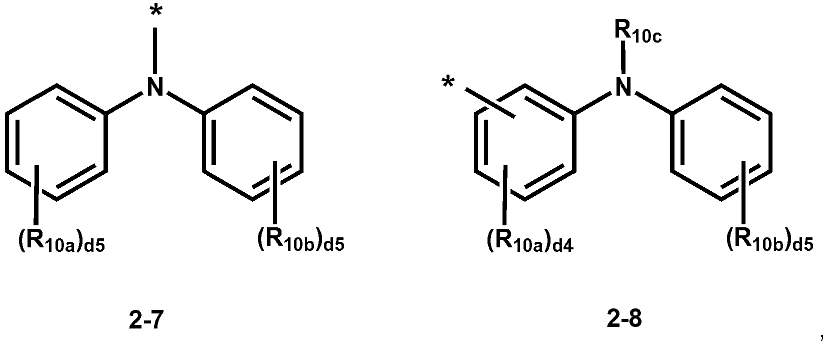
wherein, in Formulae 2-5 to 2-8,
X₂ may be a single bond, O, S, Se, C(R₈)(R₉), Si(R₈)(R₉), or N(R₈),
d3 may be an integer from 0 to 3,
d4 may be an integer from 0 to 4,
d5 may be an integer from 0 to 5,
R_{10b} and R_{10c} may each be the same as the description of R₁₀ₐ provided herein,
* indicates a binding site to an adjacent atom, and
R₈, R₉, and R₁₀ₐ may respectively be understood by referring to the descriptions of R₈, R₉, and R₁₀ₐ provided herein.

In the condensed cyclic compound according to one or more embodiments, R₁₁ to R₁₅, R₂₁ to R₂₃, and R₃₁ to R₃₄ may each independently be hydrogen, deuterium, -F, -Cl, -Br, -I, a cyano group, a C₁-C₆₀ (*e.g.* C₁-C₂₀) alkyl group unsubstituted or substituted with at least one R₁₀ₐ, a C₃-C₆₀ (*e.g*. C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ, -C(Q₁)(Q₂)(Q₃), or-Si(Q₁)(Q₂)(Q₃), and
R₁₀ₐ, Q₁, Q₂, and Q₃ may respectively be understood by referring to the descriptions of R₁₀ₐ, Q₁, Q₂, and Q₃ provided herein.

In the condensed cyclic compound according to one or more embodiments, R₁₁ to R₁₅, R₂₁ to R₂₃, and R₃₁ to R₃₄ may each independently be: hydrogen, deuterium, -F, a cyano group, a methyl group unsubstituted or substituted with at least one R₁₀ₐ, a cyclohexyl group unsubstituted or substituted with at least one R₁₀₄, a phenyl group unsubstituted or substituted with at least one R₁₀ₐ, -C(Q₁)(Q₂)(Q₃), or -Si(Q₁)(Q₂)(Q₃), or any one selected from Formulae 3-1 to 3-12: 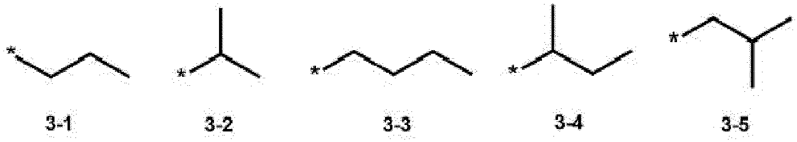 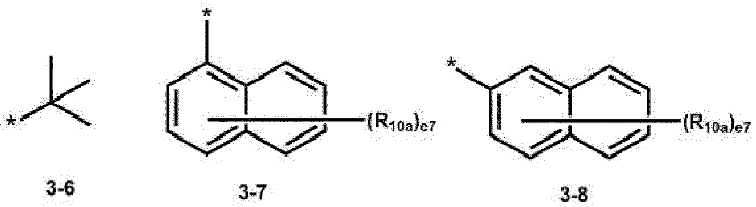 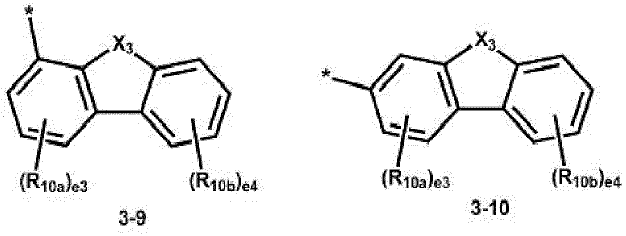 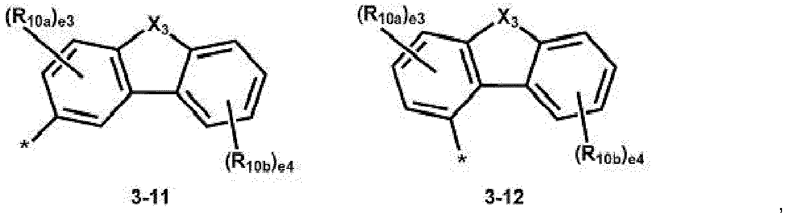 wherein, in Formulae 3-1 to 3-12,
X₃ may be O or S,
e3 may be an integer from 0 to 3,
e4 may be an integer from 0 to 4,
e7 may be an integer from 0 to 7,
R_{10b} may be the same as the description of R₁₀ₐ provided herein,
* indicates a binding site to an adjacent atom, and
R₁₀ₐ, Q₁, Q₂, and Q₃ may respectively be understood by referring to the descriptions of R₁₀ₐ, Q₁, Q₂, and Q₃ provided herein.

In the condensed cyclic compound according to one or more embodiments, R₄ to R₇ may each independently be hydrogen, deuterium, a C₁-C₆₀ (*e.g.* C₁-C₂₀) alkyl group unsubstituted or substituted with at least one R₁₀ₐ, a C₃-C₆₀ (*e.g*. C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ, or-C(Q₁)(Q₂)(Q₃), and
R₁₀ₐ, Q₁, Q₂, and Q₃ may respectively be understood by referring to the descriptions of R₁₀ₐ, Q₁, Q₂, and Q₃ provided herein.

The condensed cyclic compound according to one or more embodiments may be one selected from Compounds 1 to 68:

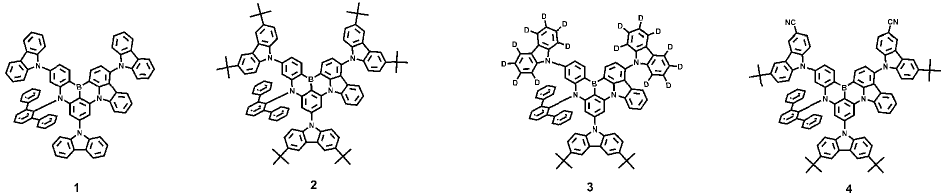

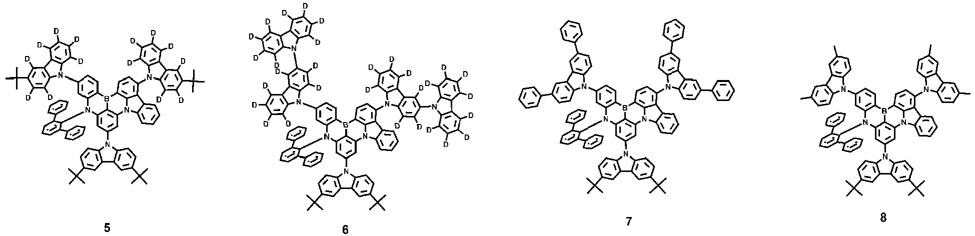

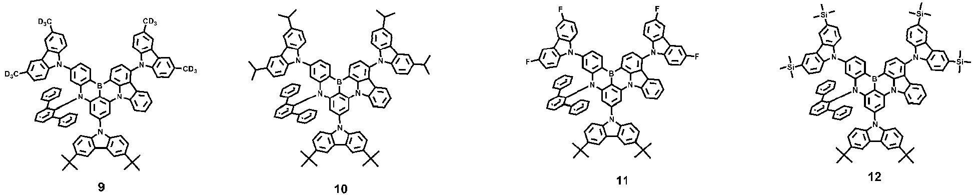

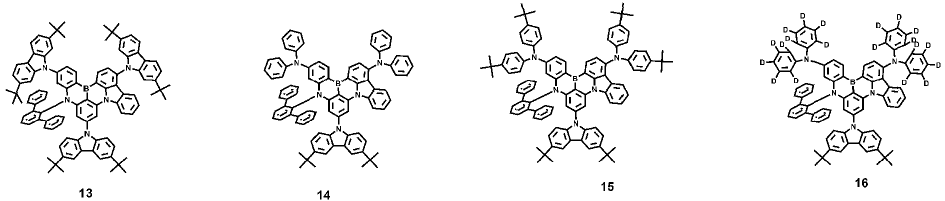

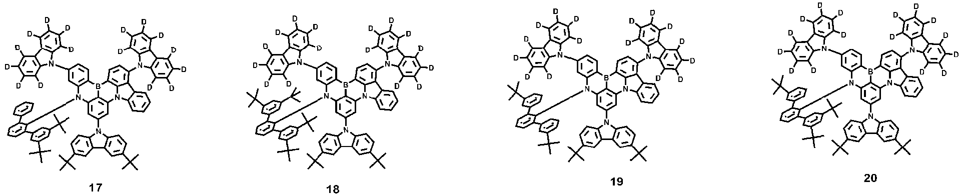

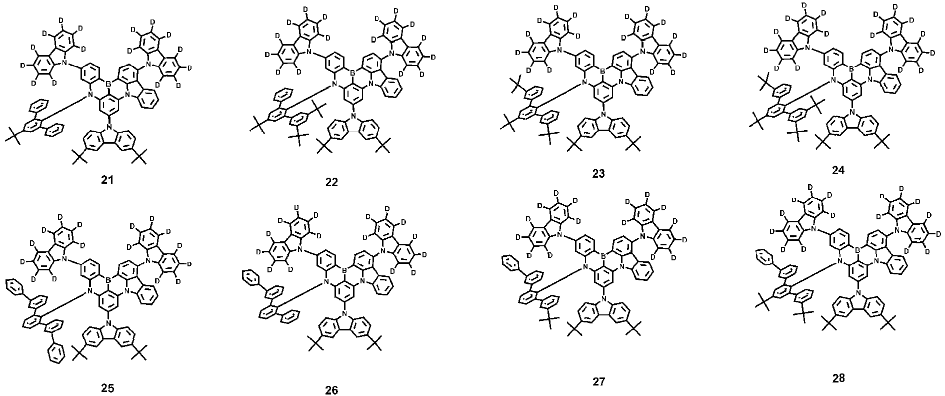

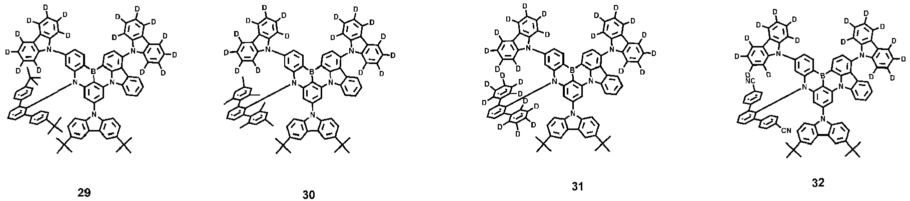

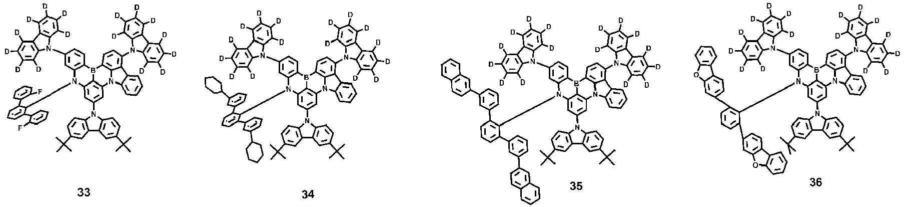

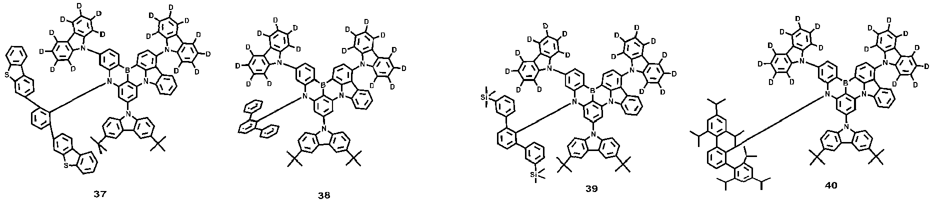

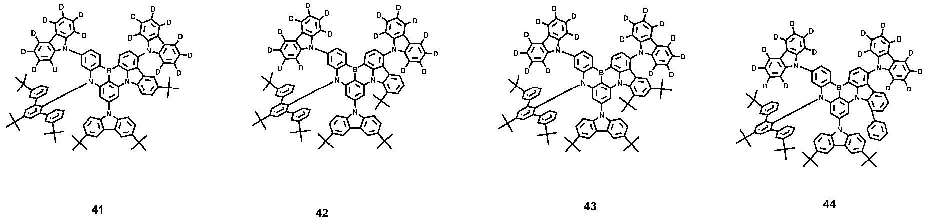

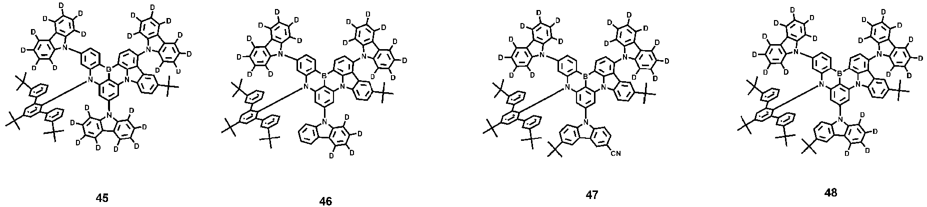

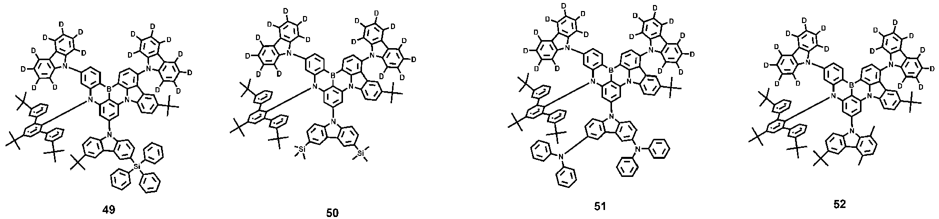

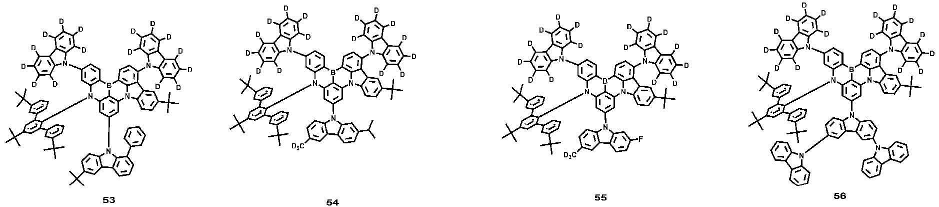

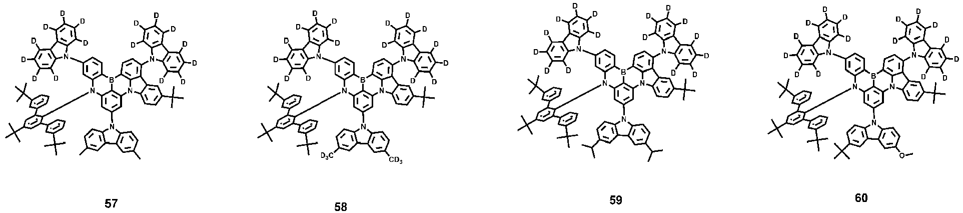

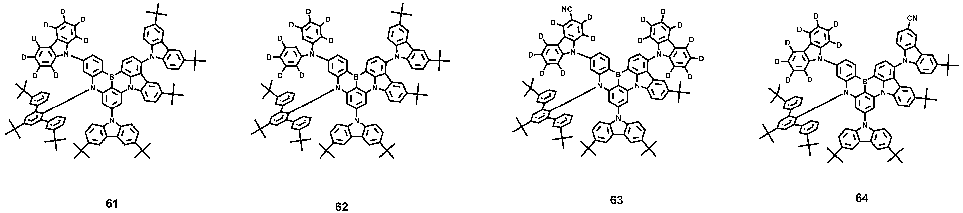

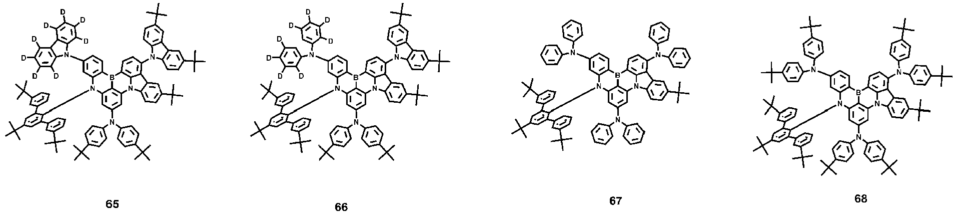

In the condensed cyclic compound represented by Formula 1, a terphenyl group may be vertically bonded from a light-emitting core. As a result, as interaction between molecules is suppressed or reduced, and the sublimation temperature is lowered, excellent or suitable thermal stability may be secured. In addition, when manufacturing devices, access of radicals, excitons, and polarons with high energy may be prevented or reduced, and as the Dexter energy transfer from the host/host+Pt sensitizer is suppressed or reduced, deterioration of the device may be reduced, and the lifespan of the device may improve.

In one or more embodiments, the condensed cyclic compound represented by Formula 1 may reduce the stoke-shift singlet-triplet energy difference by increasing rigidity by condensing the core. In addition, as the wavelength is red-shifted, as compared with non-condensed materials, it is possible to adjust to the desired or suitable wavelength range (about 455 nm to about 465 nm) even when an amine-based donor is introduced at a para-position of boron.

Also, in the condensed cyclic compound represented by Formula 1, the sum of a1 to a3 may be 1 or more, and at least one selected from among R₁ to R₃ may include an amine-based donor. As a result, the multi-resonance effect is enhanced, and the effects of reducing the full width at half maximum, reducing the singlet-triplet energy difference, increasing the photoluminescence quantum yield (PLQY), and reducing the stoke-shift may be achieved and shown.

Therefore, an electronic device, e.g., a light-emitting device, including the condensed cyclic compound represented by Formula 1 may have a low driving voltage, high efficiency, and long lifespan.

At least one of the condensed-cyclic compounds represented by Formula 1 may be utilized in a light-emitting device (e.g., an organic light-emitting device). Accordingly, in one or more embodiments, a light-emitting device may include: a first electrode; a second electrode facing the first electrode; an interlayer between the first electrode and the second electrode and including an emission layer; and a condensed cyclic compound represented by Formula 1 as described herein.

In some embodiments,
the first electrode of the light-emitting device may be an anode,
the second electrode of the light-emitting device may be a cathode,
the interlayer may further include a hole transport region between the first electrode and the emission layer and an electron transport region between the emission layer and the second electrode,
the hole transport region may include a hole injection layer, a hole transport layer, an emission auxiliary layer, an electron blocking layer, or any combination thereof, and
the electron transport region may include a buffer layer, a hole blocking layer, an electron control layer, an electron transport layer, or an electron injection layer.

In one or more embodiments, the condensed cyclic compound may be included between the first electrode and the second electrode of the light-emitting device. Accordingly, the condensed cyclic compound may be included in the interlayer of the light-emitting device, for example, in the emission layer in the interlayer.

In one or more embodiments, the emission layer in the interlayer of the light-emitting device may include a dopant and a host, and the dopant may include the condensed cyclic compound. For example, in some embodiments, the condensed cyclic compound may serve as a dopant. The emission layer may be to emit red light, green light, blue light, and/or white light (e.g., combined white light). In some embodiments, the emission layer may be to emit blue light. The blue light may have a maximum emission wavelength in a range of about 410 nanometers (nm) to about 490 nm.

In one or more embodiments, the emission layer in the interlayer of the light-emitting device may include a dopant and a host, the dopant may include the condensed cyclic compound, and the dopant may be to emit blue light. In some embodiments, the dopant may include a transition metal and ligand(s) in the number of m, m may be an integer from 1 to 6, the ligand(s) in the number of m may be identical to or different from each other, at least one of the ligand(s) in the number of m may be bound to the transition metal via a carbon-transition metal bond, and the carbon-transition metal bond may be a coordinate bond. For example, in some embodiments, at least one of the ligand(s) in the number of m may be a carbene ligand (e.g., Ir(pmp)₃ and/or the like). The transition metal may be, for example, iridium, platinum, osmium, palladium, rhodium, or gold. The emission layer and the dopant may respectively be understood by referring to the descriptions of the emission layer and the dopant provided herein.

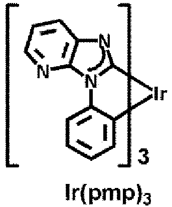

In one or more embodiments, the light-emitting device may include a capping layer located outside the first electrode and/or the second electrode.

In one or more embodiments, the light-emitting device may further include at least one of a first capping layer located outside a first electrode or a second capping layer located outside a second electrode, and at least one of the first capping layer or the second capping layer may include the condensed cyclic compound represented by Formula 1. The first capping layer and the second capping layer may respectively be understood by referring to the descriptions of the first capping layer and the second capping layer provided herein.

In some embodiments, the light-emitting device may include:
a first capping layer located outside the first electrode and including the condensed cyclic compound represented by Formula 1;
a second capping layer located outside the second electrode and including the condensed cyclic compound represented by Formula 1; or
the first capping layer and the second capping layer.

The expression that an "(interlayer and/or a capping layer) includes a condensed cyclic compound" as utilized herein may be construed as meaning that the "(interlayer and/or the capping layer) may include one condensed cyclic compound of Formula 1 or two or more different condensed cyclic compounds of Formula 1".

For example, in some embodiments, the interlayer and/or the capping layer may include Compound 1 only as the condensed cyclic compound. In these embodiments, Compound 1 may be included in the emission layer of the light-emitting device. In some embodiments, Compounds 1 and 2 may be included in the interlayer as the condensed cyclic compounds. In these embodiments, Compounds 1 and 2 may be included in substantially the same layer (for example, both (e.g., simultaneously) Compounds 1 and 2 may be included in an emission layer) or in different layers (for example, Compound 1 may be included in an emission layer, and Compound 2 may be included in an electron transport region).

The term "interlayer" as utilized herein refers to a single layer and/or a plurality of all layers between a first electrode and a second electrode in a light-emitting device.

According to one or more embodiments, an electronic apparatus may include the light-emitting device. The electronic apparatus may further include a thin-film transistor. In some embodiments, the electronic apparatus may further include a thin-film transistor including a source electrode and drain electrode, and a first electrode of the light-emitting device may be electrically connected to the source electrode or the drain electrode. The electronic apparatus may further include a color filter, a color-conversion layer, a touchscreen layer, a polarizing layer, or any combination thereof. The electronic apparatus may be understood by referring to the description of the electronic apparatus provided herein.

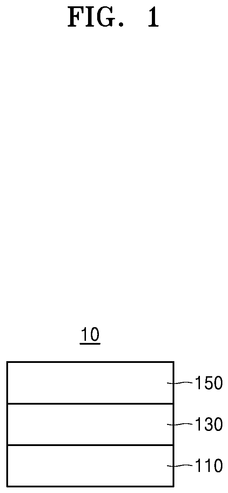

### Description of FIG. 1

FIG. 1 is a schematic view of a light-emitting device 10 according to one or more embodiments of the present disclosure. The light-emitting device 10 may include a first electrode 110, an interlayer 130, and a second electrode 150.

Hereinafter, the structure of the light-emitting device 10 according to one or more embodiments and a method of manufacturing the light-emitting device 10 according to one or more embodiments will be described with reference to FIG. 1.

### First electrode 110

In FIG. 1, in some embodiments, a substrate may be additionally provided and located under the first electrode 110 and/or above the second electrode 150. The substrate may be a glass substrate or a plastic substrate. The substrate may be a flexible substrate including plastic having excellent or suitable heat resistance and durability, for example, polyimide, polyethylene terephthalate (PET), polycarbonate, polyethylene naphthalate, polyarylate (PAR), polyetherimide, or any combination thereof.

The first electrode 110 may be formed by depositing or sputtering, on the substrate, a material for forming the first electrode 110. When the first electrode 110 is an anode, a high work function material that may easily inject holes may be utilized as a material for a first electrode.

The first electrode 110 may be a reflective electrode, a semi-transmissive electrode, or a transmissive electrode. In some embodiments, when the first electrode 110 is a transmissive electrode, a material for forming the first electrode 110 may be indium tin oxide (ITO), indium zinc oxide (IZO), tin oxide (SnO₂), zinc oxide (ZnO), or any combinations thereof. In some embodiments, when the first electrode 110 is a semi-transmissive electrode or a reflective electrode, magnesium (Mg), silver (Ag), aluminium (Al), aluminium-lithium (Al-Li), calcium (Ca), magnesium-indium (Mg-In), magnesium-silver (Mg-Ag), or any combination thereof may be utilized as a material for forming the first electrode 110.

The first electrode 110 may have a single-layered structure including (e.g., consisting of) a single layer or a multi-layered structure including two or more layers. In some embodiments, the first electrode 110 may have a triple-layered structure of ITO/Ag/ITO.

### Interlayer 130

The interlayer 130 may be on the first electrode 110. The interlayer 130 may include an emission layer.

In one or more embodiments, the interlayer 130 may further include a hole transport region between the first electrode 110 and the emission layer and an electron transport region between the emission layer and the second electrode 150.

In one or more embodiments, the interlayer 130 may further include metal-containing compounds such as organometallic compounds, inorganic materials such as quantum dots, and/or the like, in addition to one or more suitable organic materials.

In one or more embodiments, the interlayer 130 may include: i) at least two emitting units sequentially stacked between the first electrode 110 and the second electrode 150; and ii) a charge generation layer located between the at least two emitting units. When the interlayer 130 includes the at least two emitting units and the charge generation layer, the light-emitting device 10 may be a tandem light-emitting device.

### Hole transport region in interlayer 130

The hole transport region may have i) a single-layered structure including (e.g., consisting of) a single layer including (e.g., consisting of) a single material, ii) a single-layered structure including (e.g., consisting of) a single layer including a plurality of different materials, or iii) a multi-layered structure having a plurality of layers including a plurality of different materials.

The hole transport region may include a hole injection layer, a hole transport layer, an emission auxiliary layer, an electron blocking layer, or a combination thereof.

For example, in some embodiments, the hole transport region may have a multi-layered structure, e.g., a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein layers of each structure are sequentially stacked on the first electrode 110 in each stated order.

The hole transport region may include the compound represented by Formula 201, the compound represented by Formula 202, or any combination thereof: 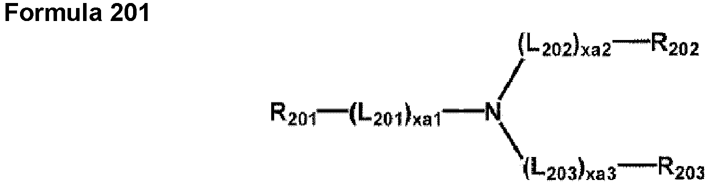 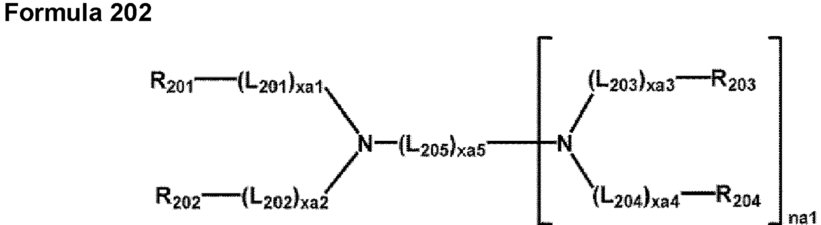 wherein, in Formulae 201 and 202,
L₂₀₁ to L₂₀₄ may each independently be a C₃-C₆₀ (*e.g*. C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
L₂₀₅ may be *-O-*', *-S-*', *-N(Q₂₀₁)-*', a C₁-C₂₀ (*e.g.* C₁-C₁₀) alkylene group unsubstituted or substituted with at least one R₁₀ₐ, a C₂-C₂₀ (*e.g.* C₂-C₁₀) alkenylene group unsubstituted or substituted with at least one R₁₀ₐ, a C₃-C₆₀ (*e.g*. C₃-C₃₀) carbocyclic group unsubstituted or substituted with at least one R₁₀ₐ, or a C₁-C₆₀ (e.g. C₁-C₂₀) heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ (*e.g*. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
R₂₀₁ and R₂₀₂ may optionally be bound to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ (*e.g.* C₈-C₃₀) polycyclic group (e.g., a carbazole group and/or the like) unsubstituted or substituted with at least one R₁₀ₐ (e.g., Compound HT16 described herein),
R₂₀₃ and R₂₀₄ may optionally be bound to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ (*e.g.* C₈-C₃₀) polycyclic group unsubstituted or substituted with at least one R₁₀ₐ, and
na1 may be an integer from 1 to 4.

In some embodiments, Formulae 201 and 202 may each include at least one selected from groups represented by Formulae CY201 to CY217: 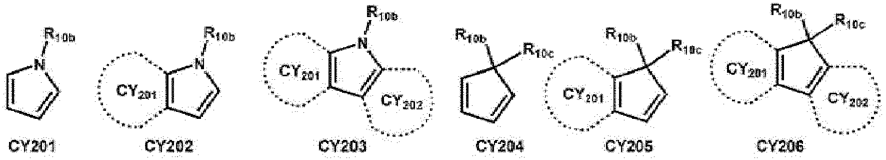 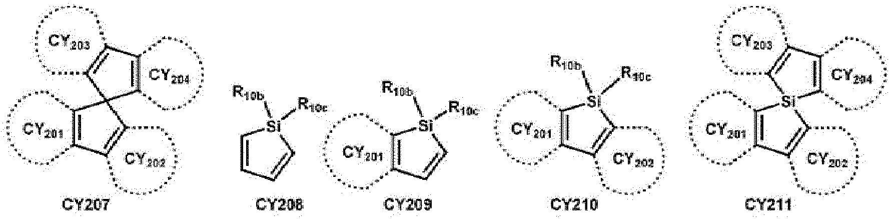 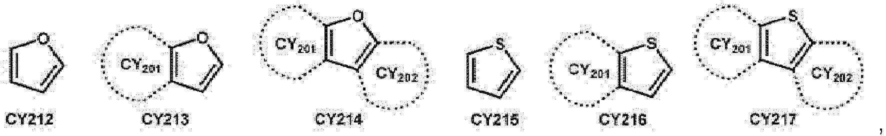 wherein, in Formulae CY201 to CY217, R_{10b} and R_{10c} may each be the same as the descriptions of R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In some embodiments, in Formulae CY201 to CY217, ring CY₂₀₁ to ring CY₂₀₄ may each independently be a benzene group, a naphthalene group, a phenanthrene group, or an anthracene group.

In one or more embodiments, Formulae 201 and 202 may each include at least one selected from groups represented by Formulae CY201 to CY203.

In one or more embodiments, Formula 201 may include at least one selected from groups represented by Formulae CY201 to CY203 and at least one selected from groups represented by Formulae CY204 to CY217.

In one or more embodiments, in Formula 201, xa1 may be 1, R₂₀₁ may be a group represented by any one selected from Formulae CY201 to CY203, xa2 may be 0, and R₂₀₂ may be a group represented by Formulae CY204 to CY207.

In one or more embodiments, Formulae 201 and 202 may each not include groups represented by Formulae CY201 to CY203.

In one or more embodiments, Formulae 201 and 202 may each not include groups represented by Formulae CY201 to CY203, and include at least one selected from groups represented by Formulae CY204 to CY217.

In one or more embodiments, Formulae 201 and 202 may each not include groups represented by Formulae CY201 to CY217.

In some embodiments, the hole transport region may include at least one selected from Compounds HT1 to HT46 and 4,4',4"-[tris(3-methylphenyl)phenylamino] triphenylamine (m-MTDATA), 4,4',4"-tris(N,N-diphenylamino)triphenylamine (TDATA), 4,4',4"-tris[N-(2-naphthyl)-N-phenylamino]-triphenylamine (2-TNATA), N,N'-di(1-naphthalene-1-yl)-N,N'-diphenyl-benzidine (NPB (NPD)), β-NPB, N,N'-bis(3-methylphenyl)-N,N'-diphenyl-[1,1'-biphenyl]-4,4'-diamine (TPD), spiro-TPD, spiro-NPB, methylated-NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate (PANI/PSS), and/or any combination thereof:

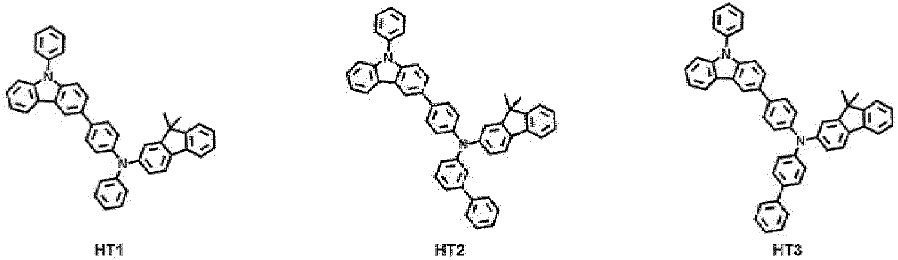

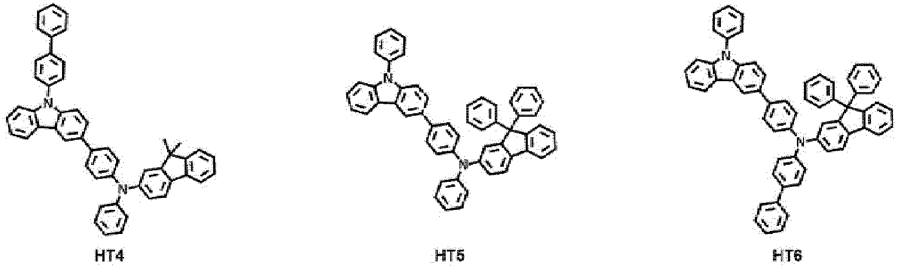

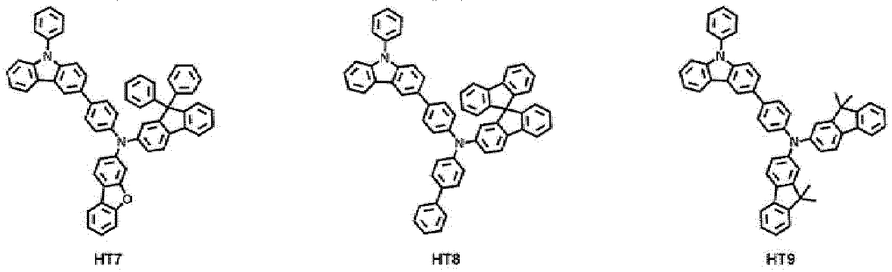

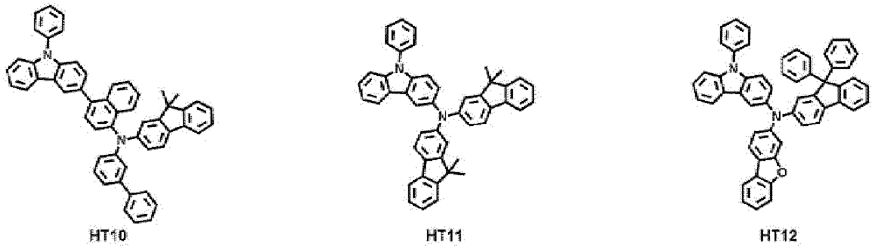

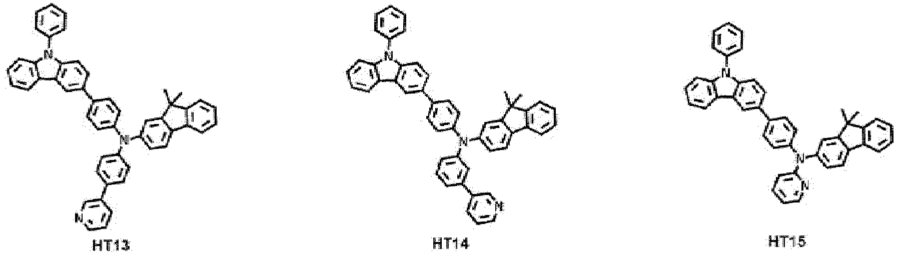

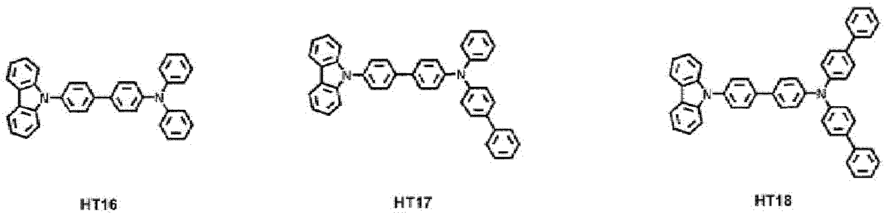

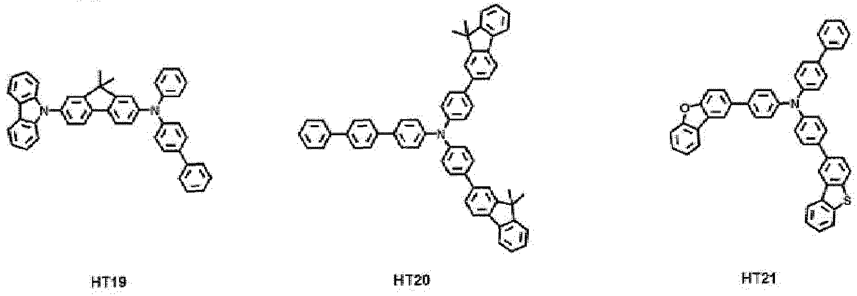

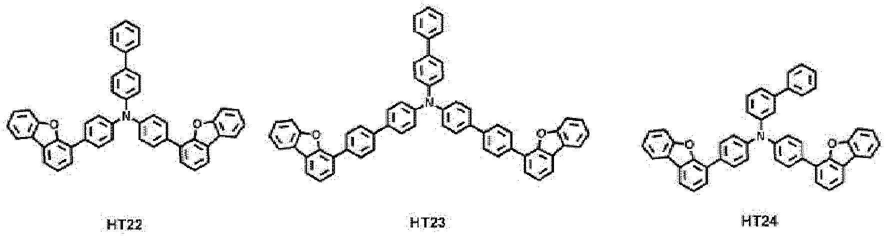

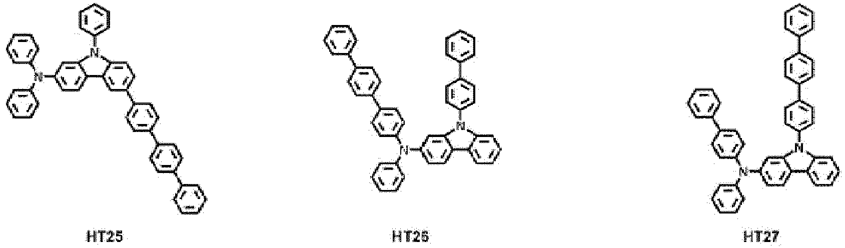

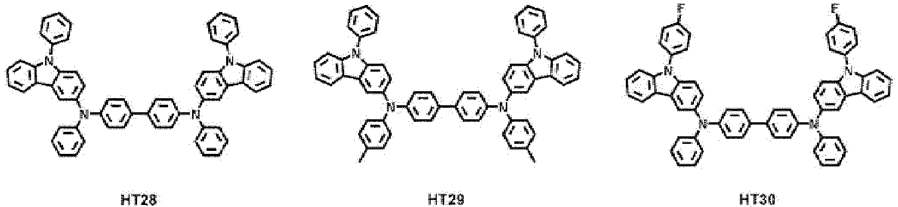

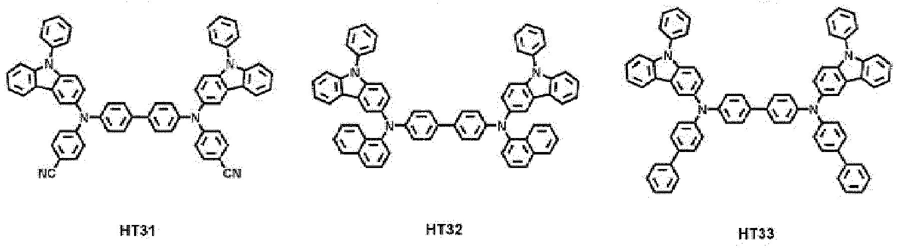

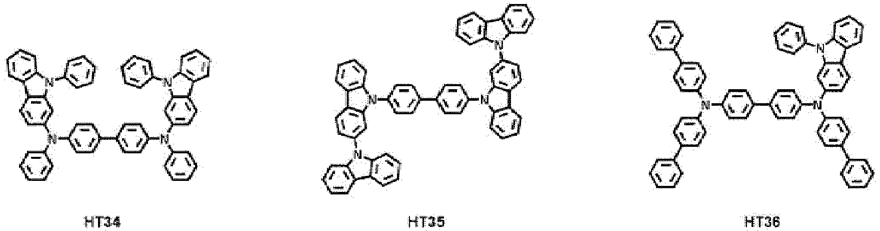

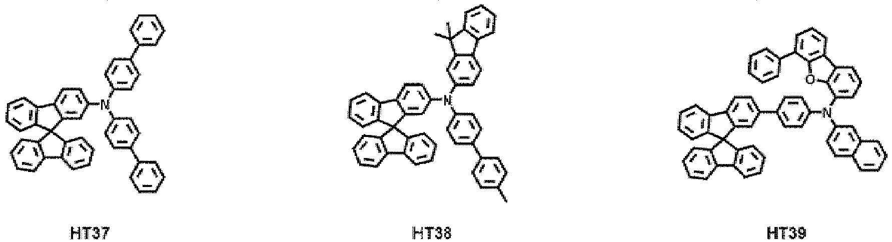

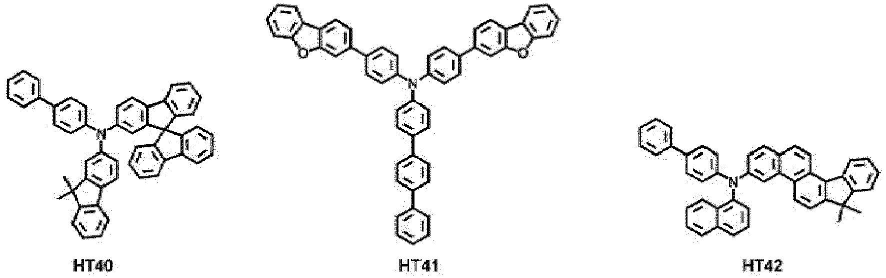

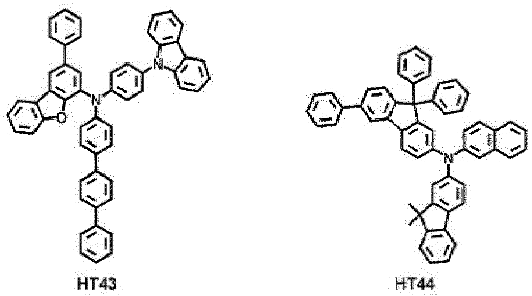

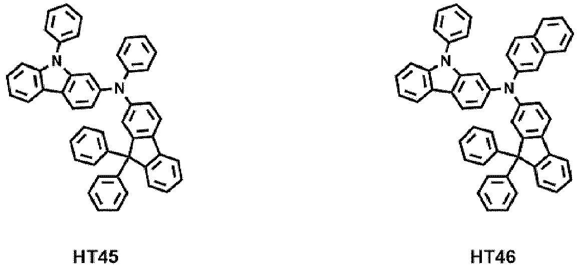

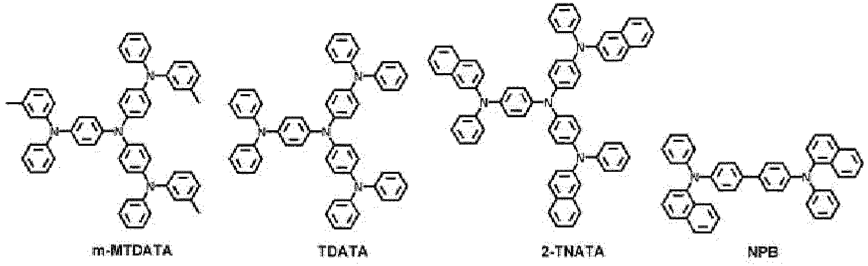

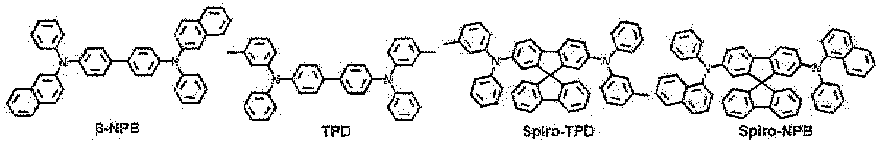

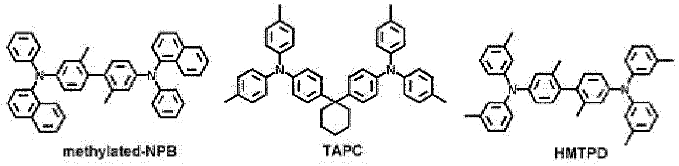

The thickness of the hole transport region may be in a range of about 50 (Angstroms) Å to about 10,000 Å, and in some embodiments, about 100 Å to about 4,000 Å. When the hole transport region includes a hole injection layer, a hole transport layer, or any combination thereof, the thickness of the hole injection layer may be in a range of about 100 Å to about 9,000 Å, and in some embodiments, about 100 Å to about 1,000 Å, and the thickness of the hole transport layer may be in a range of about 50 Å to about 2,000 Å, and in some embodiments, about 100 Å to about 1,500 Å. When the thicknesses of the hole transport region, the hole injection layer, and the hole transport layer are within these ranges, excellent or suitable hole transport characteristics may be obtained without a substantial increase in driving voltage.

The emission auxiliary layer may increase light emission efficiency by compensating for an optical resonance distance according to the wavelength of light emitted by an emission layer. The electron blocking layer may prevent or reduce leakage of electrons to a hole transport region from the emission layer. Materials that may be included in the hole transport region may also be included in an emission auxiliary layer and an electron blocking layer.

### p-dopant

In one or more embodiments, the hole transport region may include a charge generating material as well as the aforementioned materials to improve conductive properties of the hole transport region. The charge generating material may be substantially homogeneously or non-homogeneously dispersed (for example, as a single layer including (e.g., consisting of) a charge generating material) in the hole transport region.

The charge generating material may include, for example, a p-dopant.

In some embodiments, a lowest unoccupied molecular orbital (LUMO) energy level of the p-dopant may be -3.5 eV or less.

In some embodiments, the p-dopant may include a quinone derivative, a compound containing a cyano group, a compound containing element EL1 and element EL2, or any combination thereof.

Non-limiting examples of the quinone derivative may include tetracyanoquinodimethane (TCNQ), 2,3,5,6-tetrafluoro-7,7,8,8-tetracyanoquinodimethane (F4-TCNQ), and/or the like.

Non-limiting examples of the compound containing a cyano group may include dipyrazino[2,3-f: 2',3'-h] quinoxaline-2,3,6,7,10,11-hexacarbonitrile (HAT-CN), a compound represented by Formula 221, and/or the like: 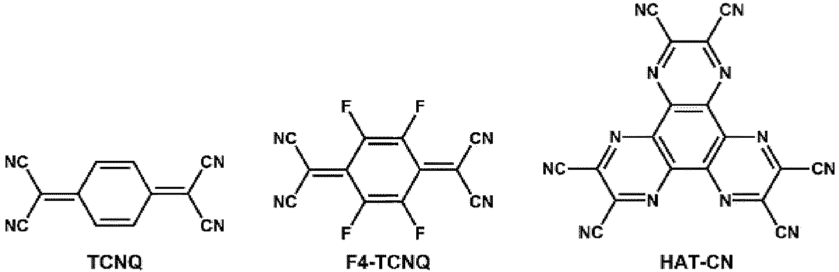 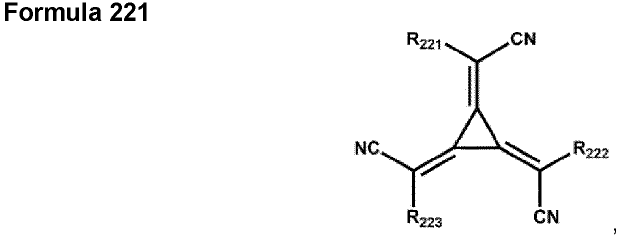 wherein, in Formula 221,
R₂₂₁ to R₂₂₃ may each independently be a C₃-C₆₀ (*e.g.* C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ, and
at least one selected from among R₂₂₁ to R₂₂₃ may each independently be: a C₃-C₆₀ (*e.g.* C₃-C₃₀) carbocyclic group or a C₁-C₆₀ (*e.g.* C₁-C₂₀) heterocyclic group, each substituted with a cyano group; -F; -Cl; -Br; -I; a C₁-C₂₀ alkyl group substituted with a cyano group, -F, -Cl, -Br, -I, or any combination thereof; or any combination thereof.

In the compound containing element EL1 and element EL2, element EL1 may be a metal, a metalloid, or a combination thereof, and element EL2 may be non-metal, a metalloid, or a combination thereof.

Non-limiting examples of the metal may include: an alkali metal (e.g., lithium (Li), sodium (Na), potassium (K), rubidium (Rb), cesium (Cs), and/or the like); an alkaline earth metal (e.g., beryllium (Be), magnesium (Mg), calcium (Ca), strontium (Sr), barium (Ba), and/or the like); a transition metal (e.g., titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), and/or the like); a post-transition metal (e.g., zinc (Zn), indium (In), tin (Sn), and/or the like); a lanthanide metal (e.g., lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), and/or the like); and/or the like.

Non-limiting examples of the metalloid may include silicon (Si), antimony (Sb), tellurium (Te), and/or the like.

Non-limiting examples of the non-metal may include oxygen (O), halogen (e.g., F, Cl, Br, I, and/or the like), and/or the like.

For example, the compound containing element EL1 and element EL2 may include a metal oxide, a metal halide (e.g., metal fluoride, metal chloride, metal bromide, metal iodide, and/or the like), a metalloid halide (e.g., a metalloid fluoride, a metalloid chloride, a metalloid bromide, a metalloid iodide, and/or the like), a metal telluride, or any combination thereof.

Non-limiting examples of the metal oxide may include tungsten oxide (e.g., WO, W₂O₃, WO₂, WO₃, W₂O₅, and/or the like), vanadium oxide (e.g., VO, V₂O₃, VO₂, V₂O₅, and/or the like), molybdenum oxide (MoO, Mo₂O₃, MoO₂, MoO₃, Mo₂O₅, and/or the like), rhenium oxide (e.g., ReO₃ and/or the like), and/or the like.

Non-limiting examples of the metal halide may include alkali metal halide, alkaline earth metal halide, transition metal halide, post-transition metal halide, lanthanide metal halide, and/or the like.

Non-limiting examples of the alkali metal halide may include LiF, NaF, KF, RbF, CsF, LiCl, NaCl, KCI, RbCl, CsCl, LiBr, NaBr, KBr, RbBr, CsBr, Lil, Nal, KI, Rbl, CsI, and/or the like.

Non-limiting examples of the alkaline earth metal halide may include BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, Bel₂, Mgl₂, Cal₂, Srl₂, Bal₂, and/or the like.

Non-limiting examples of the transition metal halide may include titanium halide (e.g., TiF₄, TiCl₄, TiBr₄, TiI₄, and/or the like), zirconium halide (e.g., ZrF₄, ZrCl₄, ZrBr₄, ZrI₄, and/or the like), hafnium halide (e.g., HfF₄, HfCl₄, HfBr₄, HfI₄, and/or the like), vanadium halide (e.g., VF₃, VCl₃, VBr₃, VI₃, and/or the like), niobium halide (e.g., NbF₃, NbCl₃, NbBr₃, NbI₃, and/or the like), tantalum halide (e.g., TaF₃, TaCl₃, TaBr₃, TaI₃, and/or the like), chromium halide (e.g., CrF₃, CrCl₃, CrBr₃, Crl₃, and/or the like), molybdenum halide (e.g., MoF₃, MoCl₃, MoBr₃, MoI₃, and/or the like), tungsten halide (e.g., WF₃, WCl₃, WBr₃, WI₃, and/or the like), manganese halide (e.g., MnF₂, MnCl₂, MnBr₂, MnI₂, and/or the like), technetium halide (e.g., TcF₂, TcCl₂, TcBr₂, TcI₂, and/or the like), rhenium halide (e.g., ReF₂, ReCl₂, ReBr₂, ReI₂, and/or the like), iron halide (e.g., FeF₂, FeCl₂, FeBr₂, FeI₂, and/or the like), ruthenium halide (e.g., RuF₂, RuCl₂, RuBr₂, RuI₂, and/or the like), osmium halide (e.g., OsF₂, OsCl₂, OsBr₂, OsI₂, and/or the like), cobalt halide (e.g., CoF₂, CoCl₂, CoBr₂, CoI₂, and/or the like), rhodium halide (e.g., RhF₂, RhCl₂, RhBr₂, RhI₂, and/or the like), iridium halide (e.g., IrF₂, IrCl₂, IrBr₂, IrI₂, and/or the like), nickel halide (e.g., NiF₂, NiCl₂, NiBr₂, NiI₂, and/or the like), palladium halide (e.g., PdF₂, PdCl₂, PdBr₂, PdI₂, and/or the like), platinum halide (e.g., PtF₂, PtCl₂, PtBr₂, PtI₂, and/or the like), copper halide (e.g., CuF, CuCl, CuBr, Cul, and/or the like), silver halide (e.g., AgF, AgCl, AgBr, AgI, and/or the like), gold halide (e.g., AuF, AuCl, AuBr, Aul, and/or the like), and/or the like.

Non-limiting examples of the post-transition metal halide may include zinc halide (e.g., ZnF₂, ZnCl₂, ZnBr₂, ZnI₂, and/or the like), indium halide (e.g., InI₃ and/or the like), tin halide (e.g., SnI₂ and/or the like), and/or the like.

Non-limiting examples of the lanthanide metal halide may include YbF, YbF₂, YbF₃, SmF₃, YbCl, YbCl₂, YbCl₃, SmCl₃, YbBr, YbBr₂, YbBr₃, SmBr₃, Ybl, YbI₂, YbI₃, SmI₃, and/or the like.

Non-limiting examples of the metalloid halide may include antimony halide (e.g., SbCl₅ and/or the like) and/or the like.

Non-limiting examples of the metal telluride may include alkali metal telluride (e.g., Li₂Te, Na₂Te, K₂Te, Rb₂Te, Cs₂Te, and/or the like), alkaline earth metal telluride (e.g., BeTe, MgTe, CaTe, SrTe, BaTe, and/or the like), transition metal telluride (e.g., TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, and/or the like), post-transition metal telluride (e.g., ZnTe and/or the like), lanthanide metal telluride (e.g., LaTe, CeTe, PrTe, NdTe, PmTe, EuTe, GdTe, TbTe, DyTe, HoTe, ErTe, TmTe, YbTe, LuTe, and/or the like), and/or the like.

### Emission layer in interlayer 130

When the light-emitting device 10 is a full color light-emitting device, the emission layer may be patterned into a red emission layer, a green emission layer, and/or a blue emission layer, according to a sub-pixel. In one or more embodiments, the emission layer may have a stacked structure. The stacked structure may include two or more layers selected from a red emission layer, a green emission layer, and a blue emission layer. The two or more layers may be in direct contact with each other or may be separated from each other to emit white light (e.g., combined white light). In one or more embodiments, the emission layer may include two or more materials. The two or more materials may include a red light-emitting material, a green light-emitting material, and/or a blue light-emitting material. The two or more materials may be mixed with each other in a single layer to emit white light (e.g., combined white light).

The emission layer may include a host and a dopant. The dopant may be a phosphorescent dopant, a fluorescent dopant, or any combination thereof.

The amount of the dopant in the emission layer may be in a range of about 0.01 parts to about 15 parts by weight based on 100 parts by weight of the host.

In some embodiments, the emission layer may include quantum dots.

In some embodiments, the emission layer may include a delayed fluorescence material. The delayed fluorescence material may serve as a host or a dopant in the emission layer.

The thickness of the emission layer may be in a range of about 100 Å to about 1,000 Å, and in some embodiments, about 200 Å to about 600 Å. When the thickness of the emission layer is within any of these ranges, improved luminescence characteristics may be obtained without a substantial increase in driving voltage.

### Host

In one or more embodiments, the host may include a compound represented by Formula 301:

**Formula 301** **[Ar₃₀₁]_{xb11}-[(L₃₀₁)_{xb1}-R₃₀₁]_{xb21},**

wherein, in Formula 301,
Ar₃₀₁ and L₃₀₁ may each independently be a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ (e.g. C₁-C₂₀) alkyl group unsubstituted or substituted with at least one R₁₀ₐ, a C₂-C₆₀ (e.g. C₂-C₂₀) alkenyl group unsubstituted or substituted with at least one R₁₀ₐ, a C₂-C₆₀ (e.g. C₂-C₂₀) alkynyl group unsubstituted or substituted with at least one R₁₀ₐ, a C₁-C₆₀ (e.g. C₁-C₂₀) alkoxy group unsubstituted or substituted with at least one R₁₀ₐ, a C₃-C₆₀ (e.g. C₃-C₃₀) carbocyclic group unsubstituted or substituted with at least one R₁₀ₐ, a C₁-C₆₀ (e.g. C₁-C₂₀) heterocyclic group unsubstituted or substituted with at least one R₁₀ₐ, -Si(Q₃₀₁)(Q₃₀₂)(Q₃₀₃), -N(Q₃₀₁)(Q₃₀₂), -B(Q₃₀₁)(Q₃₀₂), - C(=O)(Q₃₀₁), -S(=O)₂(Q₃₀₁), or **-P(=O)(Q₃₀₁)(Q₃₀₂),**
xb21 may be an integer from 1 to 5, and
Q₃₀₁ to Q₃₀₃ may each be the same as the description of Q₁ provided herein.

In some embodiments, when xb11 in Formula 301 is 2 or greater, at least two Ar₃₀₁(s) may be bound via a single bond.

In some embodiments, the host may include a compound represented by Formula 301-1, a compound represented by Formula 301-2, or any combination thereof: 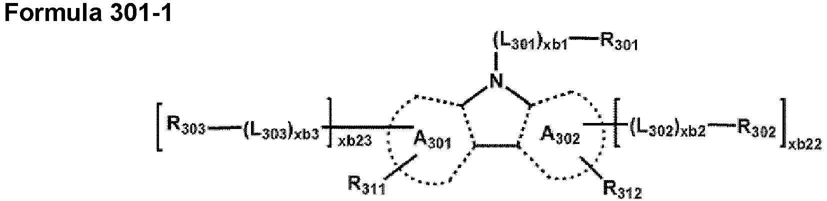 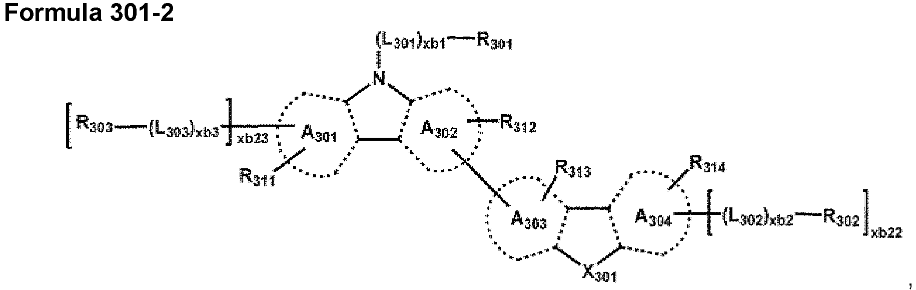
wherein, in Formulae 301-1 to 301-2,
ring A₃₀₁ to ring A₃₀₄ may each independently be a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may respectively be understood by referring to the descriptions of L₃₀₁, xb1, and R₃₀₁ provided herein,
L₃₀₂ to L₃₀₄ may each be the same as the description of L₃₀₁ provided herein,
xb2 to xb4 may each be the same as the description of xb1 provided herein, and
R₃₀₂ to R₃₀₅ and R₃₁₁ to R₃₁₄ may each be the same as the description of R₃₀₁ provided herein.

In some embodiments, the host may include an alkaline earth-metal complex, a post-transitional metal complex, or any combination thereof. For example, the host may include a Be complex (e.g., Compound H55), an Mg complex, a Zn complex, or any combination thereof.

In some embodiments, the host may include at least one selected from among Compounds H1 to H128, 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di(carbazol-9-yl)benzene (mCP), 1,3,5-tri(carbazol-9-yl)benzene (TCP), and/or any combination thereof:

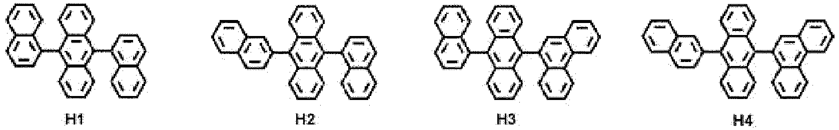

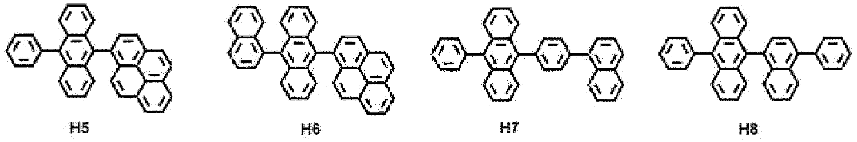

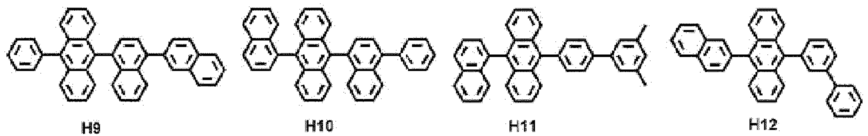

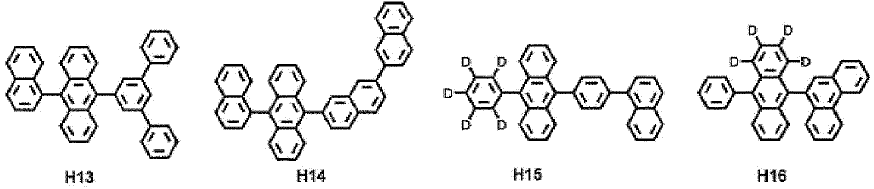

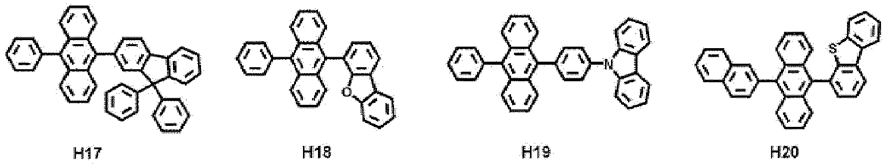

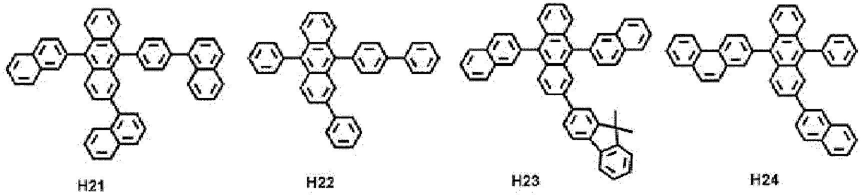

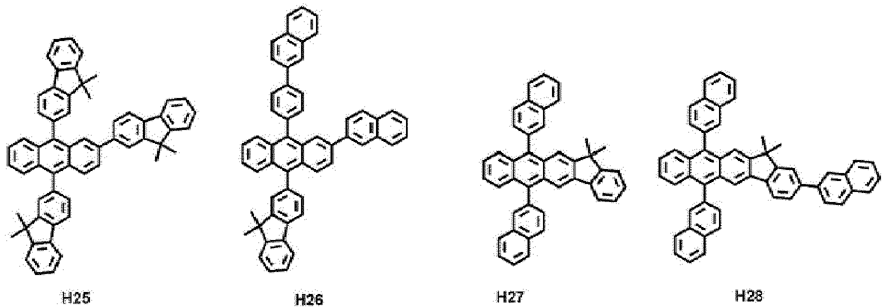

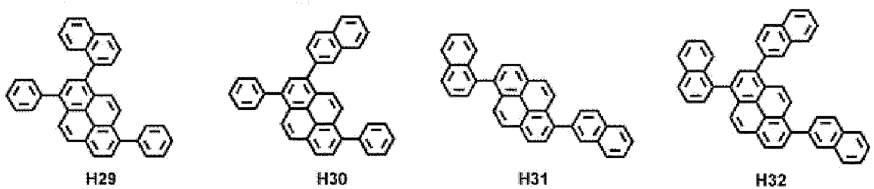

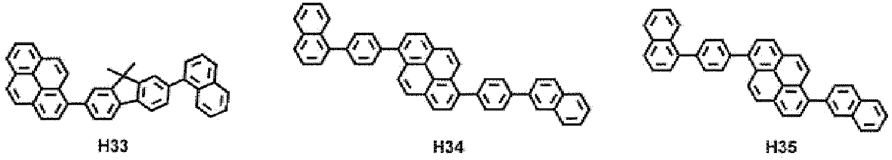

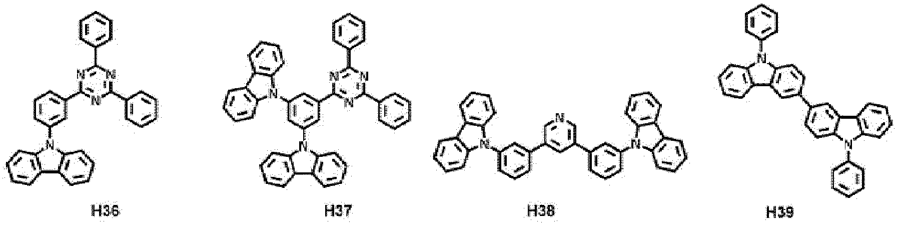

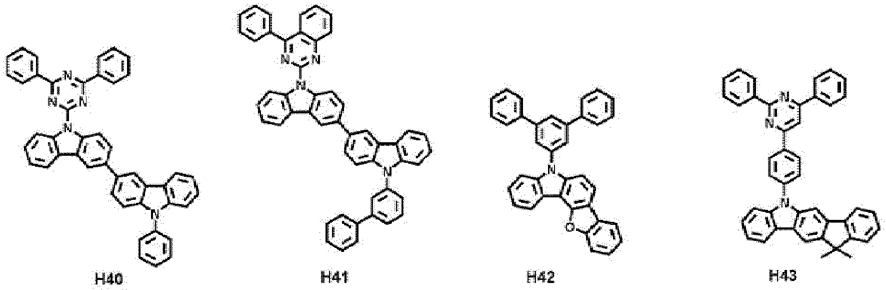

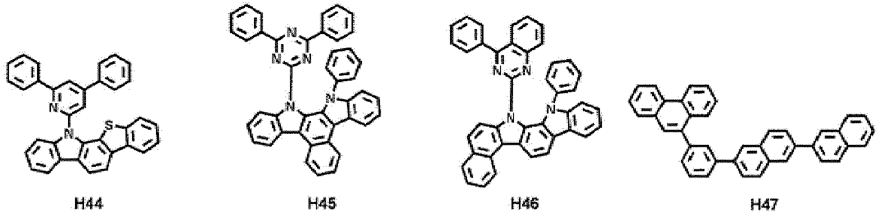

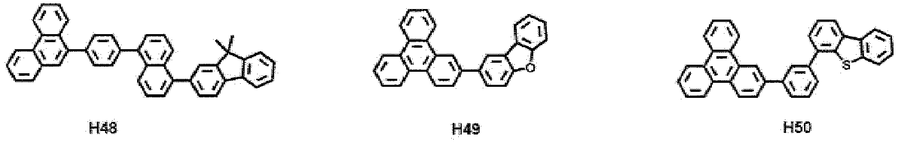

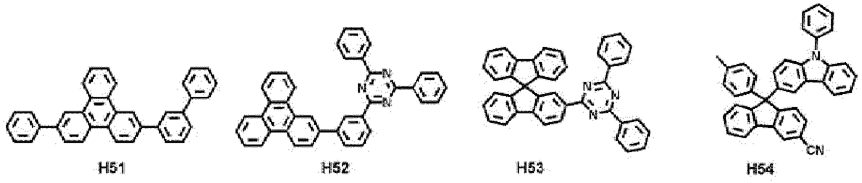

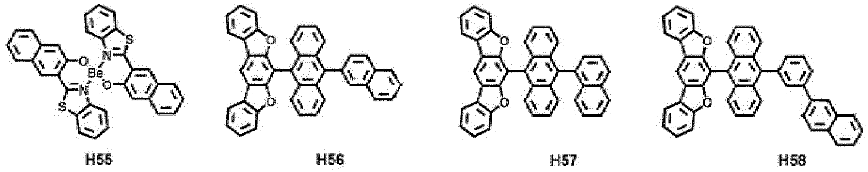

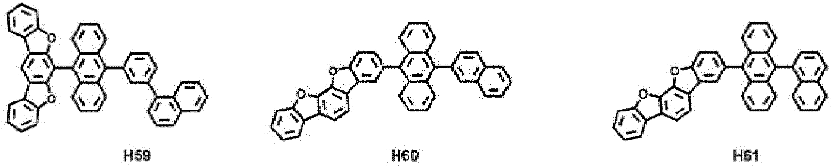

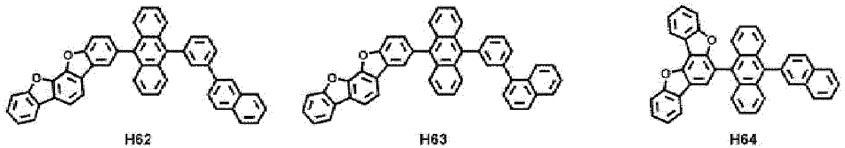

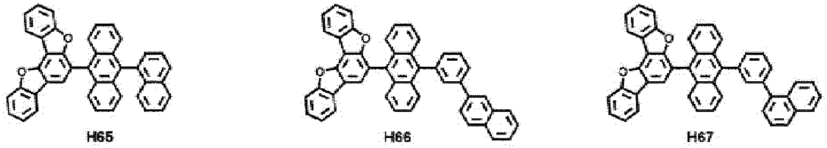

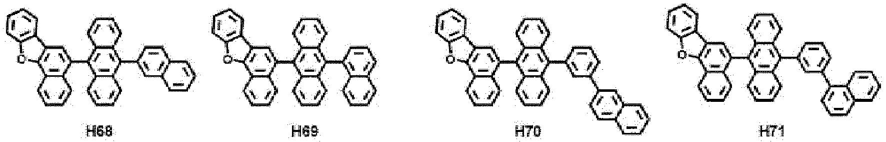

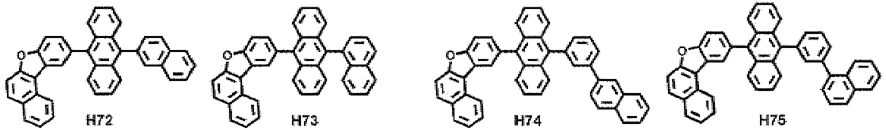

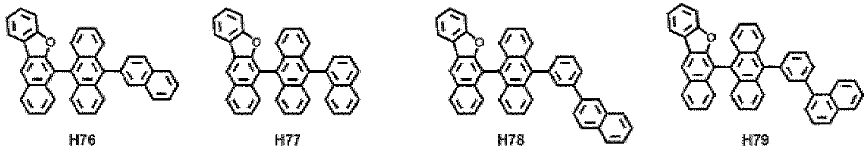

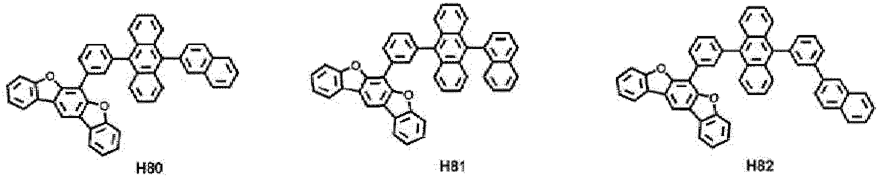

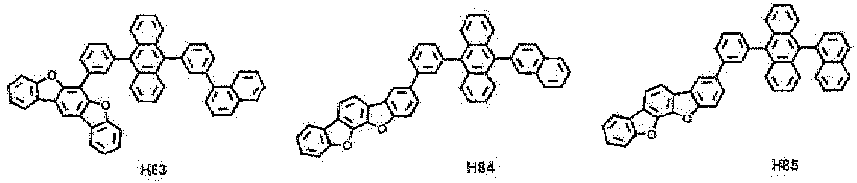

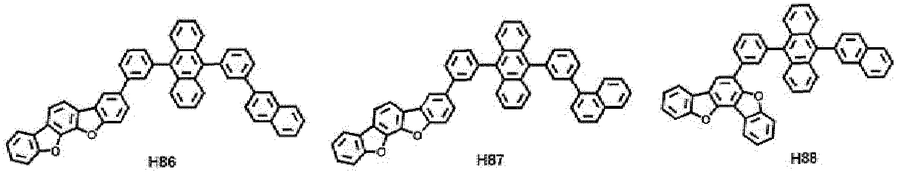

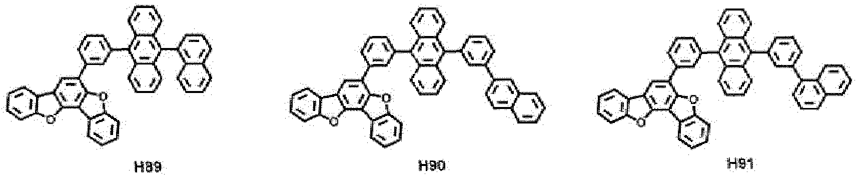

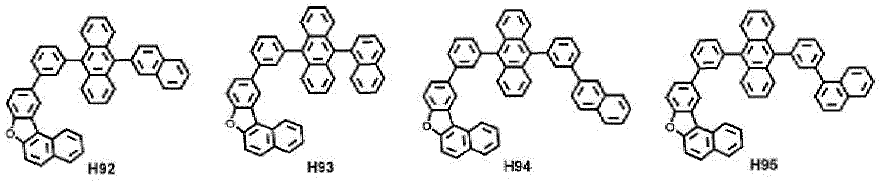

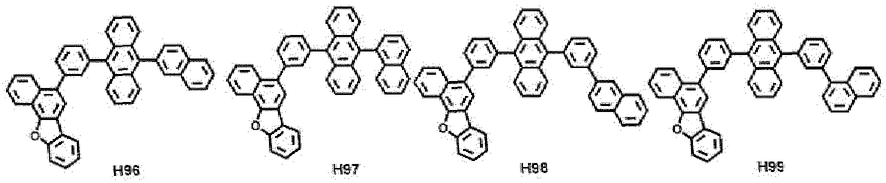

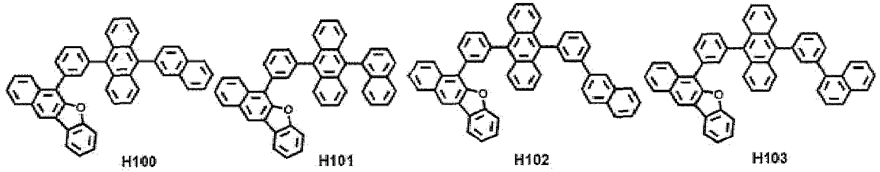

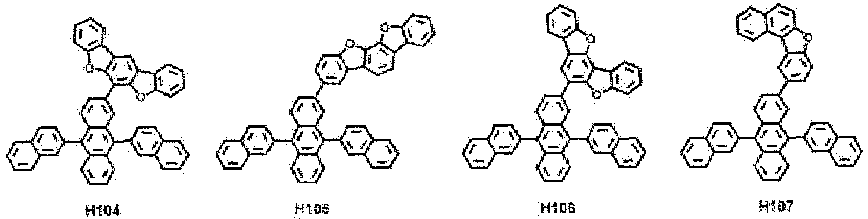

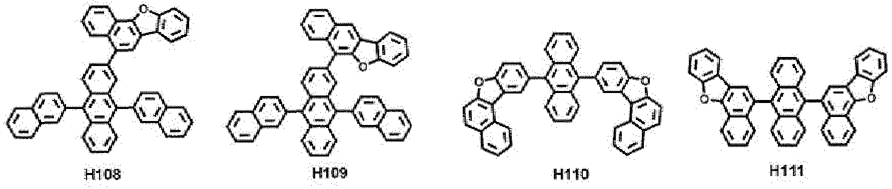

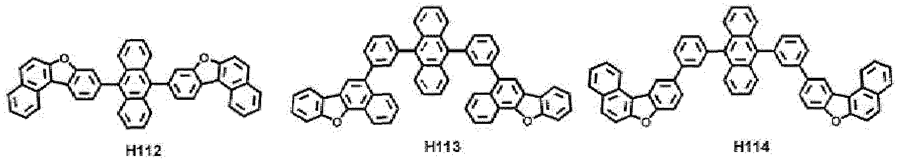

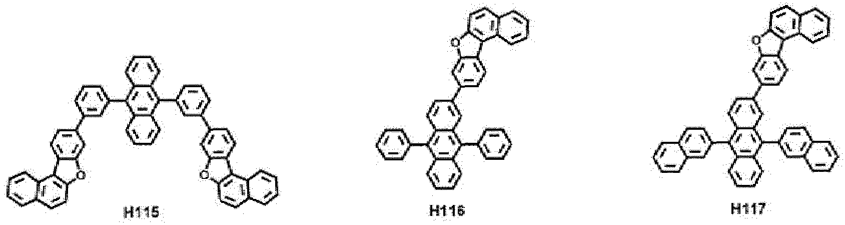

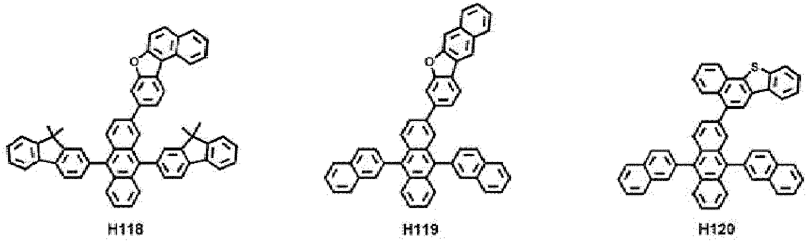

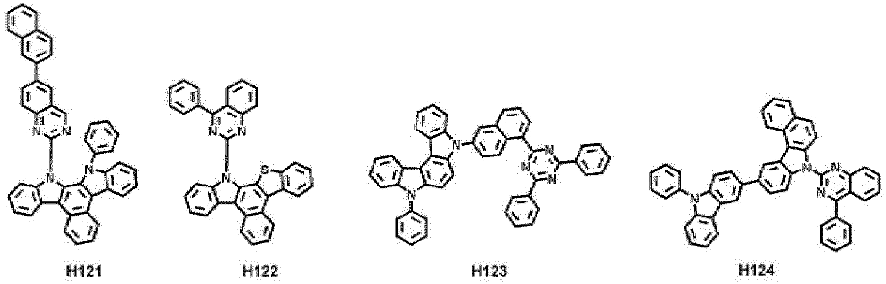

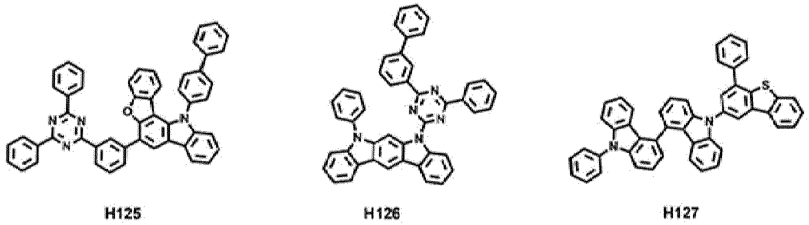

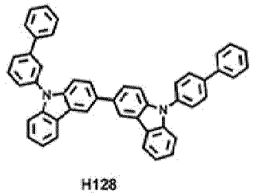

### Phosphorescent dopant

In one or more embodiments, the phosphorescent dopant may include at least one transition metal as a center metal.

The phosphorescent dopant may include a monodentate ligand, a bidentate ligand, a tridentate ligand, a tetradentate ligand, a pentadentate ligand, a hexadentate ligand, or any combination thereof.

In some embodiments, the phosphorescent dopant may be electrically neutral.

In some embodiments, the phosphorescent dopant may include an organometallic complex represented by Formula 401:

**Formula 401** M(L₄₀₁)_{xc1}(L₄₀₂)_{xc2}

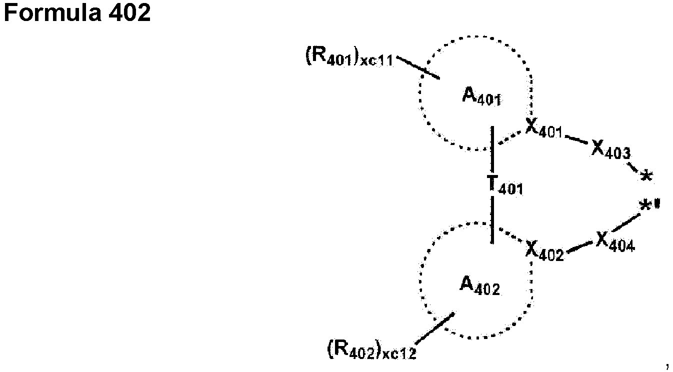

wherein, in Formulae 401 and 402,
M may be a transition metal (e.g., iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, and when xc1 is 2 or greater, at least two L₄₀₁(s) may be identical to or different from each other,
L₄₀₂ may be an organic ligand, and xc2 may be an integer from 0 to 4, and when xc2 is 2 or greater, at least two L₄₀₂(s) may be identical to or different from each other,
X₄₀₁ and X₄₀₂ may each independently be nitrogen or carbon,
ring A₄₀₁ and ring A₄₀₂ may each independently be a C₃-C₆₀ (e.g. C₃-C₃₀) carbocyclic group or a C₁-C₆₀ (e.g. C₁-C₂₀) heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (e.g., a covalent bond or a coordinate bond), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ may each be the same as the description of Q₁ provided herein,
R₄₀₁ and R₄₀₂ may each independently be hydrogen, deuterium, -F, -Cl, -Br, - I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ (e.g. C₃-C₃₀) carbocyclic group unsubstituted or substituted with at least one R₁₀ₐ, a C₁-C₆₀ (e.g. C₁-C₂₀) heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or -P(=O)(Q₄₀₁)(Q₄₀₂),
Q₄₀₁ to Q₄₀₃ may each be the same as the description of Q₁ provided herein,
xc11 and xc12 may each independently be an integer from 0 to 10, and
* and *' in Formula 402 may each indicate a binding site to M in Formula 401.

In one or more embodiments, in Formula 402, i) X₄₀₁ may be nitrogen, and X₄₀₂ may be carbon, or ii) X₄₀₁ and X₄₀₂ may both (e.g., simultaneously) be nitrogen.

In one or more embodiments, when xc1 in Formula 402 is 2 or greater, two ring A₄₀₁(s) of at least two L₄₀₁(s) may optionally be bound via T₄₀₂ as a linking group, and/or two ring A₄₀₂(s) may optionally be bound via T₄₀₃ as a linking group (see Compounds PD1 to PD4 and PD7). T₄₀₂ and T₄₀₃ may each be the same as the description of T₄₀₁ provided herein.

L₄₀₂ in Formula 401 may be any suitable organic ligand. For example, in one or more embodiments, L₄₀₂ may be a halogen, a diketone group (e.g., an acetylacetonate group), a carboxylic acid group (e.g., a picolinate group), -C(=O), an isonitrile group, -CN, a phosphorus group (e.g., a phosphine group or a phosphite group), or any combination thereof.

In one or more embodiments, the phosphorescent dopant may be, for example, at least one selected from among Compounds PD1 to PD39, and/or any combination thereof:

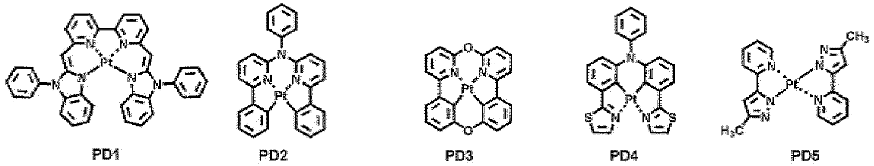

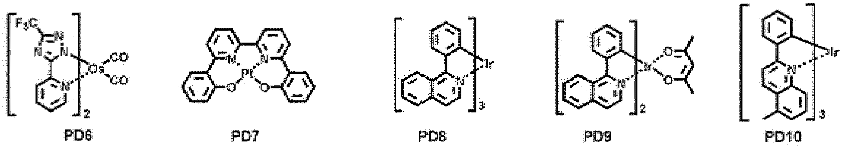

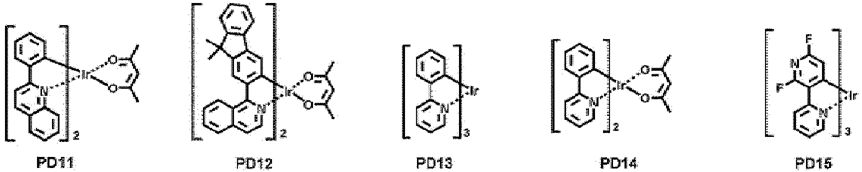

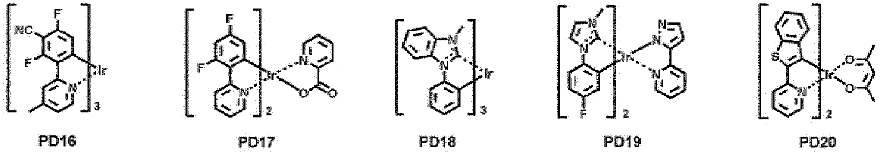

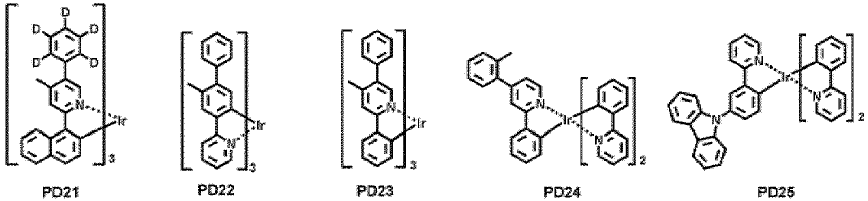

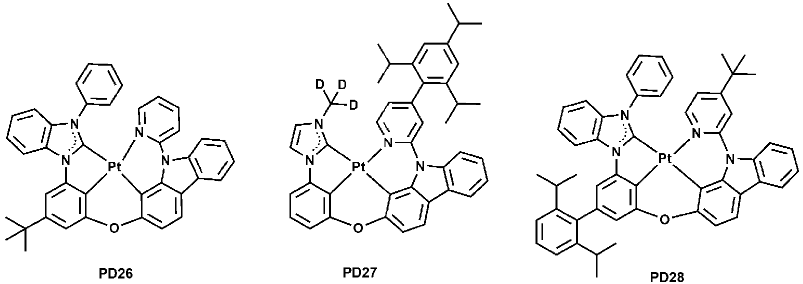

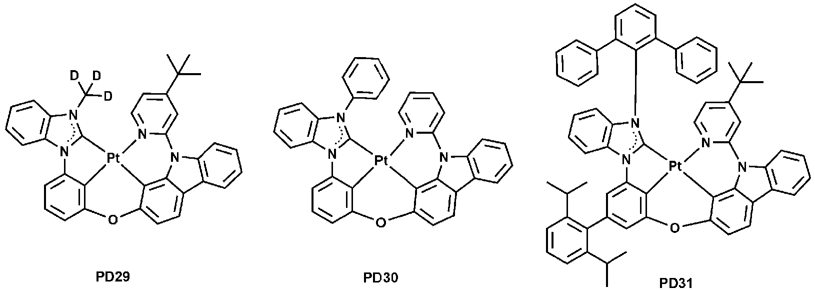

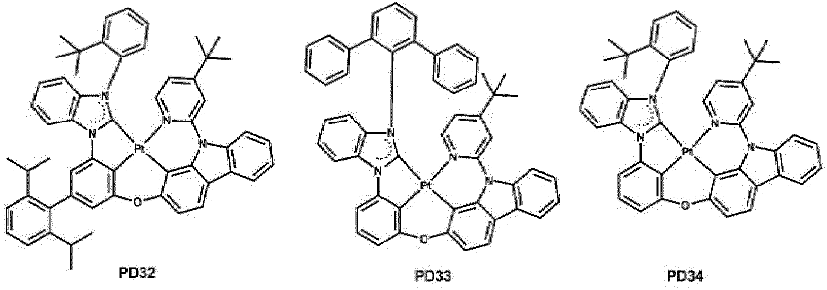

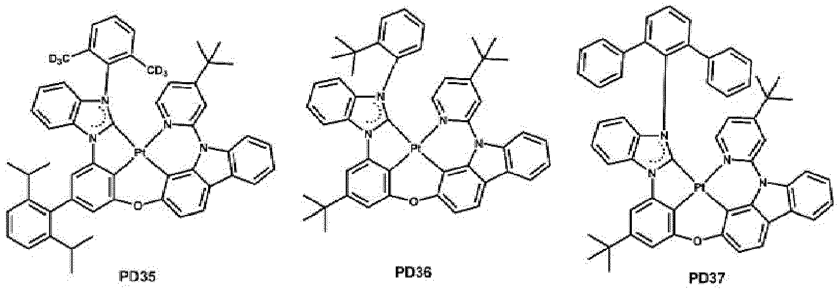

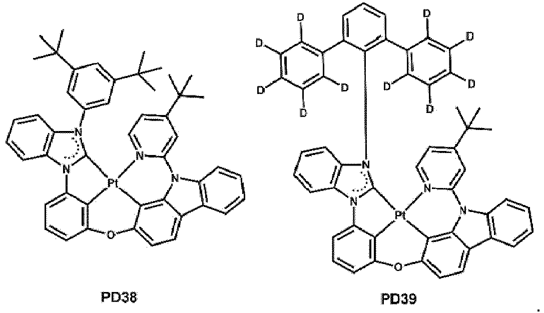

### Fluorescent dopant

In one or more embodiments, the fluorescent dopant may include an amine-containing compound, a styryl-containing compound, or any combination thereof.

In some embodiments, the fluorescent dopant may include a compound represented by Formula 501: 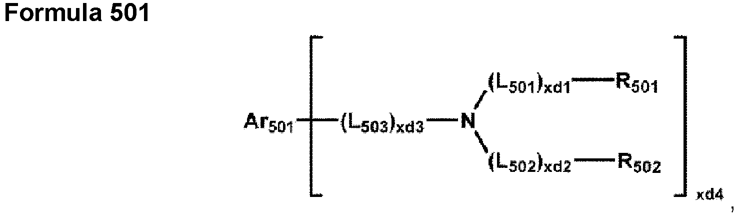 wherein, in Formula 501,
Ar₅₀₁, L₅₀₁ to L₅₀₃, R₅₀₁, and R₅₀₂ may each independently be a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
xd1 to xd3 may each independently be 0, 1, 2, or 3, and
xd4 may be 1, 2, 3, 4, 5, or 6.

In some embodiments, in Formula 501, Ar₅₀₁ may include a condensed ring group (e.g., an anthracene group, a chrysene group, or a pyrene group) in which at least three monocyclic groups are condensed.

In some embodiments, xd4 in Formula 501 may be 2.

In some embodiments, the fluorescent dopant may include at least one selected from among Compounds FD1 to FD37, 4,4'-bis(2,2-diphenylvinyl)-1,1'-biphenyl (DPVBi), 4,4'-bis[4-(di-p-tolylamino)styryl]biphenyl (DPAVBi), and/or any combination thereof:

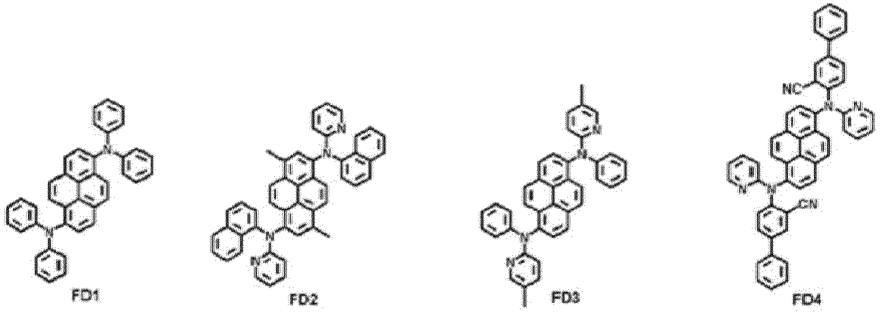

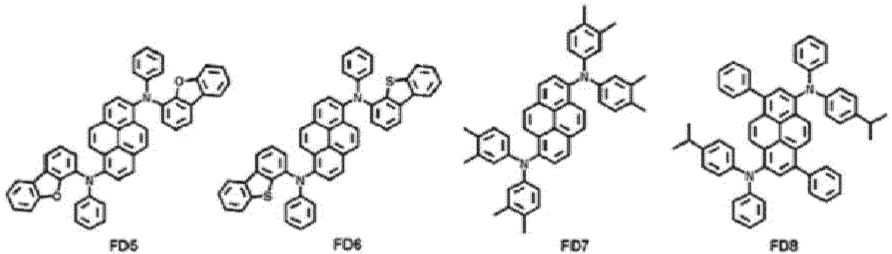

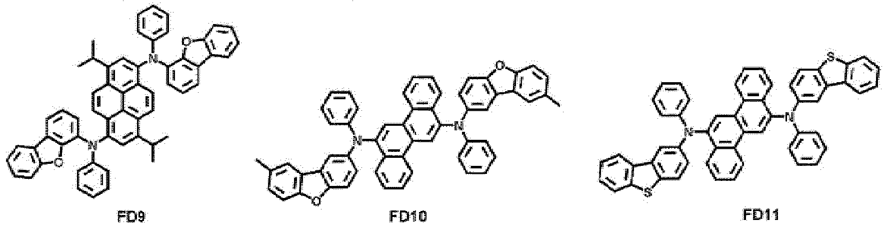

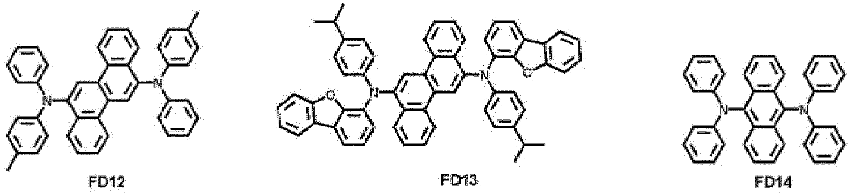

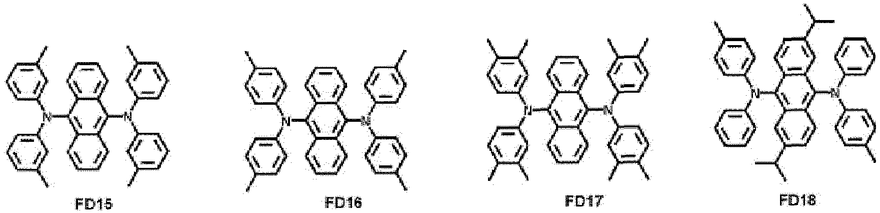

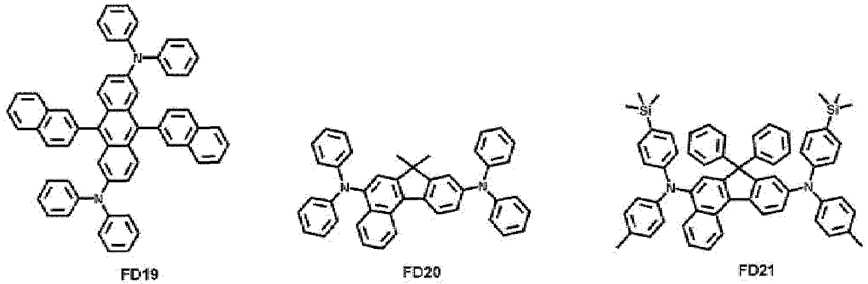

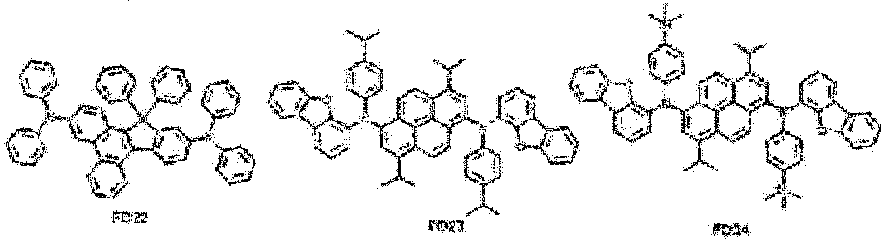

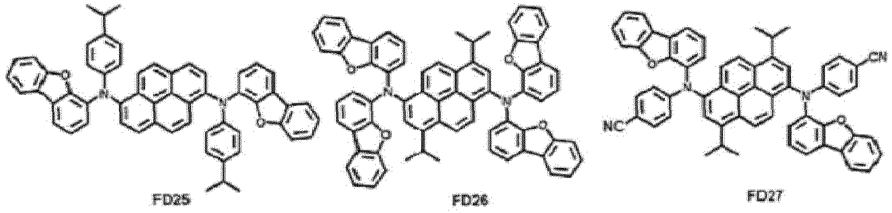

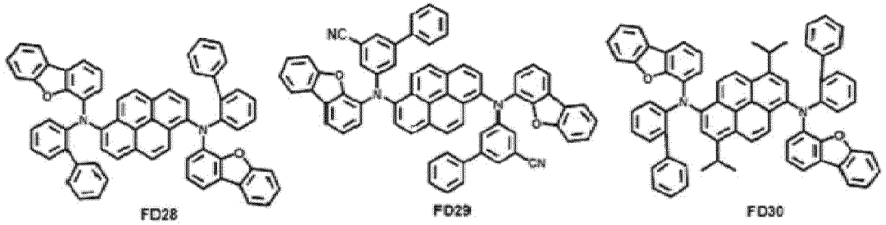

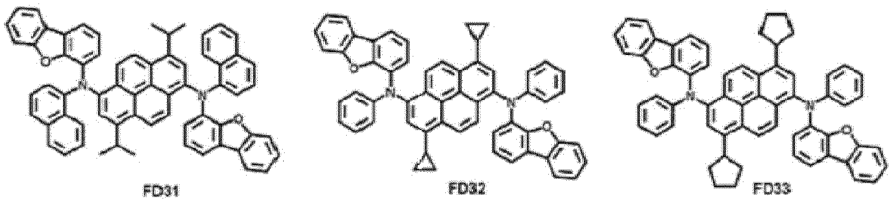

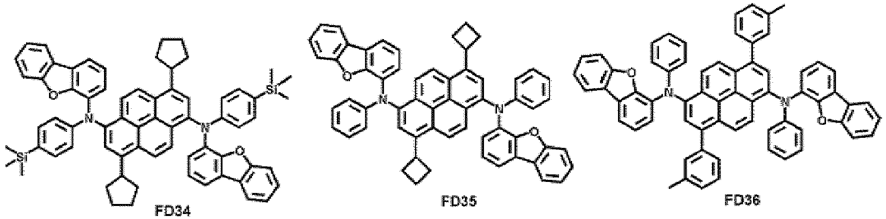

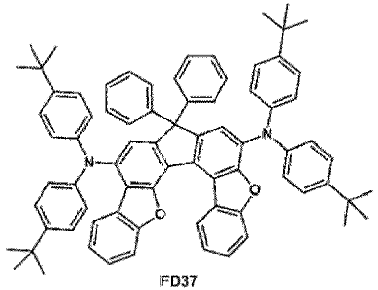

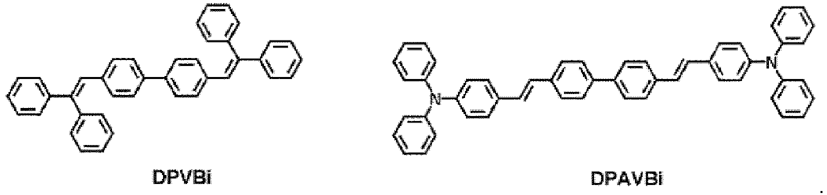

### Delayed fluorescence material

In one or more embodiments, the emission layer may include a delayed fluorescence material.

The delayed fluorescence material described herein may be any suitable compound that may be to emit delayed fluorescence according to a delayed fluorescence emission mechanism.

The delayed fluorescence material included in the emission layer may serve as a host or a dopant, depending on types (kinds) of other materials included in the emission layer.

In some embodiments, a difference between a triplet energy level (eV) of the delayed fluorescence material and a singlet energy level (eV) of the delayed fluorescence material may be about 0 eV or greater and about 0.5 eV or less. When the difference between the triplet energy level (eV) of the delayed fluorescence material and the singlet energy level (eV) of the delayed fluorescence material is within this range, up-conversion from the triplet state to the singlet state in the delayed fluorescence material may be effectively occurred, thus improving luminescence efficiency and/or the like of the light-emitting device 10.

In some embodiments, the delayed fluorescence material may include: i) a material including at least one electron donor (e.g., a π electron-rich C₃-C₆₀ (e.g. C₃-C₃₀) cyclic group such as a carbazole group and/or the like) and at least one electron acceptor (e.g., a sulfoxide group, a cyano group, a π electron-deficient nitrogen-containing C₁-C₆₀ (e.g. C₁-C₃₀) cyclic group, and/or the like), ii) a material including a C₈-C₆₀ (e.g. C₈-C₃₀) polycyclic group including at least two cyclic groups condensed to each other and sharing boron (B), and/or the like.

Non-limiting examples of the delayed fluorescence material may include at least one selected from among Compounds DF1 to DF14:

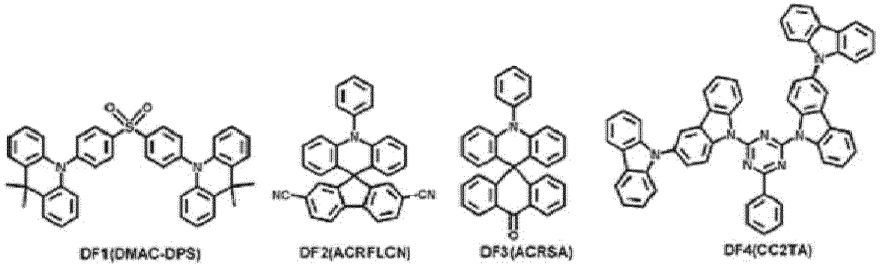

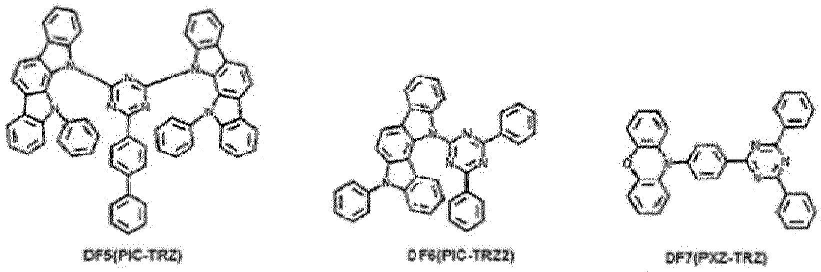

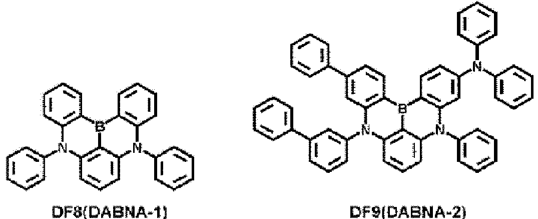

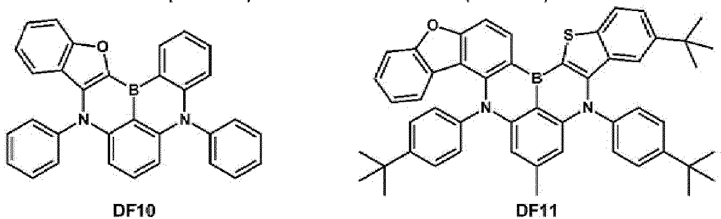

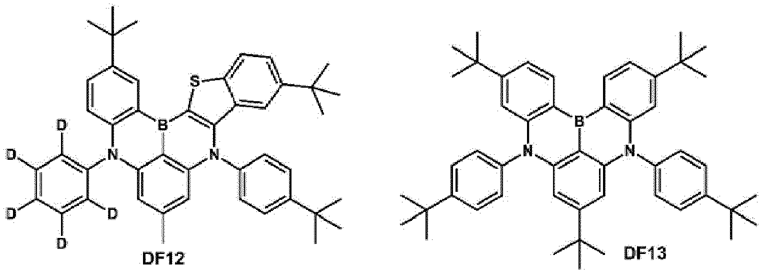

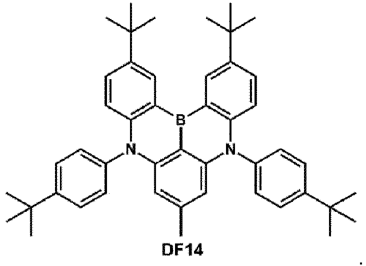

### Quantum dots

In one or more embodiments, the emission layer may include quantum dots.

The term "quantum dot" as utilized herein may refer to a crystal of a semiconductor compound and may include any suitable material capable of emitting light with emission wavelengths of one or more suitable lengths according to the size of the crystal.

The diameter of the quantum dot may be, for example, in a range of about 1 nm to about 10 nm.

Quantum dots may be synthesized by a wet chemical process, an organic metal chemical vapor deposition process, a molecular beam epitaxy process, or any similar process.

The wet chemical process is a method of growing a quantum dot particle crystal by mixing a precursor material with an organic solvent. When the crystal grows, the organic solvent may naturally serve as a dispersant coordinated on the surface of the quantum dot crystal and control the growth of the crystal. Thus, the wet chemical method may be easier to perform than the vapor deposition process such a metal organic chemical vapor deposition (MOCVD) or a molecular beam epitaxy (MBE) process. Further, the growth of quantum dot particles may be controlled or selected with a lower manufacturing cost.

The quantum dot may include a group II-VI semiconductor compound; a group III-V semiconductor compound; a group III-VI semiconductor compound; a group I-III-VI semiconductor compound; a group IV-VI semiconductor compound; a group IV element or compound; or any combination thereof.

Non-limiting examples of the group II-VI semiconductor compound may include a binary compound such as CdS, CdSe, CdTe, ZnS, ZnSe, ZnTe, ZnO, HgS, HgSe, HgTe, MgSe, or MgS; a ternary compound such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS; a quaternary compound such as CdZnSeS, CdZnSeTe, CdZnSTe, CdHgSeS, CdHgSeTe, CdHgSTe, HgZnSeS, HgZnSeTe, or HgZnSTe; and/or a combination thereof.

Non-limiting examples of the group III-V semiconductor compound may include a binary compound such as GaN, GaP, GaAs, GaSb, AIN, AlP, AlAs, AlSb, InN, InP, InAs, or InSb; a ternary compound such as GaNP, GaNAs, GaNSb, GaPAs, GaPSb, AINP, AlNAs, AlNSb, AlPAs, AlPSb, InGaP, InNP, InAlP, InNAs, InNSb, InPAs, or InPSb; a quaternary compound such as GaAlNP, GaAINAs, GaAlNSb, GaAlPAs, GaAlPSb, GaInNP, GaInNAs, GaInNSb, GaInPAs, GaInPSb, InAlNP, InAlNAs, InAlNSb, InAlPAs, or InAlPSb; and/or any combination thereof. In some embodiments, the group III-V semiconductor compound may further include a group II element. Non-limiting examples of the group III-V semiconductor compound further including the group II element may include InZnP, InGaZnP, InAlZnP, and/or the like.

Non-limiting examples of the group III-VI semiconductor compound may include a binary compound such as GaS, GaSe, Ga₂Se₃, GaTe, InS, InSe, In₂S₃, In₂Se₃, InTe, and/or the like; a ternary compound such as InGaS₃, InGaSe₃, and/or the like; and/or any combination thereof.

Non-limiting examples of the group I-III-VI semiconductor compound may include a ternary compound such as AgInS, AgInS₂, CuInS, CuInS₂, CuGaO₂, AgGaO₂, AgAlO₂, and/or any combination thereof.

Non-limiting examples of the group IV-VI semiconductor compound may include: a binary compound such as SnS, SnSe, SnTe, PbS, PbSe, or PbTe; a ternary compound such as SnSeS, SnSeTe, SnSTe, PbSeS, PbSeTe, PbSTe, SnPbS, SnPbSe, or SnPbTe; a quaternary compound such as SnPbSSe, SnPbSeTe, or SnPbSTe; and/or a combination thereof.

The group IV element or compound may be a single element material such as Si or Ge; a binary compound such as SiC or SiGe; or a combination thereof.

Individual elements included in the multi-element compound, such as a binary compound, a ternary compound, and a quaternary compound, may be present in a particle thereof at a substantially uniform or non-substantially uniform concentration.

The quantum dot may have a single structure in which the concentration of each element included in the quantum dot is substantially uniform or a core-shell double structure. In some embodiments, materials included in the core may be different from materials included in the shell.

The shell of the quantum dot may serve as a protective layer for preventing or reducing chemical denaturation of the core to maintain semiconductor characteristics and/or as a charging layer for imparting electrophoretic characteristics to the quantum dot. The shell may be a monolayer or a multilayer. An interface between a core and a shell may have a concentration gradient where a concentration of elements present in the shell decreases toward the core.

Non-limiting examples of the shell of the quantum dot may include metal, metalloid, or nonmetal oxide, a semiconductor compound, or a combination thereof. Non-limiting examples of the metal oxide, metalloid, or nonmetal oxide may include: a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO; a ternary compound such as MgAl₂O₄, CoFe₂O₄, NiFe₂O₄, or CoMn₂O₄; and/or any combination thereof. Non-limiting examples of the semiconductor compound may include: a group II-VI semiconductor compound; a group III-V semiconductor compound; a group III-VI semiconductor compound; a group I-III-VI semiconductor compound; a group IV-VI semiconductor compound; and/or any combination thereof. In some embodiments, the semiconductor compound suitable for the shell may be CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or any combination thereof.

The quantum dot may have a full width of half maximum (FWHM) of an emission spectrum of about 45 nm or less, about 40 nm or less, or about 30 nm or less. When the FWHM of the quantum dot is within this range, color purity or color reproducibility may be improved. In some embodiments, because light emitted through the quantum dots is emitted in all directions, an optical viewing angle may be improved.

In some embodiments, the quantum dot may be a substantially spherical, pyramidal, multi-arm, or cubic nanoparticle, nanotube, nanowire, nanofiber, or nanoplate particle.

By adjusting the size of the quantum dot, the energy band gap may also be adjusted, thereby obtaining light of one or more suitable wavelengths in the quantum dot emission layer. By utilizing quantum dots of one or more suitable sizes, a light-emitting device that may be to emit light of one or more suitable wavelengths may be realized. In some embodiments, the size of the quantum dot may be selected such that the quantum dot may be to emit red, green, and/or blue light. In some embodiments, the size of the quantum dot may be selected such that the quantum dot may be to emit white light by combining one or more suitable light colors.

### Electron transport region in interlayer 130

The electron transport region may have i) a single-layered structure including (e.g., consisting of) a single layer including (e.g., consisting of) a single material, ii) a single-layered structure including (e.g., consisting of) a single layer including a plurality of different materials, or iii) a multi-layered structure having a plurality of layers including a plurality of different materials.

The electron transport region may include a buffer layer, a hole blocking layer, an electron control layer, an electron transport layer, an electron injection layer, or any combination thereof.

In some embodiments, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein layers of each structure are sequentially stacked on the emission layer in each stated order.

In one or more embodiments, the electron transport region (e.g., a buffer layer, a hole blocking layer, an electron control layer, or an electron transport layer in the electron transport region) may include a metal-free compound including at least one π electron-deficient nitrogen-containing C₁-C₆₀ (e.g. C₁-C₃₀) cyclic group.

In some embodiments, the electron transport region may include a compound represented by Formula 601:

**Formula 601** **[Ar₆₀₁]ₓₑ₁₁-[(L₆₀₁)ₓₑ₁-R₆₀₁]ₓₑ₂₁,**

wherein, in Formula 601,
Ar₆₀₁ and L₆₀₁ may each independently be a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ (e.g. C₃-C₃₀) carbocyclic group unsubstituted or substituted with at least one R₁₀ₐ, a C₁-C₆₀ (e.g. C₁-C₂₀) heterocyclic group unsubstituted or substituted with at least one R₁₀ₐ, -Si(Q₆₀₁)(Q₆₀₂)(Q₆₀₃), -C(=O)(Q₆₀₁), - S(=O)₂(Q₆₀₁), or -P(=O)(Q₆₀₁)(Q₆₀₂),
Q₆₀₁ to Q₆₀₃ may each be the same as the description of Q₁ provided herein,
xe21 may be 1, 2, 3, 4, or 5, and
at least one selected from among Ar₆₀₁, L₆₀₁, and R₆₀₁ may each independently be a π electron-deficient nitrogen-containing C₁-C₆₀ (e.g. C₁-C₃₀) cyclic group unsubstituted or substituted with at least one R₁₀ₐ.

In some embodiments, when xe11 in Formula 601 is 2 or greater, at least two Ar₆₀₁(s) may be bound via a single bond.

In some embodiments, in Formula 601, Ar₆₀₁ may be a substituted or unsubstituted anthracene group.

In some embodiments, the electron transport region may include a compound represented by Formula 601-1: 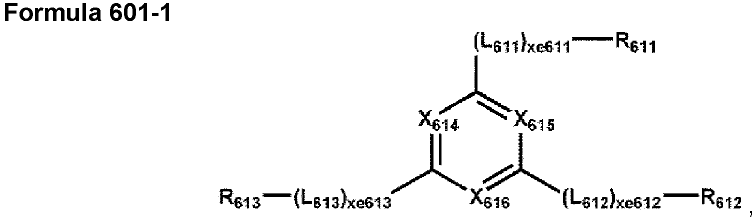 wherein, in Formula 601-1,
X₆₁₄ may be N or C(R₆₁₄), X₆₁₅ may be N or C(R₆₁₅), X₆₁₆ may be N or C(R₆₁₆), and at least one selected from among X₆₁₄ to X₆₁₆ may be **N,**
L₆₁₁ to L₆₁₃ may each be the same as the description of L₆₀₁ provided herein,
xe611 to xe613 may each be the same as the description of xe1 provided herein,
R₆₁₁ to R₆₁₃ may each be the same as the description of R₆₀₁ provided herein, and
R₆₁₄ to R₆₁₆ may each independently be hydrogen, deuterium, -F, -Cl, -Br, -I, a hydroxyl group, a cyano group, a nitro group, a C₁-C₂₀ (e.g. C₁-C₁₀) alkyl group, a C₁-C₂₀ (e.g. C₁-C₁₀) alkoxy group, a C₃-C₆₀ (e.g. C₃-C₃₀) carbocyclic group unsubstituted or substituted with at least one R₁₀ₐ, or a C₁-C₆₀ (e.g. C₁-C₂₀) heterocyclic group unsubstituted or substituted with at least one R₁₀ₐ.

For example, in Formulae 601 and 601-1, xe1 and xe611 to xe613 may each independently be 0, 1, or 2.

In one or more embodiments, The electron transport region may include at least one selected from among Compounds ET1 to ET45, 2,9-dimethyl-4,7-diphenyl-1,10-phenanthroline (BCP), 4,7-diphenyl-1,10-phenanthroline (Bphen), tris(8-hydroxyquinolinato)aluminium (Alq₃), bis(2-methyl-8-quinolinolato-N1,O8)-(1,1'-biphenyl-4-olato)aluminium (BAlq), 3-(4-biphenyl)-4-phenyl-5-tert-butylphenyl-1,2,4-triazole (TAZ), 4-(naphthalen-1-yl)-3,5-diphenyl-4H-1,2,4-triazole (NTAZ), and/or any combination thereof:

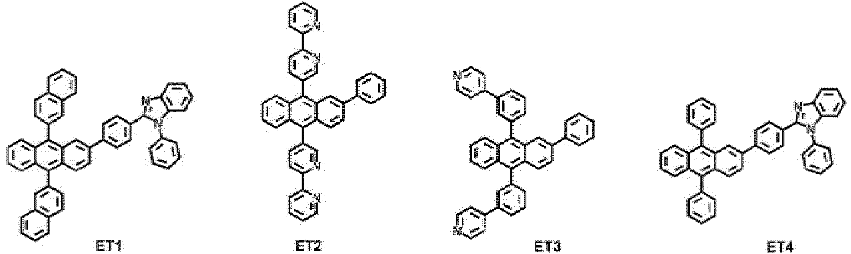

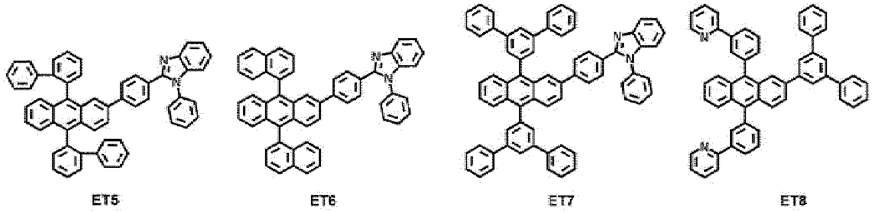

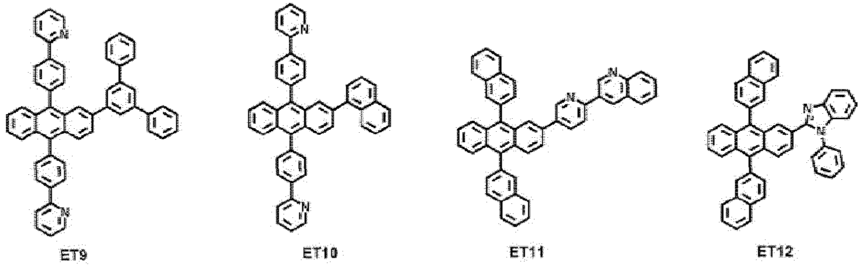

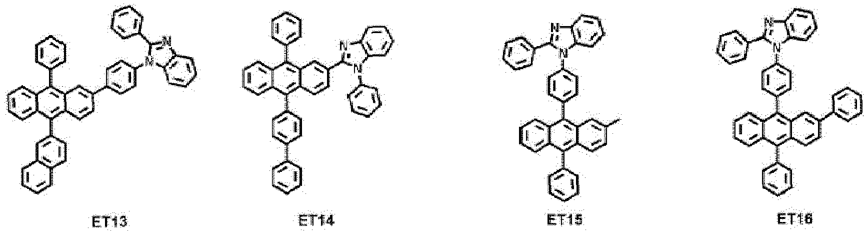

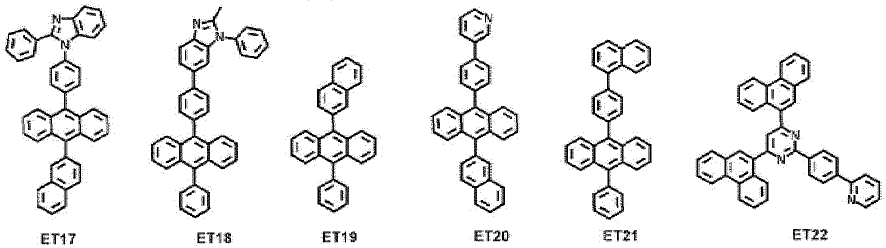

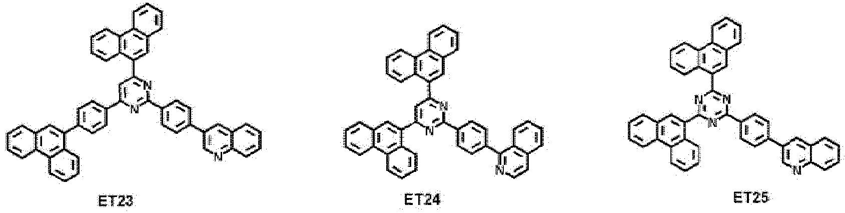

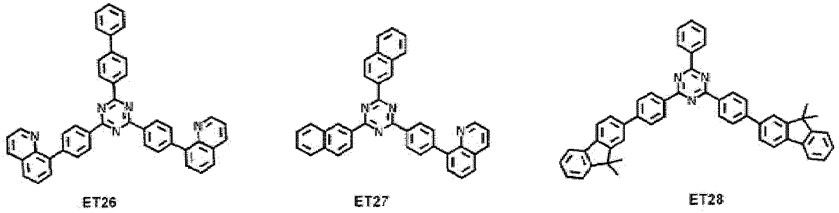

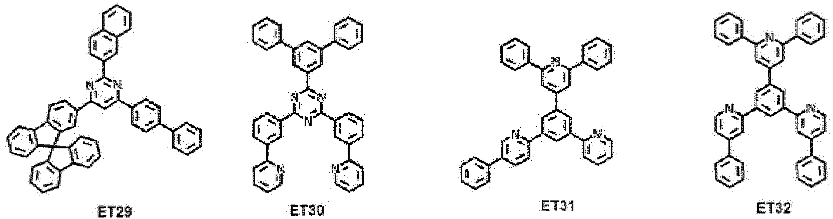

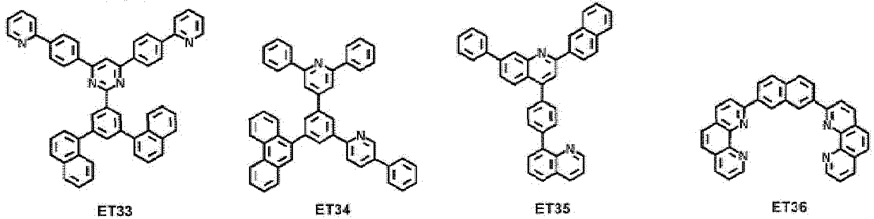

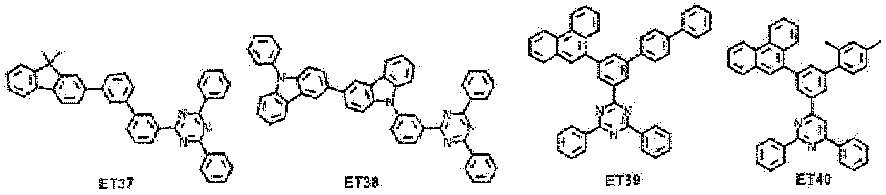

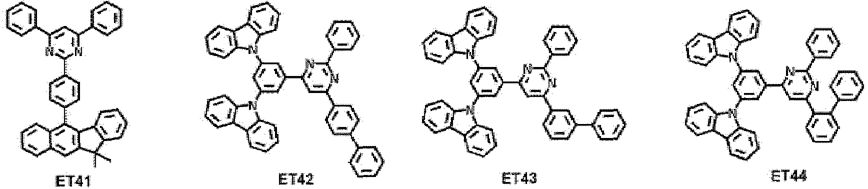

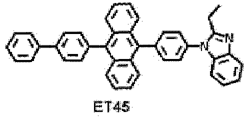

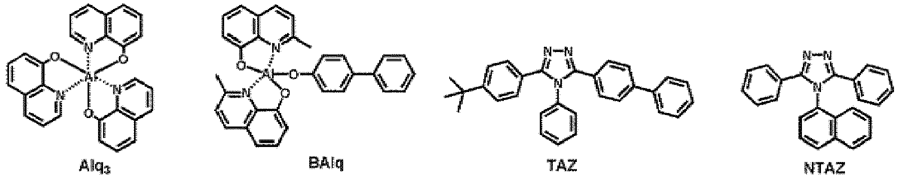

The thickness of the electron transport region may be in a range of about 100 Å to about 5,000 Å, and in some embodiments, about 160 Å to about 4,000 Å. When the electron transport region includes a buffer layer, a hole blocking layer, an electron control layer, an electron transport layer, or any combination thereof, the thicknesses of the buffer layer, the hole blocking layer, or the electron control layer may each independently be in a range of about 20 Å to about 1,000 Å, for example, about 30 Å to about 300 Å, and the thickness of the electron transport layer may be in a range of about 100 Å to about 1,000 Å, for example, about 150 Å to about 500 Å. When the thicknesses of the buffer layer, the hole blocking layer, the electron control layer, the electron transport layer, and/or the electron transport region are each within these ranges, excellent or suitable electron transport characteristics may be obtained without a substantial increase in driving voltage.

In one or more embodiments, the electron transport region (for example, the electron transport layer in the electron transport region) may further include, in addition to the materials described above, a metal-containing material.

The metal-containing material may include an alkali metal complex, an alkaline earth metal complex, or any combination thereof. A metal ion of the alkali metal complex may be a lithium (Li) ion, a sodium (Na) ion, a potassium (K) ion, a rubidium (Rb) ion, or a cesium (Cs) ion. A metal ion of the alkaline earth metal complex may be a beryllium (Be) ion, a magnesium (Mg) ion, a calcium (Ca) ion, a strontium (Sr) ion, or a barium (Ba) ion. Each ligand coordinated with the metal ion of the alkali metal complex or the alkaline earth metal complex may independently be hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, or any combination thereof.

For example, in some embodiments, the metal-containing material may include a Li complex. The Li complex may include, e.g., Compound ET-D1 (LiQ) or Compound ET-D2:

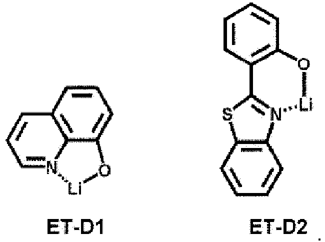

In one or more embodiments, the electron transport region may include an electron injection layer that facilitates injection of electrons from the second electrode 150. The electron injection layer may be in direct contact with the second electrode 150.

The electron injection layer may have i) a single-layered structure including (e.g., consisting of) a single layer including (e.g., consisting of) a single material, ii) a single-layered structure including (e.g., consisting of) a single layer including a plurality of different materials, or iii) a multi-layered structure having a plurality of layers including a plurality of different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may be Li, Na, K, Rb, Cs, or any combination thereof. The alkaline earth metal may be Mg, Ca, Sr, Ba, or any combination thereof. The rare earth metal may be Sc, Y, Ce, Tb, Yb, Gd, or any combination thereof.

The alkali metal-containing compound, the alkaline earth metal-containing compound, and the rare earth metal-containing compound may respectively be oxides, halides (e.g., fluorides, chlorides, bromides, or iodides), tellurides, or any combination thereof of each of the alkali metal, the alkaline earth metal, and the rare earth metal.

The alkali metal-containing compound may be alkali metal oxides such as Li₂O, Cs₂O, or K₂O, alkali metal halides such as LiF, NaF, CsF, KF, Lil, Nal, CsI, or KI, or any combination thereof. The alkaline earth-metal-containing compound may include alkaline earth-metal oxides, such as BaO, SrO, CaO, BaₓSr₁₋ₓO (wherein x is a real number satisfying 0<x<1), or BaₓCa₁₋ₓO (wherein x is a real number satisfying 0<x<1). The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In some embodiments, the rare earth metal-containing compound may include a lanthanide metal telluride. Non-limiting examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and/or the like.

The alkali metal complex, the alkaline earth metal complex, and the rare earth metal complex may include: i) one of ions of the alkali metal, alkaline earth metal, and rare earth metal described above, respectively, and ii) a ligand bond to the metal ion, e.g., hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, or any combination thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In some embodiments, the electron injection layer may further include an organic material (e.g., a compound represented by Formula 601).

In some embodiments, the electron injection layer may include (e.g., consist of) i) an alkali metal-containing compound (e.g., alkali metal halide), or ii) a) an alkali metal-containing compound (e.g., alkali metal halide); and b) an alkali metal, an alkaline earth metal, a rare earth metal, or any combination thereof. In some embodiments, the electron injection layer may be a KI:Yb co-deposition layer, a RbI:Yb co-deposition layer, a LiF:Yb co-deposition layer, and/or the like.

When the electron injection layer further includes an organic material, the alkali metal, the alkaline earth metal, the rare earth metal, the alkali metal-containing compound, the alkaline earth metal-containing compound, the rare earth metal-containing compound, the alkali metal complex, the alkaline earth metal complex, the rare earth metal complex, or any combination thereof may be homogeneously or non-homogeneously dispersed in a matrix including the organic material.

The thickness of the electron injection layer may be in a range of about 1 Å to about 100 Å, and in some embodiments, about 3 Å to about 90 Å. When the thickness of the electron injection layer is within any of these ranges, excellent or suitable electron injection characteristics may be obtained without a substantial increase in driving voltage.

### Second electrode 150

The second electrode 150 may be on the interlayer 130. In one or more embodiments, the second electrode 150 may be a cathode that is an electron injection electrode. In these embodiments, a material for forming the second electrode 150 may be a material having a low work function, for example, a metal, an alloy, an electrically conductive compound, or a combination thereof.

The second electrode 150 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layered structure, or a multi-layered structure including two or more layers.

### Capping layer

A first capping layer may be located outside the first electrode 110, and/or a second capping layer may be located outside the second electrode 150. In some embodiments, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

In some embodiments, in the light-emitting device 10, light emitted from the emission layer in the interlayer 130 may pass through the first electrode 110 (which may be a semi-transmissive electrode or a transmissive electrode) and through the first capping layer to the outside. In some embodiments, in the light-emitting device 10, light emitted from the emission layer in the interlayer 130 may pass through the second electrode 150 (which may be a semi-transmissive electrode or a transmissive electrode) and through the second capping layer to the outside.

The first capping layer and the second capping layer may improve the external luminescence efficiency based on the principle of constructive interference. Accordingly, the optical extraction efficiency of the light-emitting device 10 may be increased, thus improving the luminescence efficiency of the light-emitting device 10.

The first capping layer and the second capping layer may each include a material having a refractive index of 1.6 or higher (at 589 nm).

The first capping layer and the second capping layer may each independently be an organic capping layer including an organic material, an inorganic capping layer including an inorganic material, or an organic-inorganic composite capping layer including an organic material and an inorganic material.

At least one selected from among the first capping layer and the second capping layer may each independently include carbocyclic compounds, heterocyclic compounds, amine group-containing compounds, porphine derivatives, phthalocyanine derivatives, naphthalocyanine derivatives, alkali metal complexes, alkaline earth metal complexes, or any combination thereof. The carbocyclic compound, the heterocyclic compound, and the amine group-containing compound may optionally be substituted with a substituent of O, N, S, Se, Si, F, Cl, Br, I, or any combination thereof. In some embodiments, at least one selected from among the first capping layer and the second capping layer may each independently include an amine group-containing compound.

In some embodiments, at least one selected from among the first capping layer and the second capping layer may each independently include a compound represented by Formula 201, a compound represented by Formula 202, or any combination thereof.

In one or more embodiments, at least one selected from among the first capping layer and the second capping layer may each independently include at least one selected from among Compounds HT28 to HT33, at least one selected from among Compounds CP1 to CP6, β-NPB, and/or any combination thereof:

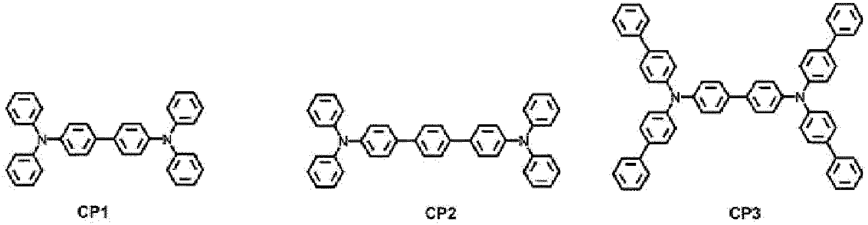

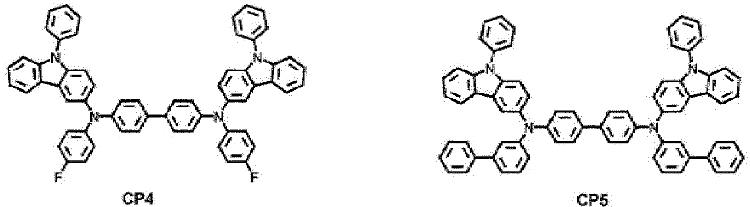

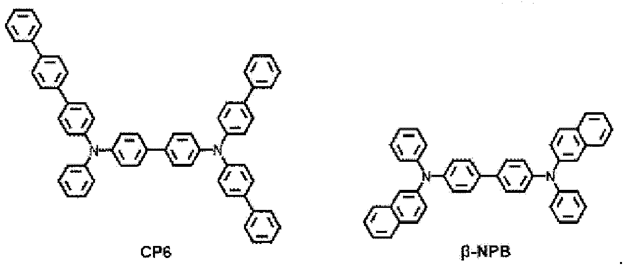

### Film

The condensed cyclic compound represented by Formula 1 may be included in one or more suitable films. According to one or more embodiments, a film including the condensed cyclic compound represented by Formula 1 may be provided. The film may be, for example, an optical member (or, a light-controlling member) (e.g., a color filter, a color-conversion member, a capping layer, a light extraction efficiency improvement layer, a selective light-absorbing layer, a polarizing layer, a quantum dot-containing layer, and/or the like), a light-blocking member (e.g., a light reflection layer or a light-absorbing layer), and/or a protection member (e.g., an insulating layer or a dielectric material layer).

### Electronic apparatus

The light-emitting device may be included in one or more suitable electronic apparatuses. In some embodiments, an electronic apparatus including the light-emitting device may be a light-emitting apparatus or an authentication apparatus.

In one or more embodiments, the electronic apparatus (e.g., a light-emitting apparatus) may further include, in addition to the light-emitting device, i) a color filter, ii) a color conversion layer, or iii) a color filter and a color conversion layer. The color filter and/or the color conversion layer may be disposed on at least one traveling direction of light emitted from the light-emitting device. For example, in some embodiments, light emitted from the light-emitting device may be blue light or white light (e.g., combined white light). The light-emitting device may be understood by referring to the descriptions provided herein. In some embodiments, the color conversion layer may include quantum dots. The quantum dot may be, for example, the quantum dot described herein.

The electronic apparatus may include a first substrate. The first substrate may include a plurality of sub-pixel areas, the color filter may include a plurality of color filter areas respectively corresponding to the plurality of sub-pixel areas, and the color conversion layer may include a plurality of color conversion areas respectively corresponding to the plurality of sub-pixel areas.

A pixel-defining film may be located between the plurality of sub-pixel areas to define each sub-pixel area.

The color filter may further include a plurality of color filter areas and light-blocking patterns between the plurality of color filter areas, and the color conversion layer may further include a plurality of color conversion areas and light-blocking patterns between the plurality of color conversion areas.

The plurality of color filter areas (or a plurality of color conversion areas) may include: a first area emitting first color light; a second area emitting second color light; and/or a third area emitting third color light, and the first color light, the second color light, and/or the third color light may have different maximum emission wavelengths. In some embodiments, the first color light may be red light, the second color light may be green light, and the third color light may be blue light. In some embodiments, the plurality of color filter areas (or the plurality of color conversion areas) may each include quantum dots. In some embodiments, the first area may include red quantum dots to emit red light, the second area may include green quantum dots to emit green light, and the third area may not include (e.g., may exclude) a quantum dot. The quantum dot may be understood by referring to the description of the quantum dot provided herein. The first area, the second area, and/or the third area may each further include an emitter.

In some embodiments, the light-emitting device may be to emit first light, the first area may be to absorb the first light to emit first-first color light, the second area may be to absorb the first light to emit second-first color light, and the third area may be to absorb the first light to emit third-first color light. In these embodiments, the first-first color light, the second-first color light, and the third-first color light may each have a different maximum emission wavelength. In some embodiments, the first light may be blue light, the first-first color light may be red light, the second-first color light may be green light, and the third-first light may be blue light.

In one or more embodiments, the electronic apparatus may further include a thin-film transistor, in addition to the light-emitting device. The thin-film transistor may include a source electrode, a drain electrode, and an active layer, wherein one selected from the source electrode and the drain electrode may be electrically connected to the first electrode or the second electrode of the light-emitting device.

The thin-film transistor may further include a gate electrode, a gate insulating film, and/or the like.

The active layer may include a crystalline silicon, an amorphous silicon, an organic semiconductor, and/or an oxide semiconductor.

The electronic apparatus may further include an encapsulation unit for sealing the light-emitting device. The encapsulation unit may be located between the color filter and/or the color conversion layer and the light-emitting device. The encapsulation unit may allow light to pass to the outside from the light-emitting device and prevent or reduce the air and moisture to permeate to the light-emitting device at the same time. The encapsulation unit may be a sealing substrate including transparent glass or a plastic substrate. The encapsulation unit may be a thin-film encapsulating layer including at least one of an organic layer and/or an inorganic layer. When the encapsulation unit is a thin-film encapsulating layer, the electronic apparatus may be flexible.

In addition to the color filter and/or the color conversion layer, one or more suitable functional layers may be disposed on the encapsulation unit depending on the utilization of an electronic apparatus. Non-limiting examples of the functional layer may include a touch screen layer, a polarizing layer, and/or the like. The touch screen layer may be a resistive touch screen layer, a capacitive touch screen layer, or an infrared beam touch screen layer. The authentication apparatus may be, for example, a biometric authentication apparatus that identifies an individual according to biometric information (e.g., a fingertip, a pupil, and/or the like).

The authentication apparatus may further include a biometric information collecting unit, in addition to the light-emitting device described above.

The electronic apparatus may be applicable to one or more suitable displays, an optical source, lighting, a personal computer (e.g., a mobile personal computer), a cellphone, a digital camera, an electronic note, an electronic dictionary, an electronic game console, a medical device (e.g., an electronic thermometer, a blood pressure meter, a glucometer, a pulse measuring device, a pulse wave measuring device, an electrocardiograph recorder, an ultrasonic diagnosis device, or an endoscope display device), a fish finder, one or more suitable measurement devices, gauges (e.g., gauges of an automobile, an airplane, or a ship), and/or a projector.

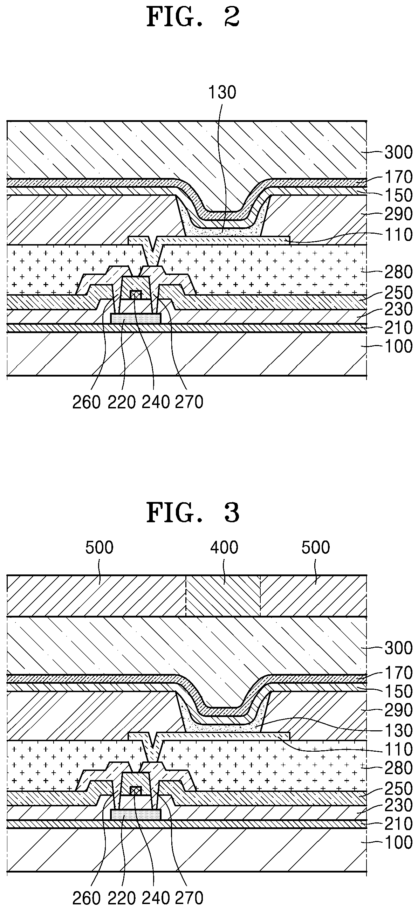

### Descriptions of FIGs. 2 and 3

FIG. 2 is a schematic cross-sectional view of an embodiment of an electronic apparatus according to the present disclosure.

The electronic apparatus in FIG. 2 may include a substrate 100, a thin-film transistor, a light-emitting device, and an encapsulation unit 300 sealing the light-emitting device.

The substrate 100 may be a flexible substrate, a glass substrate, or a metal substrate. A buffer layer 210 may be on the substrate 100. The buffer layer 210 may prevent or reduce penetration of impurities through the substrate 100 and provide a flat surface on the substrate 100.

A thin-film transistor may be on the buffer layer 210. The thin-film transistor may include an active layer 220, a gate electrode 240, a source electrode 260, and a drain electrode 270.

The active layer 220 may include an inorganic semiconductor such as silicon or polysilicon, an organic semiconductor, or an oxide semiconductor and include a source area, a drain area, and a channel area.

A gate insulating film 230 for insulating the active layer 220 and the gate electrode 240 may be on the active layer 220, and the gate electrode 240 may be on the gate insulating film 230.

An interlayer insulating film 250 may be on the gate electrode 240. The interlayer insulating film 250 may be between the gate electrode 240 and the source electrode 260 and between the gate electrode 240 and the drain electrode 270 to provide insulation therebetween.

The source electrode 260 and the drain electrode 270 may be on the interlayer insulating film 250. The interlayer insulating film 250 and the gate insulating film 230 may be formed to expose the source area and the drain area of the active layer 220, and the source electrode 260 and the drain electrode 270 may be adjacent to the exposed source area and the exposed drain area of the active layer 220, respectively.

Such a thin-film transistor may be electrically connected to a light-emitting device to drive the light-emitting device and may be protected by a passivation layer 280. The passivation layer 280 may include an inorganic insulating film, an organic insulating film, or a combination thereof. A light-emitting device may be on the passivation layer 280. The light-emitting device may include a first electrode 110, an interlayer 130, and a second electrode 150.

The first electrode 110 may be on the passivation layer 280. The passivation layer 280 may not fully cover the drain electrode 270 but expose a specific area of the drain electrode 270, and the first electrode 110 may be disposed to connect to the exposed area of the drain electrode 270.

A pixel-defining film 290 may be on the first electrode 110. The pixel-defining film 290 may expose a specific area of the first electrode 110, and the interlayer 130 may be formed in the exposed area of the first electrode 110. The pixel-defining film 290 may be a polyimide or polyacrylic organic film. In some embodiments, at least some layers of the interlayer 130 may extend to the upper portion of the pixel-defining film 290 to be located in the form of a common layer.

The second electrode 150 may be on the interlayer 130, and a capping layer 170 may be additionally formed on the second electrode 150. The capping layer 170 may be formed to cover the second electrode 150.

The encapsulation unit 300 may be on the capping layer 170. The encapsulation unit 300 may be on the light-emitting device to protect the light-emitting device from moisture and/or oxygen. The encapsulation unit 300 may include: an inorganic film including silicon nitride (SiNₓ), silicon oxide (SiOₓ), indium tin oxide, indium zinc oxide, or any combination thereof; an organic film including polyethylene terephthalate (PET), polyethylene naphthalate, polycarbonate, polyimide, polyethylene sulfonate, polyoxymethylene, poly arylate, hexamethyldisiloxane, an acrylic resin (e.g., polymethyl methacrylate, polyacrylic acid, and/or the like), an epoxy resin (e.g., aliphatic glycidyl ether (AGE) and/or the like), or any combination thereof; or a combination of the inorganic film and the organic film.

FIG. 3 is a schematic cross-sectional view of another embodiment of an electronic apparatus according to present disclosure.

The electronic apparatus shown in FIG. 3 may be substantially identical to the electronic apparatus shown in FIG. 2, except that a light-shielding pattern 500 and a functional area 400 are additionally located on the encapsulation unit 300. The functional area 400 may be i) a color filter area, ii) a color-conversion area, or iii) a combination of a color filter area and a color-conversion area. In some embodiments, the light-emitting device shown in FIG. 3 included in the electronic apparatus may be a tandem light-emitting device.

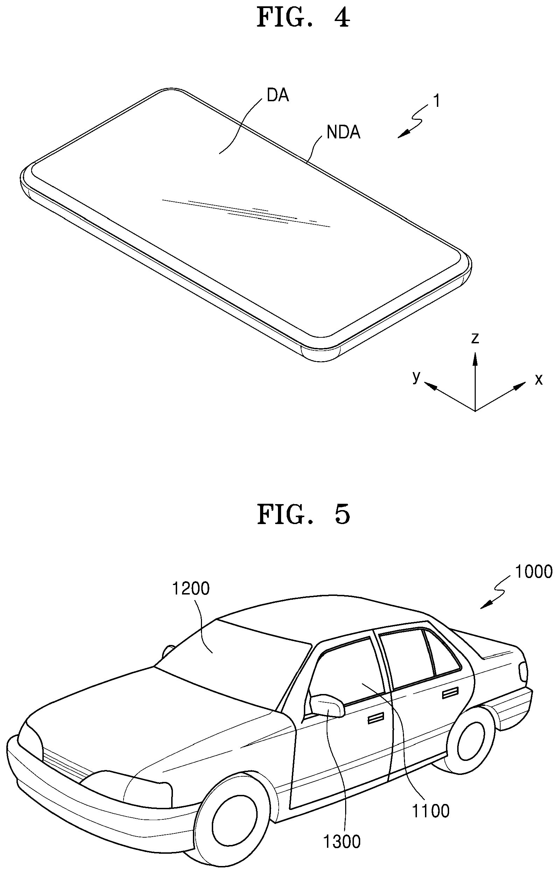

### Description of FIG. 4

FIG. 4 is a perspective view schematically illustrating electronic equipment 1 including a light-emitting device according to one or more embodiments of the present disclosure. The electronic equipment 1 may be an apparatus for displaying a moving image or still image, and may be any product such as a television, a laptop, a monitor, a billboard, or internet of things (IOT), as well as a portable electronic device such as a mobile phone, a smart phone, a tablet personal computer (PC), a mobile communication terminal, an electronic notebook, an electronic book, and a portable multimedia player (PMP) or navigation, an ultra-mobile PC (UMPC), or a part thereof. In some embodiments, the electronic equipment 1 may be a wearable device such as a smart watch, a watch phone, a glasses display, or a head mounted display (HMD), or a part thereof, but embodiments of the present disclosure are not limited thereto. For example, in some embodiments, the electronic equipment 1 may be a center information display (CID) on an instrument panel and a center fascia or dashboard of a vehicle, a room mirror display instead of a side mirror of a vehicle, an entertainment display for the rear seat of a car or a display placed on the back of the front seat, head up display (HUD) installed in the front of a vehicle or projected on a front window glass, or a computer generated hologram augmented reality head up display (CGH AR HUD). FIG. 4 shows an embodiment where the electronic equipment 1 is a smart phone for convenience of description.

The electronic equipment 1 may include a display area DA and a non-display area NDA outside the display area DA. A display apparatus of the electronic equipment 1 may realize an image through an array of a plurality of pixels that are two-dimensionally arranged in the display area DA.

The non-display area NDA may be an area that may not display an image, and may completely surround the display area DA. In the non-display area NDA, a driver for providing an electrical signal or power to the display devices arranged in the display area DA may be arranged. In the non-display area NDA, a pad, which is an area to which an electronic device or a printed circuit board may be electrically connected, may be arranged.

The electronic equipment 1 may have different lengths in the x-axis direction and in the y-axis direction. For example, as shown in FIG. 4, the length in the x-axis direction may be shorter than the length in the y-axis direction. As another example, the length in the x-axis direction may be the same as the length in the y-axis direction. As another example, the length in the x-axis direction may be longer than the length in the y-axis direction.

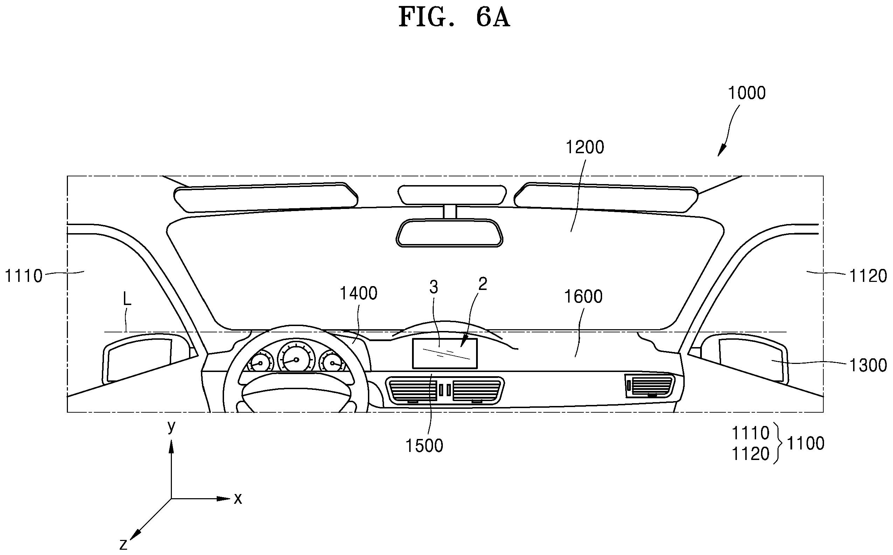

### Descriptions of FIGs. 5 and 6A to 6C

FIG. 5 is a schematic view illustrating an exterior of a vehicle 1000 as electronic equipment including a light-emitting device according to one or more embodiments of the present disclosure. FIGs. 6A to 6C are each a schematic view illustrating an interior of the vehicle 1000 according to one or more embodiments of the present disclosure.

In FIGs. 5 and 6A to 6C, the vehicle 1000 may refer to one or more suitable apparatuses that move an object to be transported such as a human, an object, or an animal, from a departure point to a destination. The vehicle 1000 may include a vehicle traveling on a road or track, a vessel moving over the sea or river, and/or an airplane flying in the sky utilizing the action of air.

In one and more embodiments, the vehicle 1000 may travel on roads or tracks. The vehicle 1000 may move in a set or predetermined direction according to rotation of at least one wheel. For example, the vehicle 1000 may include a three-wheeled or four-wheeled vehicle, a construction machine, a two-wheeled vehicle, a motorbike, a bicycle, or a train running on a track.

The vehicle 1000 may include a body having an interior and an exterior, and a chassis in which mechanical apparatuses necessary for driving are installed as the remaining parts except for the body. The exterior of the body of the vehicle may include a front panel, a bonnet, a roof panel, a rear panel, a trunk, and a pillar provided at a boundary between doors. The chassis of the vehicle 1000 may include a power generating apparatus, a power transmitting apparatus, a traveling apparatus, a steering apparatus, a braking apparatus, a suspension apparatus, a transmission apparatus, a fuel apparatus, front and rear wheels, left and right wheels, and/or the like.

The vehicle 1000 may include a side window glass 1100, a front window glass 1200, a side mirror 1300, a cluster 1400, a center fascia 1500, a passenger seat dashboard 1600, and a display apparatus 2.

The side window glass 1100 and the front window glass 1200 may be partitioned by a pillar located between the side window glass 1100 and the front window glass 1200.

The side window glass 1100 may be installed on a side of the vehicle 1000. In some embodiments, the side window glass 1100 may be installed on a door of the vehicle 1000. A plurality of side window glasses 1100 may be provided and may face each other. In some embodiments, the side window glass 1100 may include a first side window glass 1110 and a second side window glass 1120. In some embodiments, the first side window glass 1110 may be arranged adjacent to the cluster 1400. In some embodiments, the second side window glass 1120 may be arranged adjacent to the passenger seat dashboard 1600.

In some embodiments, the side window glasses 1100 may be spaced apart from each other in the x direction or the -x direction. For example, the first side window glass 1110 and the second side window glass 1120 may be spaced apart from each other in the x direction or the -x direction. In other words, an imaginary straight line L connecting the side window glasses 1100 may extend in the x direction or the -x direction. For example, the imaginary straight line L connecting the first side window glass 1110 and the second side window glass 1120 to each other may extend in the x direction or the -x direction.

The front window glass 1200 may be installed on a front of the vehicle 1000. The front window glass 1200 may be arranged between the side window glasses 1100 facing each other.

The side mirror 1300 may provide a rear view of the vehicle 1000. The side mirror 1300 may be installed on the exterior of the body of the vehicle. In one embodiment, a plurality of side mirrors 1300 may be provided. Any one of the plurality of side mirrors 1300 may be located outside the first side window glass 1110. Another one of the plurality of side mirrors 1300 may be located outside the second side window glass 1120.

The cluster 1400 may be located in front of the steering wheel. The cluster 1400 may include a tachometer, a speedometer, a coolant thermometer, a fuel gauge turn indicator, a high beam indicator, a warning indicator, a seat belt warning indicator, an odometer, a hodometer, an automatic shift selector indicator, a door open warning indicator, an engine oil warning indicator, and/or a low fuel warning indicator.

The center fascia 1500 may include a control panel on which a plurality of buttons for adjusting an audio apparatus, an air conditioning apparatus, and a heater of seats. The center fascia 1500 may be on one side of the cluster 1400.

The passenger seat dashboard 1600 may be spaced apart from the cluster 1400 with the center fascia 1500 interposed therebetween. In one embodiment, the cluster 1400 may be disposed to correspond to a seat of a driver, and the passenger seat dashboard 1600 may be disposed to correspond to a seat of a passenger. In one embodiment, the cluster 1400 may be adjacent to the first side window glass 1110, and the passenger seat dashboard 1600 may be adjacent to the second side window glass 1120.

In one or more embodiments, the display apparatus 2 may include a display panel 3, and the display panel 3 may display an image. The display apparatus 2 may be inside the vehicle 1000. In some embodiments, the display apparatus 2 may be arranged between the side window glasses 1100 facing each other. The display apparatus 2 may be on at least one selected from among the cluster 1400, the center fascia 1500, and the passenger seat dashboard 1600.

The display apparatus 2 may include an organic light-emitting display apparatus, an inorganic EL display apparatus, a quantum dot display apparatus, and/or the like. Hereinafter, as the display apparatus 2 according to one or more embodiments, an organic light-emitting display apparatus including the light-emitting device according to one or more embodiments of the present disclosure will be described as an example, however, embodiments of the present disclosure may include one or more suitable types (kinds) of the display apparatus.

As shown in FIG. 6A, the display apparatus 2 may be disposed on the center fascia 1500. In one embodiment, the display apparatus 2 may display navigation information. In one embodiment, the display apparatus 2 may display information of audio, video, or vehicle settings.

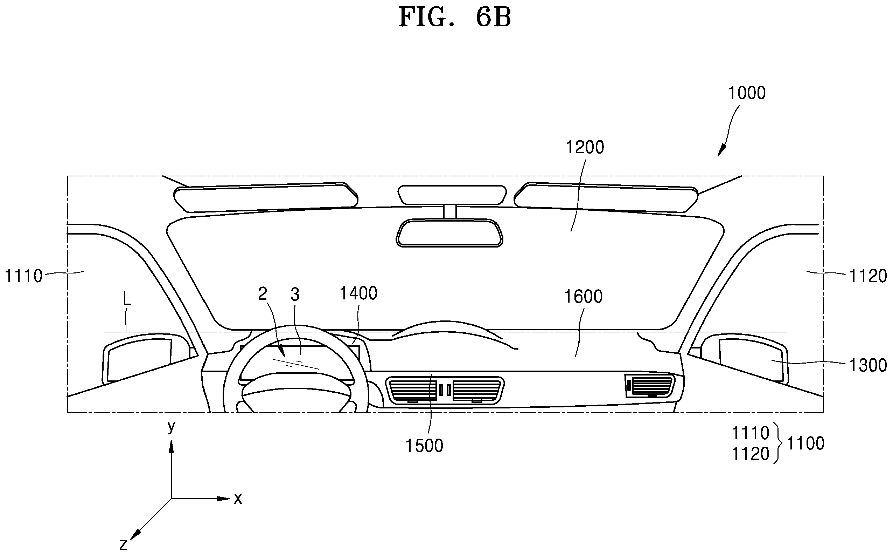

As shown in FIG. 6B, the display apparatus 2 may be disposed on the cluster 1400. In some embodiments, the cluster 1400 may show driving information and/or the like by the display apparatus 2. For example, the cluster 1400 may be implemented digitally. The digital cluster 1400 may display vehicle information and driving information as images. For example, in some embodiments, a needle and a gauge and one or more suitable warning indicators of a tachometer may be displayed by digital signals.

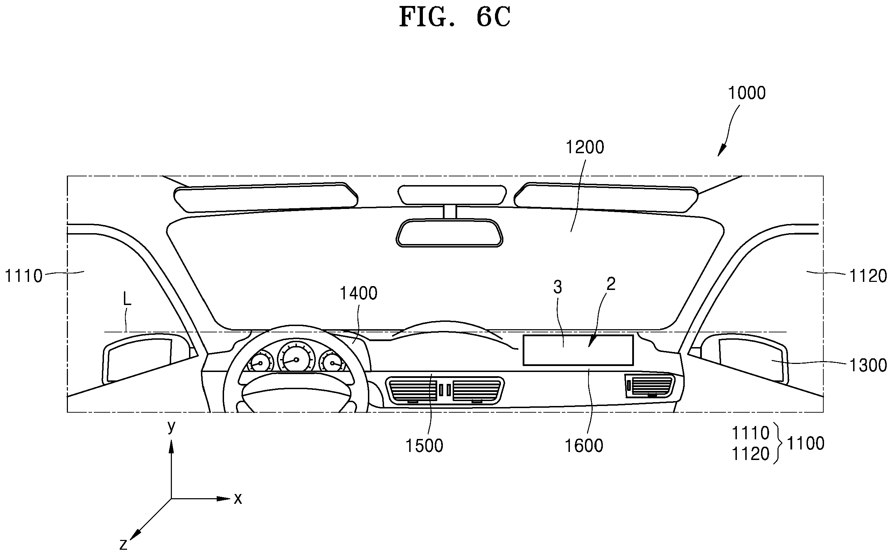

As shown in FIG. 6C, the display apparatus 2 may be disposed on the passenger seat dashboard 1600. The display apparatus 2 may be embedded in the passenger seat dashboard 1600 or located on the passenger seat dashboard 1600. In some embodiments, the display apparatus 2 disposed on the passenger seat dashboard 1600 may display an image related to information displayed on the cluster 1400 and/or information displayed on the center fascia 1500. In some embodiments, the display apparatus 2 disposed on the passenger seat dashboard 1600 may display information different from information displayed on the cluster 1400 and/or information displayed on the center fascia 1500.

### Manufacturing method

The layers constituting the hole transport region, the emission layer, and the layers constituting the electron transport region may be formed in a specific region by utilizing one or more suitable methods such as vacuum deposition, spin coating, casting, Langmuir-Blodgett (LB) deposition, ink-jet printing, laser printing, and laser-induced thermal imaging.

When the layers constituting the hole transport region, the emission layer, and the layers constituting the electron transport region are each formed by vacuum deposition, the vacuum deposition may be performed at a deposition temperature in a range of about 100 °C to about 500 °C at a vacuum degree in a range of about 10⁻⁸ torr to about 10⁻³ torr, and at a deposition rate in a range of about 0.01 Angstroms per second (Å/sec) to about 100 Å/sec, depending on a material to be included in each layer and the structure of each layer to be formed.

### General definitions of terms

The term "C₃-C₆₀ carbocyclic group" as utilized herein refers to a cyclic group including (e.g., consisting of) carbon atoms only and having 3 to 60 carbon atoms as ring-forming atoms. The term "C₁-C₆₀ heterocyclic group" as utilized herein refers to a cyclic group having 1 to 60 carbon atoms in addition to a heteroatom as ring-forming atoms other than carbon atoms. The C₃-C₆₀ carbocyclic group and the C₁-C₆₀ heterocyclic group may each be a monocyclic group including (e.g., consisting of) one ring or a polycyclic group in which at least two rings are condensed. For example, the number of ring-forming atoms in the C₁-C₆₀ heterocyclic group may be in a range of 3 to 61.

The term "cyclic group" as utilized herein may include the C₃-C₆₀ carbocyclic group and the C₁-C₆₀ heterocyclic group.

The term "π electron-rich C₃-C₆₀ cyclic group" as utilized herein refers to a cyclic group having 3 to 60 carbon atoms and not including *-N=*' as a ring-forming moiety. The term "π electron-deficient nitrogen-containing C₁-C₆₀ cyclic group" as utilized herein refers to a heterocyclic group having 1 to 60 carbon atoms and *-N=*' as a ring-forming moiety.

In some embodiments,
the C₃-C₆₀ carbocyclic group may be i) a T1 group or ii) a group in which at least two T1 groups are condensed (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) a T2 group, ii) a group in which at least two T2 groups are condensed, or iii) a group in which at least one T2 group is condensed with at least one T1 group (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
the π electron-rich C₃-C₆₀ cyclic group may be i) a T1 group, ii) a condensed group in which at least two T1 groups are condensed, iii) a T3 group, iv) a condensed group in which at least two T3 groups are condensed, or v) a condensed group in which at least one T3 group is condensed with at least one T1 group (for example, a C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, and/or the like), and
the π electron-deficient nitrogen-containing C₁-C₆₀ cyclic group may be i) a T4 group, ii) a group in which at least two T4 groups are condensed, iii) a group in which at least one T4 group is condensed with at least one T1 group, iv) a group in which at least one T4 group is condensed with at least one T3 group, or v) a group in which at least one T4 group, at least one T1 group, and at least one T3 group are condensed (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
wherein the T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
the T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
the T3 group may be a furan group, a thiophene group, a 1H-pyrrole group, a silole group, or a borole group, and
the T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The term "cyclic group", "C₃-C₆₀ carbocyclic group", "C₁-C₆₀ heterocyclic group", "π electron-rich C₃-C₆₀ cyclic group", or "π electron-deficient nitrogen-containing C₁-C₆₀ cyclic group" as utilized herein may be a group condensed with any suitable cyclic group, a monovalent group, or a polyvalent group (e.g., a divalent group, a trivalent group, a quadrivalent group, and/or the like), depending on the structure of a formula to which the term is applied. For example, a "benzene group" may be a benzo group, a phenyl group, a phenylene group, and/or the like, and this may be understood by one of ordinary skill in the art, depending on the structure of a formula including the "benzene group".

Non-limiting examples of the monovalent C₃-C₆₀ carbocyclic group and the monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Non-limiting examples of the divalent C₃-C₆₀ carbocyclic group and the divalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as utilized herein refers to a linear or branched aliphatic hydrocarbon monovalent group having 1 to 60 carbon atoms, and non-limiting examples thereof may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a *sec*-pentyl group, a 3-pentyl group, a sec-isopentyl group, an n-hexyl group, an isohexyl group, a *sec*-hexyl group, a tert-hexyl group, an n-heptyl group, an isoheptyl group, a *sec*-heptyl group, a tert-heptyl group, an n-octyl group, an isooctyl group, a sec-octyl group, a tert-octyl group, an n-nonyl group, an iso-nonyl group, a sec-nonyl group, a tert-nonyl group, an n-decyl group, an isodecyl group, a sec-decyl group, and a tert-decyl group. The term "C₁-C₆₀ alkylene group" as utilized herein refers to a divalent group having the same structure as the C₁-C₆₀ alkyl group. Corresponding definitions apply to other ranges given for the number of carbon atoms in an alkyl/alkylene group.

The term "C₂-C₆₀ alkenyl group" as utilized herein refers to a hydrocarbon group having at least one carbon-carbon double bond in the middle or at the terminus of the C₂-C₆₀ alkyl group. Non-limiting examples thereof may include an ethenyl group, a propenyl group, and a butenyl group. The term "C₂-C₆₀ alkenylene group" as utilized herein refers to a divalent group having the same structure as the C₂-C₆₀ alkenyl group. Corresponding definitions apply to other ranges given for the number of carbon atoms in an alkenyl/alkenylene group.

The term "C₂-C₆₀ alkynyl group" as utilized herein refers to a monovalent hydrocarbon group having at least one carbon-carbon triple bond in the middle or at the terminus of the C₂-C₆₀ alkyl group. Non-limiting examples thereof may include an ethynyl group and a propynyl group. The term "C₂-C₆₀ alkynylene group" as utilized herein refers to a divalent group having the same structure as the C₂-C₆₀ alkynyl group. Corresponding definitions apply to other ranges given for the number of carbon atoms in an alkynyl/alkynylene group.

The term "C₁-C₆₀ alkoxy group" as utilized herein refers to a monovalent group represented by -OA₁₀₁ (wherein A₁₀₁ is a C₁-C₆₀ alkyl group). Non-limiting examples thereof may include a methoxy group, an ethoxy group, and an isopropyloxy group. Corresponding definitions apply to other ranges given for the number of carbon atoms in an alkoxy group.

The term "C₃-C₁₀ cycloalkyl group" as utilized herein refers to a monovalent saturated hydrocarbon monocyclic group including 3 to 10 carbon atoms. Non-limiting examples of the C₃-C₁₀ cycloalkyl group as utilized herein may include a cyclopropyl group, a cyclobutyl group, a cyclopentyl group, a cyclohexyl group, a cycloheptyl group, a cyclooctyl group, an adamantanyl group, a norbornanyl (bicyclo[2.2.1]heptyl) group, a bicyclo[1.1.1]pentyl group, a bicyclo[2.1.1]hexyl group, and/or a bicyclo[2.2.2]octyl group. The term "C₃-C₁₀ cycloalkylene group" as utilized herein refers to a divalent group having the same structure as the C₃-C₁₀ cycloalkyl group.

The term "C₁-C₁₀ heterocycloalkyl group" as utilized herein refers to a monovalent cyclic group including at least one heteroatom other than carbon atoms as a ring-forming atom and having 1 to 10 carbon atoms. Non-limiting examples thereof may include a 1,2,3,4-oxatriazolidinyl group, a tetrahydrofuranyl group, and a tetrahydrothiophenyl group. The term "C₁-C₁₀ heterocycloalkylene group" as utilized herein refers to a divalent group having the same structure as the C₁-C₁₀ heterocycloalkyl group.

The term "C₃-C₁₀ cycloalkenyl group" as utilized herein refers to a monovalent cyclic group that has 3 to 10 carbon atoms and at least one carbon-carbon double bond in its ring, and is not aromatic. Non-limiting examples thereof may include a cyclopentenyl group, a cyclohexenyl group, and a cycloheptenyl group. The term "C₃-C₁₀ cycloalkenylene group" as utilized herein refers to a divalent group having the same structure as the C₃-C₁₀ cycloalkenyl group.

The term "C₁-C₁₀ heterocycloalkenyl group" as utilized herein refers to a monovalent cyclic group including at least one heteroatom other than carbon atoms as a ring-forming atom, 1 to 10 carbon atoms, and at least one double bond in its ring. Non-limiting examples of the C₁-C₁₀ heterocycloalkenyl group may include a 4,5-dihydro-1,2,3,4-oxatriazolyl group, a 2,3-dihydrofuranyl group, and a 2,3-dihydrothiophenyl group. The term "C₁-C₁₀ heterocycloalkylene group" as utilized herein refers to a divalent group having the same structure as the C₁-C₁₀ heterocycloalkyl group.

The term "C₆-C₆₀ aryl group" as utilized herein refers to a monovalent group having a carbocyclic aromatic system having 6 to 60 carbon atoms. The term "C₆-C₆₀ arylene group" as utilized herein refers to a divalent group having a carbocyclic aromatic system having 6 to 60 carbon atoms. Non-limiting examples of the C₆-C₆₀ aryl group may include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each independently include two or more rings, the respective rings may be fused. Corresponding definitions apply to other ranges given for the number of carbon atoms in an aryl/arylene group.

The term "C₁-C₆₀ heteroaryl group" as utilized herein refers to a monovalent group having a heterocyclic aromatic system further including at least one heteroatom other than carbon atoms as a ring-forming atom and 1 to 60 carbon atoms. The term "C₁-C₆₀ heteroarylene group" as utilized herein refers to a divalent group having a heterocyclic aromatic system further including at least one heteroatom other than carbon atoms as a ring-forming atom and 1 to 60 carbon atoms. Non-limiting examples of the C₁-C₆₀ heteroaryl group may include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each independently include two or more rings, the respective rings may be fused. Corresponding definitions apply to other ranges given for the number of carbon atoms in a heteroaryl/heteroarylene group.

The term "monovalent non-aromatic condensed polycyclic group" as utilized herein refers to a monovalent group that has two or more condensed rings and only carbon atoms (e.g., 8 to 60 carbon atoms) as ring forming atoms, wherein the molecular structure when considered as a whole is non-aromatic. Non-limiting examples of the monovalent non-aromatic condensed polycyclic group may include an indenyl group, a fluorenyl group, a spiro-bifluorenyl group, a benzofluorenyl group, an indenophenanthrenyl group, and an indenoanthracenyl group. The term "polyvalent (e.g., divalent) non-aromatic condensed polycyclic group" as utilized herein respectively refers to a polyvalent (e.g., divalent) group having substantially the same structure as the monovalent non-aromatic condensed polycyclic group.

The term "monovalent non-aromatic condensed heteropolycyclic group" as utilized herein refers to a monovalent group that has two or more condensed rings and at least one heteroatom other than carbon atoms (e.g., 1 to 60 carbon atoms), as a ring-forming atom, wherein the molecular structure when considered as a whole is non-aromatic. Non-limiting examples of the monovalent non-aromatic condensed heteropolycyclic group may include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzooxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "polyvalent (e.g., divalent) non-aromatic condensed heteropolycyclic group" as utilized herein respectively refers to a polyvalent (e.g., divalent) group having substantially the same structure as the monovalent non-aromatic condensed heteropolycyclic group.

The term "C₆-C₆₀ aryloxy group" as utilized herein refers to -OA₁₀₂ (wherein A₁₀₂ is a C₆-C₆₀ aryl group), and a C₆-C₆₀ arylthio group as utilized herein refers to - SA₁₀₃ (wherein A₁₀₃ is a C₆-C₆₀ aryl group). Corresponding definitions apply to other ranges given for the number of carbon atoms in an aryloxy group and an arylthio group.

The term "C₇-C₆₀ aryl alkyl group" utilized herein refers to -A₁₀₄A₁₀₅ (where A₁₀₄ may be a C₁-C₅₄ alkylene group, and A₁₀₅ may be a C₆-C₅₉ aryl group), and the term "C₂-C₆₀ heteroaryl alkyl group" utilized herein refers to -A₁₀₆A₁₀₇ (where A₁₀₆ may be a C₁-C₅₉ alkylene group, and A₁₀₇ may be a C₁-C₅₉ heteroaryl group).

The term "R₁₀ₐ" as utilized herein may be:
deuterium, -F, -Cl, -Br, -I, a hydroxyl group, a cyano group, or a nitro group;
a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, or a C₁-C₆₀ (e.g. C₁-C₂₀) alkoxy group, each unsubstituted or substituted with deuterium, -F, -Cl, -Br, -I, a hydroxyl group, a cyano group, a nitro group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ aryl alkyl group, a C₂-C₆₀ (e.g. C₂-C₂₀) heteroaryl alkyl group, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), or any combination thereof;
a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) aryl alkyl group, or a C₂-C₆₀ (e.g. C₂-C₂₀) heteroaryl alkyl group, each unsubstituted or substituted with deuterium, -F, -Cl, -Br, -I, a hydroxyl group, a cyano group, a nitro group, a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, a C₁-C₆₀ (e.g. C₁-C₂₀) alkoxy group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) aryl alkyl group, a C₂-C₆₀ (e.g. C₂-C₂₀) heteroaryl alkyl group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
Q₁ to Q₃, Q₁₁ to Q₁₃, Q₂₁ to Q₂₃ and Q₃₁ to Q₃₃ may each independently be: hydrogen; deuterium; -F; -Cl; -Br; -I; a hydroxyl group; a cyano group; a nitro group; a C₁-C₆₀ (e.g. C₁-C₂₀) alkyl group; a C₂-C₆₀ (e.g. C₂-C₂₀) alkenyl group; a C₂-C₆₀ (e.g. C₂-C₂₀) alkynyl group; a C₁-C₆₀ (e.g. C₁-C₂₀) alkoxy group; a C₃-C₆₀ (e.g. C₃-C₃₀) carbocyclic group or a C₁-C₆₀ (e.g. C₁-C₂₀) heterocyclic group, each unsubstituted or substituted with deuterium, -F, a cyano group, a C₁-C₆₀ (e.g. C₁-C₂₀) alkyl group, a C₁-C₆₀ (e.g. C₁-C₂₀) alkoxy group, a phenyl group, a biphenyl group, or any combination thereof; a C₇-C₆₀ (e.g. C₇-C₃₀) aryl alkyl group; or a C₂-C₆₀ (e.g. C₂-C₂₀) heteroaryl alkyl group.

The term "heteroatom" as utilized herein refers to any atom other than a carbon atom. Non-limiting examples of the heteroatom may include O, S, N, P, Si, B, Ge, Se, or any combination thereof.

A third-row transition metal as utilized herein may include hafnium (Hf), tantalum (Ta), tungsten (W), rhenium (Re), osmium (Os), iridium (Ir), platinum (Pt), and gold (Au).

The term "Ph" as utilized herein refers to a phenyl group. The term "Me" as utilized herein refers to a methyl group. The term "Et" as utilized herein refers to an ethyl group. The term "tert-Bu" or "Bu^{t}" as utilized herein refers to a tert-butyl group. The term "OMe" as utilized herein refers to a methoxy group.

The term "biphenyl group" as utilized herein refers to a phenyl group substituted with a phenyl group. The "biphenyl group" may be a substituted phenyl group having a C₆-C₆₀ aryl group as a substituent.

The term "terphenyl group" as utilized herein refers to a phenyl group substituted with a biphenyl group. The "terphenyl group" may be a substituted phenyl group having a C₆-C₆₀ aryl group substituted with a C₆-C₆₀ aryl group as a substituent.

The symbols * and *' as utilized herein, unless defined otherwise, refer to a binding site to an adjacent atom in a corresponding formula or moiety.

In the present disclosure, the x-axis, y-axis, and z-axis are not limited to three axes on the orthogonal coordinates system, and may be interpreted in a broad sense including the orthogonal coordinates system. For example, the x-axis, y-axis, and z-axis may be orthogonal to each other, but the x-axis, y-axis, and z-axis may also refer to different directions that are not orthogonal to each other.

Hereinafter, compounds and a light-emitting device according to one or more embodiments will be described in more detail with reference to Synthesis Examples and Examples. The wording "B was utilized instead of A" utilized in describing Synthesis Examples refers to that an identical number of molar equivalents of B was utilized in place of A.

### Examples

A condensed cyclic compound according to one or more embodiments may be synthesized as follows, for example. However, the synthesis method of the condensed cyclic compound according to one or more embodiments is not limited thereto.

### Synthesis Example 1. Synthesis of Compound 1

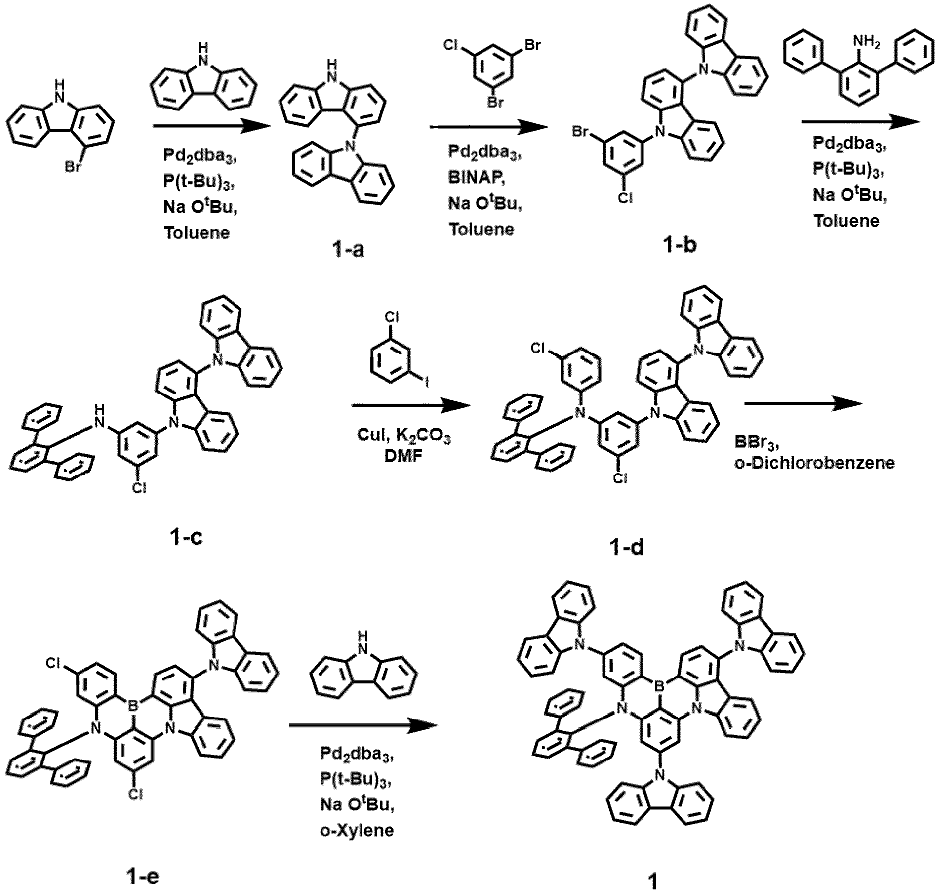

### Synthesis of Intermediate Compound 1-a

Compound 4-bromo-9H-carbazole (1 eq), 9H-carbazole (2 eq), Pd₂dba₃ (0.05 eq), tris-tert-butyl phosphine (0.1 eq), and sodium tert-butoxide (3 eq) were added to a 1 L-flask in an argon atmosphere and dissolved in toluene, and the reaction solution was stirred at a temperature of 110 °C for 12 hours. After cooling, water and ethyl acetate were added thereto to extract an organic layer. The organic layer was dried utilizing MgSO₄ and filtered. The solvents were removed from the filtered solution under reduced pressure, and the obtained residue was subjected to column chromatography utilizing silica gel with a developing solvent of CH₂Cl₂ and hexane for separation and purification, thereby obtaining Intermediate Compound 1-a (yield: 50 %). The thus obtained compound was identified as Intermediate Compound 1-a through ESI-LCMS.
ESI-LCMS: [M]⁺: C₂₄H₁₆N₂. 332.1313

### Synthesis of Intermediate Compound 1-b

Intermediate Compound 1-a (1 eq), 1,3-dibromo-5-chlorobenzene (2 eq), Pd₂dba₃ (0.05 eq), 2,2'-bis(diphenylphosphino)-1,1'-binaphthyl (BINAP) (0.1 eq), and sodium tert-butoxide (3 eq) were added to a 1 L-flask in an argon atmosphere and dissolved in toluene, and the reaction solution was stirred at a temperature of 110 °C for 12 hours. After cooling, water and ethyl acetate were added thereto to extract an organic layer. The organic layer was dried utilizing MgSO₄ and filtered. The solvents were removed from the filtered solution under reduced pressure, and the obtained residue was subjected to column chromatography utilizing silica gel with a developing solvent of CH₂Cl₂ and hexane for separation and purification, thereby obtaining Intermediate Compound 1-b (yield: 71 %). The thus obtained compound was identified as Intermediate Compound 1-b through ESI-LCMS.
ESI-LCMS: [M]⁺: C₃₀H₁₈BrClN₂. 520.0340

### Synthesis of Intermediate Compound 1-c

Intermediate Compound 1-b (1 eq), [1,1':3',1"-terphenyl]-2'-amine (1 eq), Pd₂dba₃ (0.05 eq), tris-tert-butyl phosphine (0.1 eq), and sodium tert-butoxide (3 eq) were added to a 1 L-flask in an argon atmosphere and dissolved in toluene, and the reaction solution was stirred at a temperature of 110 °C for 12 hours. After cooling, water and ethyl acetate were added thereto to extract an organic layer. The organic layer was dried utilizing MgSO₄ and filtered. The solvents were removed from the filtered solution under reduced pressure, and the obtained residue was subjected to column chromatography utilizing silica gel with a developing solvent of CH₂Cl₂ and hexane for separation and purification, thereby obtaining Intermediate Compound 1-c (yield: 68 %). The thus obtained compound was identified as Intermediate Compound 1-c through ESI-LCMS.
ESI-LCMS: [M]⁺: C₄₈H₃₂ClN₃. 685.2283

### Synthesis of Intermediate Compound 1-d

Intermediate Compound 1-c (1 eq), 1-chloro-3-iodobenzene (1.5 eq), copper iodide (1 eq), 1,10-phenanthroline (1 eq), and potassium carbonate (3 eq) were added to a 1 L-flask in an argon atmosphere and dissolved in dimethylformamide (DMF), and the reaction solution was stirred at a temperature of 160 °C for 12 hours. After cooling, water and ethyl acetate were added thereto to extract an organic layer. The organic layer was dried utilizing MgSO₄ and filtered. The solvents were removed from the filtered solution under reduced pressure, and the obtained residue was subjected to column chromatography utilizing silica gel with a developing solvent of CH₂Cl₂ and hexane for separation and purification, thereby obtaining Intermediate Compound 1-d (5.4 g, yield: 42 %). The thus obtained compound was identified as Intermediate Compound 1-d through ESI-LCMS.
ESI-LCMS: [M]⁺: C₃₄H₃₃Cl₂N₃. 795.2203

### Synthesis of Intermediate Compound 1-e

In an argon atmosphere, Intermediate Compound 1-d (1 eq) was added to a 500 mL-flask and dissolved in o-dichlorobenzene, followed by cooling with water-ice. Then, BBr₃ (5 eq.) was slowly added dropwise thereto, and the reaction solution was stirred at a temperature of 180 °C for 12 hours. After cooling, triethylamine (5 eq.) was added thereto to complete the reaction. Then, an organic layer was extracted by utilizing water/CH₂Cl₂, dried utilizing MgSO₄, and filtered. The solvents were removed from the filtered solution under reduced pressure, and the obtained residue was subjected to column chromatography utilizing silica gel with a developing solvent of CH₂Cl₂ and hexane for separation and purification, thereby obtaining Intermediate Compound 1-e (yellow solid, yield: 11 %). The thus obtained compound was identified as Intermediate Compound 1-e through ESI-LCMS.
ESI-LCMS: [M]⁺: C₃₄H₃₂BCl₂N₃. 803.2061

### Synthesis of Compound 1

Compound 1-e (1 eq), 9H-carbazole (2 eq), Pd₂dba₃ (0.05 eq), tris-tert-butyl phosphine (0.1 eq), and sodium tert-butoxide (3 eq) were added to a 1 L-flask in an argon atmosphere and dissolved in o-xylene, and the reaction solution was stirred at a temperature of 140 °C for 12 hours. After cooling, water and ethyl acetate were added thereto to extract an organic layer. The organic layer was dried utilizing MgSO₄ and filtered. The solvents were removed from the filtered solution under reduced pressure, and the obtained residue was subjected to column chromatography utilizing silica gel with a developing solvent of CH₂Cl₂ and hexane for separation and purification, thereby obtaining Compound 1 (yield: 68 %). The thus obtained compound was identified as Compound 1 through ESI-LCMS.
¹H-NMR (400 MHz, CDCl₃): d = 9.32 (s, 1H), 9.28 (s, 1H), 8.98 (s, 1H), 8.93 (s, 1H), 8.35 -8.20(m, 4H), 8.13-8.04 (m, 4H), 7.91-7.78 (m, 6H), 7.73-7.62 (m, 5H), 7.58-7.43 (m, 4H), 7.40-7.28 (m, 4H), 7.43-7.24 (m, 8H), 7.20-7.05 (m, 6H), 7.03-6.95 (m, 3H)
ESI-LCMS: [M]⁺: C₇₈H₄₈BN₅. 1065.4001

### Synthesis Example 2. Synthesis of Compound 17

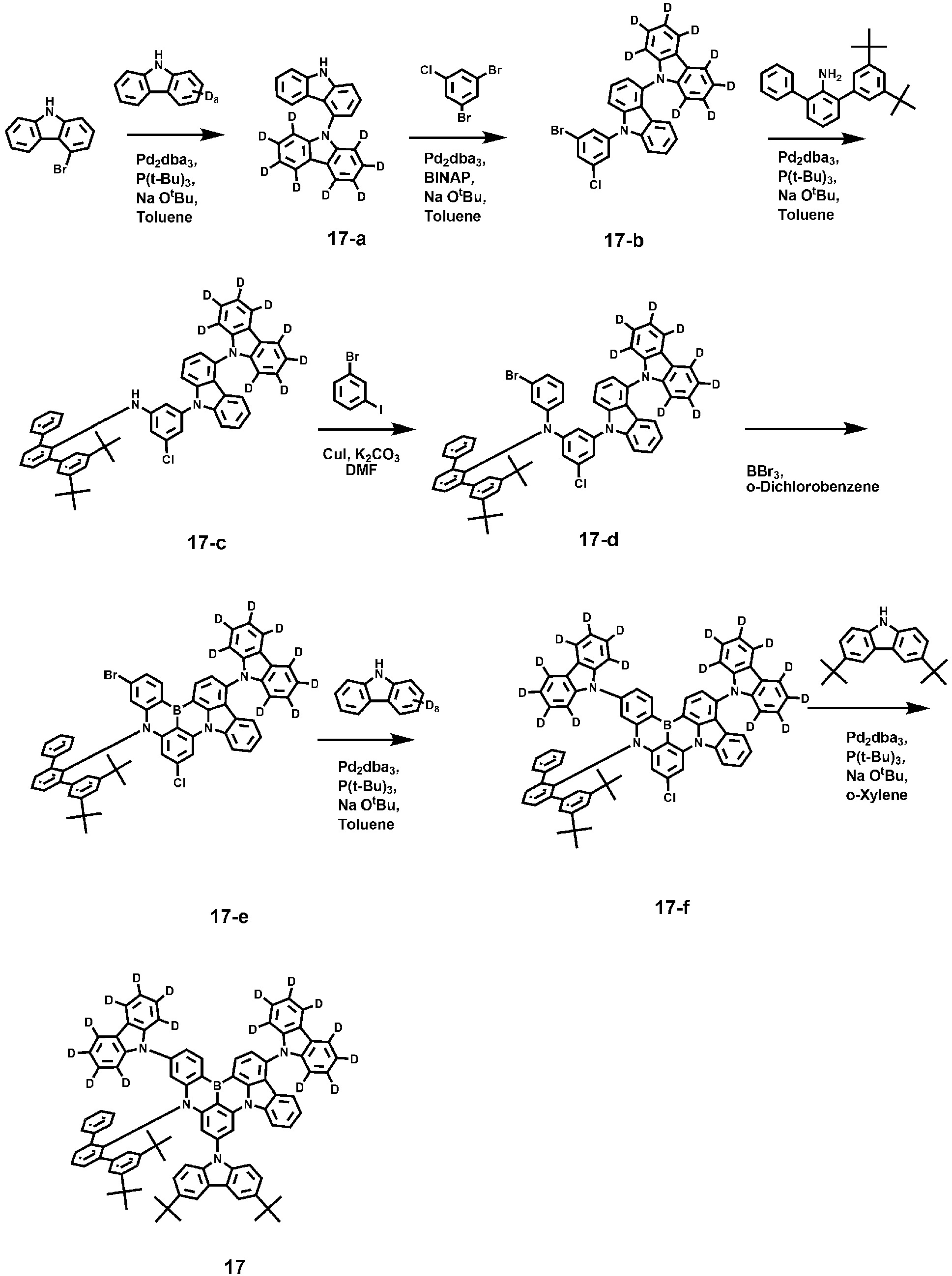

### Synthesis of Intermediate Compound 17-a

Intermediate Compound 17-a was synthesized in substantially the same manner as in Synthesis of Intermediate Compound 1-a, except that 9H-carbazole-1,2,3,4,5,6,7,8-d8 was utilized instead of 9H-carbazole (yield: 54 %). The thus obtained solid was identified as Intermediate Compound 17-a through ESI-LCMS.

ESI-LCMS: [M]⁺: C₂₄H₈D₈N₂. 340.1816.

### Synthesis of Intermediate Compound 17-b

Intermediate Compound 17-b was synthesized in substantially the same manner as in Synthesis of Intermediate Compound 1-b, except that Intermediate Compound 17-a was utilized instead of Intermediate Compound 1-a (yield: 62 %). The thus obtained solid was identified as Intermediate Compound 17-b through ESI-LCMS.

ESI-LCMS: [M]⁺: C₃₀H₁₀D₈BrClN₂. 528.0844.

### Synthesis of Intermediate Compound 17-c

Intermediate Compound 17-c was synthesized in substantially the same manner as in Synthesis of Intermediate Compound 1-c, except that Intermediate Compound 17-b was utilized instead of Intermediate Compound 1-b, and 3,5-di-tert-butyl-[1,1':3',1"-terphenyl]-2'-amine was utilized instead of [1,1':3',1"-terphenyl]-2'-amine (yield: 68 %). The thus obtained solid was identified as Intermediate Compound 17-c through ESI-LCMS.

ESI-LCMS: [M]⁺: C₅₆H₄₀D₈ClN₃. 805.4038.

### Synthesis of Intermediate Compound 17-d

Intermediate Compound 17-d was synthesized in substantially the same manner as in Synthesis of Intermediate Compound 1-d, except that Intermediate Compound 17-c was utilized instead of Intermediate Compound 1-c, and 1-bromo-3-iodobenzene was utilized instead of 1-chloro-3-iodobenzene (yield: 41 %). The thus obtained solid was identified as Intermediate Compound 17-d through ESI-LCMS.

ESI-LCMS: [M]⁺: C₆₂H₄₃D₈BrClN₃. 959.3457.

### Synthesis of Intermediate Compound 17-e

Intermediate Compound 17-e was synthesized in substantially the same manner as in Synthesis of Intermediate Compound 1-e, except that Intermediate Compound 17-d was utilized instead of Intermediate Compound 1-d (yellow solid, yield: 12 %). The thus obtained solid was identified as Intermediate Compound 17-e through ESI-LCMS.

ESI-LCMS: [M]⁺: C₆₂H₄₀D₈BBrClN₃. 967.3415.

### Synthesis of Intermediate Compound 17-f

Intermediate Compound 17-f was synthesized in substantially the same manner as in Synthesis of Intermediate Compound 1-c, except that Intermediate Compound 17-e was utilized instead of Intermediate Compound 1-b, and 9H-carbazole-1,2,3,4,5,6,7,8-d8 was utilized instead of [1,1':3',1"-terphenyl]-2'-amine (yield: 72 %). The thus obtained solid was identified as Intermediate Compound 17-f through ESI-LCMS.

ESI-LCMS: [M]⁺: C₇₄H₄₀D₁₆BClN₄. 1062.5291.

### Synthesis of Compound 17

Compound 17 was synthesized in substantially the same manner as in Synthesis of Compound 1, except that Intermediate Compound 17-f was utilized instead of Intermediate Compound 1-e, and 3,6-di-tert-butyl-9H-carbazole was utilized instead of 9H-carbazole (yellow solid, yield: 65 %). The thus obtained yellow solid was identified as Compound 17 through ¹H-NMR and ESI-LCMS.

¹H-NMR (400 MHz, CDCl₃): d = 9.35 (s, 1H), 9.31 (s, 1H), 8.02-7.90 (m, 6H), 7.85-7.72 (m, 5H) 7.58-7.48 (m, 4H), 7.42-7.31 (m, 4H), 7.28-7.23 (m, 3H), 7.03-6.95 (m, 4H), 1.43 (s, 18H), 1.32 (s, 18H).

ESI-LCMS: [M]⁺: C₉₄H₆₄D₁₆BN₅. 1305.7511.

### Synthesis Example 3. Synthesis of Compound 23

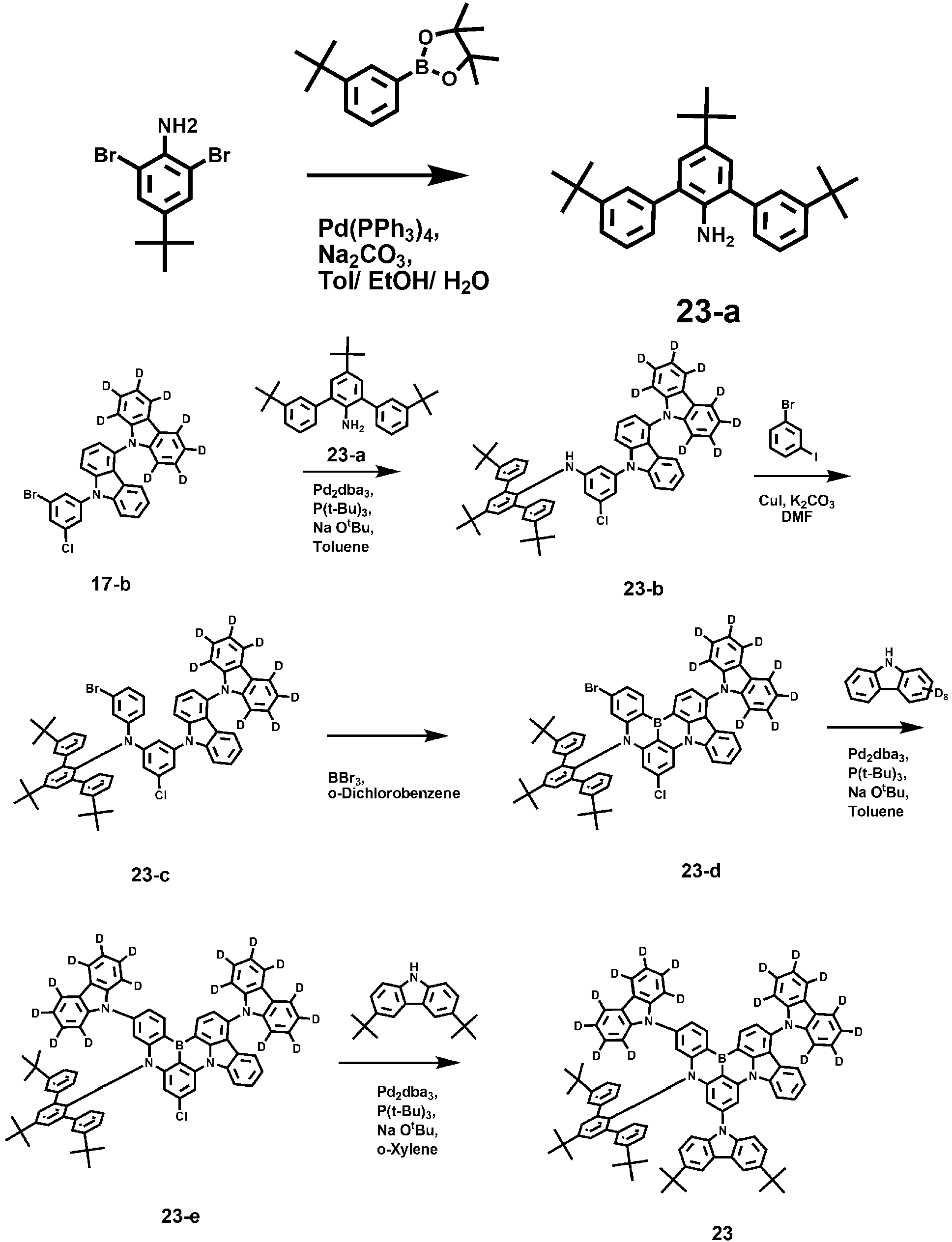

### Synthesis of Intermediate Compound 23-a

2,6-dibromo-4-(tert-butyl)aniline (1 eq), 2-(3-(tert-butyl)phenyl)-4,4,5,5-tetramethyl-1,3,2-dioxaborolane (2.5 eq), Pd(PPh₃)₄ (0.03 eq), and sodium bicarbonate (3 eq) were added to a 2 L-flask in an argon atmosphere and dissolved in toluene:ethyl alcohol:H₂O (4:1:2), and then, the reaction solution was stirred at a temperature of 100 °C for 12 hours. After cooling, water (1 L) and ethyl acetate (300 mL) were added thereto to extract an organic layer. The organic layer was dried utilizing MgSO₄ and filtered. The solvents were removed from the filtered solution under reduced pressure, and the obtained residue was subjected to column chromatography utilizing silica gel with a developing solvent of CH₂Cl₂ and hexane for separation and purification, thereby obtaining Intermediate Compound 23-a (yield: 85 %). The thus obtained compound was identified as Intermediate Compound 23-a through ESI-LCMS.
ESI-LCMS: [M]⁺: C₃₀H₃₉N. 413.3085

### Synthesis of Intermediate Compound 23-b

Intermediate Compound 23-b was synthesized in substantially the same manner as in Synthesis of Intermediate Compound 1-c, except that Intermediate Compound 17-b was utilized instead of Intermediate Compound 1-b, and Intermediate Compound 23-a was utilized instead of [1,1':3',1"-terphenyl]-2'-amine (yield: 62 %). The thus obtained solid was identified as Intermediate Compound 23-b through ESI-LCMS.
ESI-LCMS: [M]⁺: C₆₀H₄₈D₈ClN₃. 861.4661

### Synthesis of Intermediate Compound 23-c

Intermediate Compound 23-c was synthesized in substantially the same manner as in Synthesis of Intermediate Compound 1-d, except that Intermediate Compound 23-b was utilized instead of Intermediate Compound 1-c, and 1-bromo-3-iodobenzene was utilized instead of 1-chloro-3-iodobenzene (yield: 42 %). The thus obtained solid was identified as Intermediate Compound 23-c through ESI-LCMS.

ESI-LCMS: [M]⁺: C₆₆H₅₁D₈BrClN₃. 1016.4084.

### Synthesis of Intermediate Compound 23-d

Intermediate Compound 23-d was synthesized in substantially the same manner as in Synthesis of Intermediate Compound 1-e, except that Intermediate Compound 23-c was utilized instead of Intermediate Compound 1-d (yellow solid, yield: 15 %). The thus obtained solid was identified as Intermediate Compound 23-d through ESI-LCMS.
ESI-LCMS: [M]⁺: C₆₆H₄₈D₈BBrClN₃. 1024.3940

### Synthesis of Intermediate Compound 23-e

Intermediate Compound 23-e was synthesized in substantially the same manner as in Synthesis of Intermediate Compound 1-c, except that Intermediate Compound 23-d was utilized instead of Intermediate Compound 1-b, and 9H-carbazole-1,2,3,4,5,6,7,8-d8 was utilized instead of [1,1':3',1"-terphenyl]-2'-amine (yield: 68 %). The thus obtained solid was identified as Intermediate Compound 23-e through ESI-LCMS.

ESI-LCMS: [M]⁺: C₇₈H₄₈D₁₆BClN₄. 1118.5971.

### Synthesis of Compound 23

Compound 23 was synthesized in substantially the same manner as in Synthesis of Compound 1, except that Intermediate Compound 23-e was utilized instead of Intermediate Compound 1-e, and 3,6-di-tert-butyl-9H-carbazole was utilized instead of 9H-carbazole (yellow solid, yield: 71 %) The thus obtained yellow solid was identified as Compound 23 through ¹H-NMR and ESI-LCMS.

¹H-NMR (400 MHz, CDCl₃): d = 9.10 (s, 1H), 9.02 (s, 1H), 8.51-8.42 (m, 2H), 8.10-7.98 (m, 4H), 7.92-7.68 (m, 7H) 7.59-7.52 (m, 2H), 7.48-7.31 (m, 6H), 7.28-7.23 (m, 4H), 1.43 (s, 18H), 1.32 (s, 18H), 1.09 (s, 9H).
ESI-LCMS: [M]⁺: C₉₈H₇₂D₁₆BN₅. 1361.8137

### Synthesis Example 4. Synthesis of Compound 26

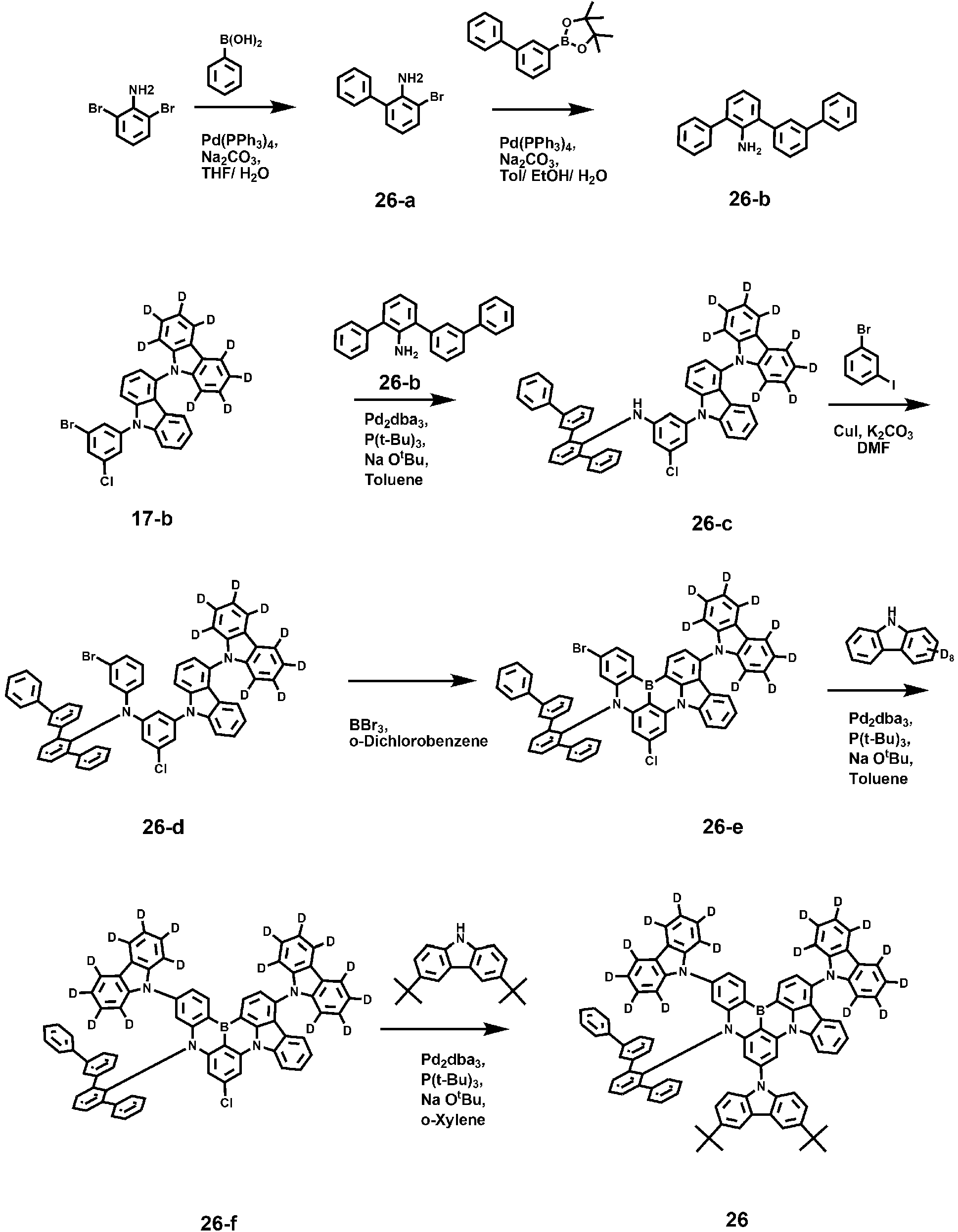

### Synthesis of Intermediate Compound 26-a

2,6-dibromoaniline (1.5 eq), phenyl boronic acid (1 eq), Pd(PPh₃)₄ (0.03 eq), and sodium carbonate (3 eq) were added to a 2 L-flask in an argon atmosphere and dissolved in tetrahydrofuran (THF):H₂O (3:1), and then, the reaction solution was stirred at a temperature of 80 °C for 12 hours. After cooling, water (1 L) and ethyl acetate (300 mL) were added thereto to extract an organic layer. The organic layer was dried utilizing MgSO₄ and filtered. The solvents were removed from the filtered solution under reduced pressure, and the obtained residue was subjected to column chromatography utilizing silica gel with a developing solvent of CH₂Cl₂ and hexane for separation and purification, thereby obtaining Intermediate Compound 26-a (yield: 53 %). The thus obtained compound was identified as Intermediate Compound 26-a through ESI-LCMS.
ESI-LCMS: [M]⁺: C₁₂H₁₀BrN. 246.9997

### Synthesis of Intermediate Compound 26-b

Intermediate Compound 26-b was synthesized in substantially the same manner as in Synthesis of Intermediate Compound 23-a, except that Intermediate Compound 26-a was utilized instead of 2,6-dibromo-4-(tert-butyl)aniline, and 2-([1,1'-biphenyl]-3-yl)-4,4,5,5-tetramethyl-1,3,2-dioxaborolane was utilized instead of 2-(3-(tert-butyl)phenyl)-4,4,5,5-tetramethyl-1,3,2-dioxaborolane (yield: 67 %). The thus obtained solid was identified as Intermediate Compound 26-b through ESI-LCMS.

ESI-LCMS: [M]⁺: C₂₄H₁₉N. 321.1517.

### Synthesis of Intermediate Compound 26-c

Intermediate Compound 26-c was synthesized in substantially the same manner as in Synthesis of Intermediate Compound 1-c, except that Intermediate Compound 17-b was utilized instead of Intermediate Compound 1-b, and Intermediate Compound 26-b was utilized instead of [1,1':3',1"-terphenyl]-2'-amine (yield: 71 %). The thus obtained solid was identified as Intermediate Compound 26-c through ESI-LCMS.
ESI-LCMS: [M]⁺: C₅₄H₂₈D₈ClN₃. 769.3100

### Synthesis of Intermediate Compound 26-d

Intermediate Compound 26-d was synthesized in substantially the same manner as in Synthesis of Intermediate Compound 1-d, except that Intermediate Compound 26-c was utilized instead of Intermediate Compound 1-c, and 1-bromo-3-iodobenzene was utilized instead of 1-chloro-3-iodobenzene (yield: 48 %). The thus obtained solid was identified as Intermediate Compound 26-d through ESI-LCMS.

ESI-LCMS: [M]⁺: C₆₀H₃₁D₈BrClN₃. 923.2518.

### Synthesis of Intermediate Compound 26-e

Intermediate Compound 26-e was synthesized in substantially the same manner as in Synthesis of Intermediate Compound 1-e, except that Intermediate Compound 26-d was utilized instead of Intermediate Compound 1-d (yellow solid, yield: 12 %). The thus obtained solid was identified as Intermediate Compound 26-e through ESI-LCMS.

ESI-LCMS: [M]⁺: C₆₀H₂₈D₈BBrClN₃. 931.2380.

### Synthesis of Intermediate Compound 26-f

Intermediate Compound 26-f was synthesized in substantially the same manner as in Synthesis of Intermediate Compound 23-e, except that Intermediate Compound 26-e was utilized instead of Intermediate Compound 23-d (yield: 65 %). The thus obtained solid was identified as Intermediate Compound 26-f through ESI-LCMS.

ESI-LCMS: [M]⁺: C₇₂H₂₈D₁₆BClN₄. 1026.4350.

### Synthesis of Compound 26

Compound 26 was synthesized in substantially the same manner as in Synthesis of Compound 1, except that Intermediate Compound 26-f was utilized instead of Intermediate Compound 1-e, and 3,6-di-tert-butyl-9H-carbazole was utilized instead of 9H-carbazole (yellow solid, yield: 62 %). The thus obtained yellow solid was identified as Compound 26 through ¹H-NMR and ESI-LCMS.
¹H-NMR (400 MHz, CDCl₃): d = 9.09 (s, 1H), 9.01 (s, 1H), 8.52-8.44 (m, 2H), 8.08-7.98 (m, 4H), 7.94-7.77 (m, 7H) 7.63-7.59 (m, 2H), 7.51-7.33 (m, 13H), 7.27-7.21 (m, 4H), 1.43 (s, 18H)
ESI-LCMS: [M]⁺: C₉₂H₅₂D₁₆BN₅. 1269.6572

### Synthesis Example 5. Synthesis of Compound 41

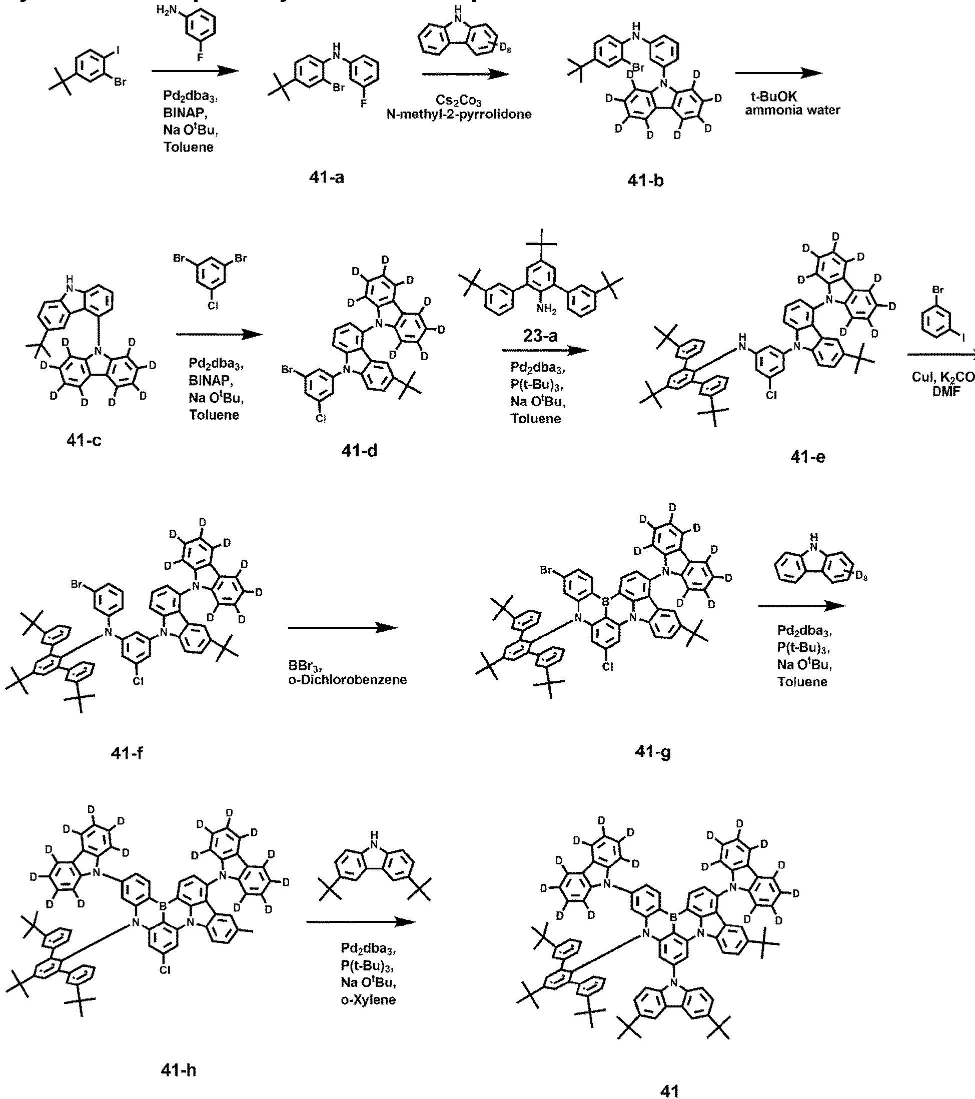

### Synthesis of Intermediate Compound 41-a

Compound 2-bromo-4-(tert-butyl)-1-iodobenzene (2 eq), 3-fluoroaniline (1.2 eq), Pd₂dba₃ (0.05 eq), BINAP (0.1 eq), and sodium tert-butoxide (3 eq) were added to a 1 L-flask in an argon atmosphere and dissolved in toluene, and the reaction solution was stirred at a temperature of 85 °C for 12 hours. After cooling, water and ethyl acetate were added thereto to extract an organic layer. The organic layer was dried utilizing MgSO₄ and filtered. The solvents were removed from the filtered solution under reduced pressure, and the obtained residue was subjected to column chromatography utilizing silica gel with a developing solvent of CH₂Cl₂ and hexane for separation and purification, thereby obtaining Intermediate Compound 41-a (yield: 58 %). The thus obtained compound was identified as Intermediate Compound 41-a through ESI-LCMS.

ESI-LCMS: [M]⁺: C₁₆H₁₇BrFN. 321.0528.

### Synthesis of Intermediate Compound 41-b

Intermediate Compound 41-a (1 eq), 9H-carbazole-1,2,3,4,5,6,7,8-d8 (1.3 eq), and cesium carbonate (2.5 eq) were added to a 1 L-flask in an argon atmosphere and dissolved in N-methyl-2-pyrrolidone, and then, the reaction solution was stirred at a temperature of 160 °C for 12 hours. After cooling, water and ethyl acetate were added thereto to extract an organic layer. The organic layer was dried utilizing MgSO₄ and filtered. The solvents were removed from the filtered solution under reduced pressure, and the obtained residue was subjected to column chromatography utilizing silica gel with a developing solvent of CH₂Cl₂ and hexane for separation and purification, thereby obtaining Intermediate Compound 41-b (yield: 58 %). The thus obtained compound was identified as Intermediate Compound 41-b through ESI-LCMS.

ESI-LCMS: [M]⁺: C₂₈H₁₇D₈BrN₂. 476.1703.

### Synthesis of Intermediate Compound 41-c

Intermediate Compound 41-b (1 eq) and potassium tert-butoxide (2 eq) were added to a 1 L-flask in an argon atmosphere and dissolved in ammonia water, and then, the reaction solution was stirred at room temperature for 4 hours. Water and ethyl acetate were added thereto to extract an organic layer. The organic layer was dried utilizing MgSO₄ and filtered. The solvents were removed from the filtered solution under reduced pressure, and the obtained residue was subjected to column chromatography utilizing silica gel with a developing solvent of CH₂Cl₂ and hexane for separation and purification, thereby obtaining Intermediate Compound 41-c (yield: 63 %). The thus obtained compound was identified as Intermediate Compound 41-c through ESI-LCMS.

ESI-LCMS: [M]⁺: C₂₈H₁₆D₈N₂. 396.2442.

### Synthesis of Intermediate Compound 41-d

Intermediate Compound 41-d was synthesized in substantially the same manner as in Synthesis of Intermediate Compound 1-b, except that Intermediate 41-c was utilized instead of Intermediate Compound 1-a (yield: 58 %). The thus obtained solid was identified as Intermediate Compound 41-d through ESI-LCMS.

ESI-LCMS: [M]⁺: C₃₄H₁₈D₈BrClN₂. 584.1470.

### Synthesis of Intermediate Compound 41-e

Intermediate Compound 41-e was synthesized in substantially the same manner as in Synthesis of Intermediate Compound 1-c, except that Intermediate Compound 41-d was utilized instead of Intermediate Compound 1-b, and Intermediate Compound 23-a was utilized instead of [1,1':3',1"-terphenyl]-2'-amine (yield: 68 %). The thus obtained solid was identified as Intermediate Compound 41-e through ESI-LCMS.

ESI-LCMS: [M]⁺: C₆₄H₅₆D₈ClN₃. 917.5290.

### Synthesis of Intermediate Compound 41-f

Intermediate Compound 41-f was synthesized in substantially the same manner as in Synthesis of Intermediate Compound 1-d, except that Intermediate Compound 41-e was utilized instead of Intermediate Compound 1-c, and 1-bromo-3-iodobenzene was utilized instead of 1-chloro-3-iodobenzene (yield: 51 %). The thus obtained solid was identified as Intermediate Compound 41-f through ESI-LCMS.

ESI-LCMS: [M]⁺: C₇₀H₅₉D₈BrClN₃. 1072.4708.

### Synthesis of Intermediate Compound 41-g

Intermediate Compound 41-g was synthesized in substantially the same manner as in Synthesis of Intermediate Compound 1-e, except that Intermediate Compound 41-f was utilized instead of Intermediate Compound 1-d (yellow solid, yield: 10 %). The thus obtained solid was identified as Intermediate Compound 41-g through ESI-LCMS.

ESI-LCMS: [M]⁺: C₇₀H₅₆D₈BBrClN₃. 1079.4567.

### Synthesis of Intermediate Compound 41-h

Intermediate Compound 41-h was synthesized in substantially the same manner as in Synthesis of Intermediate Compound 23-e, except that Intermediate Compound 41-g was utilized instead of Intermediate Compound 23-d (yield: 71 %). The thus obtained solid was identified as Intermediate Compound 41-h through ESI-LCMS.

ESI-LCMS: [M]⁺: C₈₂H₅₆D₁₆BClN₄. 1132.6073.

### Synthesis of Compound 41

Compound 41 was synthesized in substantially the same manner as in Synthesis of Compound 1, except that Intermediate Compound 41-h was utilized instead of Intermediate Compound 1-e, and 3,6-di-tert-butyl-9H-carbazole was utilized instead of 9H-carbazole (yellow solid, yield: 72 %). The thus obtained yellow solid was identified as Compound 41 through ¹H-NMR and ESI-LCMS.

¹H-NMR (400 MHz, CDCl₃): d = 8.98 (s, 1H), 8.94 (s, 1H), 8.50-8.46 (m, 2H), 8.23-8.01 (m, 4H), 7.94-7.80 (m, 6H) 7.60-7.55 (m, 2H), 7.51-7.37 (m, 6H), 7.25-7.19 (m, 4H), 1.43 (s, 18H), 1.31 (s, 18H), 1.21 (s, 9H) 1.09 (s, 9H).
ESI-LCMS: [M]⁺: C₁₀₂H₈₀D₁₆BN₅. 1417.8763.

### Synthesis Example 6. Synthesis of Compound 63

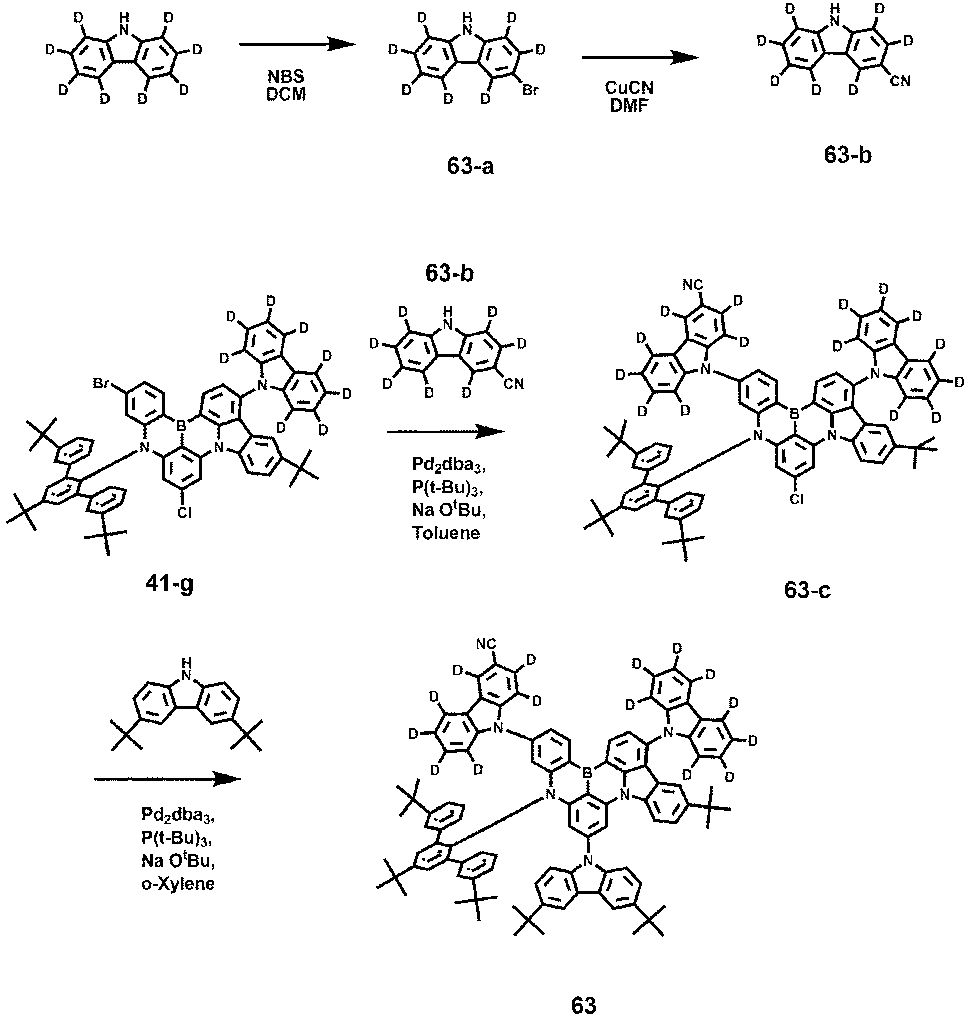

### Synthesis of Intermediate Compound 63-a

9H-carbazole-1,2,3,4,5,6,7,8-d8 (1 eq) was dissolved in dichloromethane in a 1 L-flask under an argon atmosphere. n-bromosuccinimide (1 eq) was dissolved in a small amount of DMF and added dropwise thereto. The reaction solution was stirred at room temperature for 4 hours. Water and methyl acetate (MC) were added thereto to extract an organic layer. The organic layer was dried utilizing MgSO₄ and filtered. The solvents were removed from the filtered solution under reduced pressure, and the obtained residue was subjected to column chromatography utilizing silica gel with a developing solvent of CH₂Cl₂ and hexane for separation and purification, thereby obtaining Intermediate Compound 63-a (yield: 82 %). The thus obtained compound was identified as Intermediate Compound 63-a through ESI-LCMS.

ESI-LCMS: [M]⁺: C₁₂HD₇BrN. 252.0279.

### Synthesis of Intermediate Compound 63-b

Intermediate Compound 63-a (1 eq) and copper cyanide (5 eq) were added to a 1 L-flask in an argon atmosphere and dissolved in DMF, followed by stirring the reaction solution at a temperature of 160 °C overnight. Water and MC were added thereto to extract an organic layer. The organic layer was dried utilizing MgSO₄ and filtered. The solvents were removed from the filtered solution under reduced pressure, and the obtained residue was subjected to column chromatography utilizing silica gel with a developing solvent of CH₂Cl₂ and hexane for separation and purification, thereby obtaining Intermediate Compound 63-b (yield: 71 %). The thus obtained compound was identified as Intermediate Compound 63-b through ESI-LCMS.

ESI-LCMS: [M]⁺: C₁₃HD₇N₂. 199.1127.

### Synthesis of Intermediate Compound 63-c

Intermediate Compound 63-c was synthesized in substantially the same manner as in Synthesis of Intermediate Compound 23-e, except that Intermediate 41-g was utilized instead of Intermediate Compound 23-d, and Intermediate Compound 63-b was utilized instead of 9H-carbazole-1,2,3,4,5,6,7,8-d8 (yield: 81 %). The thus obtained solid was identified as Intermediate Compound 63-c through ESI-LCMS.

ESI-LCMS: [M]⁺: C₈₃H₅₆D₁₅BClN₅. 1198.6433.

### Synthesis of Compound 63

Compound 63 was synthesized in substantially the same manner as in Synthesis of Compound 1, except that Intermediate Compound 63-c was utilized instead of Intermediate Compound 1-e, and 3,6-di-tert-butyl-9H-carbazole was utilized instead of 9H-carbazole (yellow solid, yield: 69 %). The thus obtained yellow solid was identified as Compound 63 through ¹H-NMR and ESI-LCMS.

¹H-NMR (400 MHz, CDCl₃): d = 9.13 (s, 1H), 9.05 (s, 1H), 8.63-8.60 (m, 2H), 8.48-8.30 (m, 4H), 8.01-7.80 (m, 6H) 7.78-7.72 (m, 2H), 7.58-7.42 (m, 6H), 7.22-7.18 (m, 4H), 1.42 (s, 18H), 1.32 (s, 18H), 1.22 (s, 9H) 1.09 (s, 9H).

ESI-LCMS: [M]⁺: C₁₀₃H₈₀D₁₅BN₆. 1441.8653.

**Table 1**

| Compound | ¹H NMR (δ) | ESI-LCMS | |
|---|---|---|---|
| | | Calc. | Found |
| 1 | 9.32 (s, 1H), 9.28 (s, 1H), 8.98 (s, 1H), 8.93 (s, 1H), 8.35 -8.20(m, 4H), 8.13-8.04 (m, 4H), 7.91-7.78 (m, 6H), 7.73-7.62 (m, 5H), 7.58-7.43 (m, 4H), 7.40-7.28 (m, 4H), 7.43-7.24 (m, 8H), 7.20-7.05 (m, 6H), 7.03-6.95 (m, 3H) | 1066.0870 | 1065.4001 |
| 17 | 9.35 (s, 1H), 9.31 (s, 1H), 8.02-7.90 (m, 6H), 7.85-7.72 (m, 5H) 7.58-7.48 (m, 4H), 7.42-7.31 (m, 4H), 7.28-7.23 (m, 3H), 7.03-6.95 (m, 4H), 1.43 (s, 18H), 1.32 (s, 18H). | 1306.6166 | 1305.7511. |
| 23 | 9.10 (s, 1H), 9.02 (s, 1H), 8.51-8.42 (m, 2H), 8.10-7.98 (m, 4H), 7.92-7.68 (m, 7H) 7.59-7.52 (m, 2H), 7.48-7.31 (m, 6H), 7.28-7.23 (m, 4H), 1.43 (s, 18H), 1.32 (s, 18H), 1.09 (s, 9H). | 1362.7246 | 1361.8137 |
| 26 | = 9.09 (s, 1H), 9.01 (s, 1H), 8.52-8.44 (m, 2H), 8.08-7.98 (m, 4H), 7.94-7.77 (m, 7H) 7.63-7.59 (m, 2H), 7.51-7.33 (m, 13H), 7.27-7.21 (m, 4H), 1.43 (s, 18H) | 1270.4986 | 1269.6572 |
| 41 | 8.98 (s, 1H), 8.94 (s, 1H), 8.50-8.46 (m, 2H), 8.23-8.01 (m, 4H), 7.94-7.80 (m, 6H) 7.60-7.55 (m, 2H), 7.51-7.37 (m, 6H), 7.25-7.19 (m, 4H), 1.43 (s, 18H), 1.31 (s, 18H), 1.21 (s, 9H) 1.09 (s, 9H). | 1418.8326 | 1417.8763. |
| 63 | 9.13 (s, 1H), 9.05 (s, 1H), 8.63-8.60 (m, 2H), 8.48-8.30 (m, 4H), 8.01-7.80 (m, 6H) 7.78-7.72 (m, 2H), 7.58-7.42 (m, 6H), 7.22-7.18 (m, 4H), 1.42 (s, 18H), 1.32 (s, 18H), 1.22 (s, 9H) 1.09 (s, 9H). | 1442.8365 | 1441.8653 |

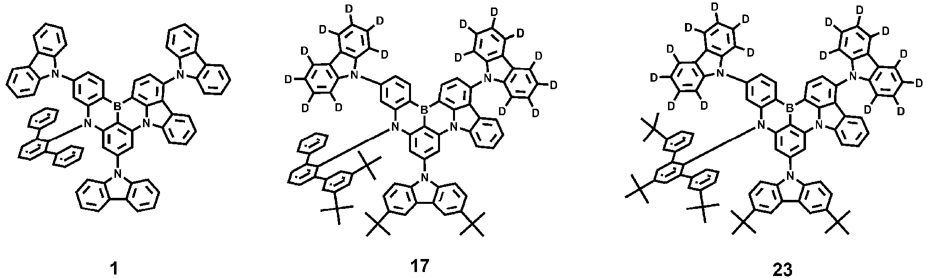

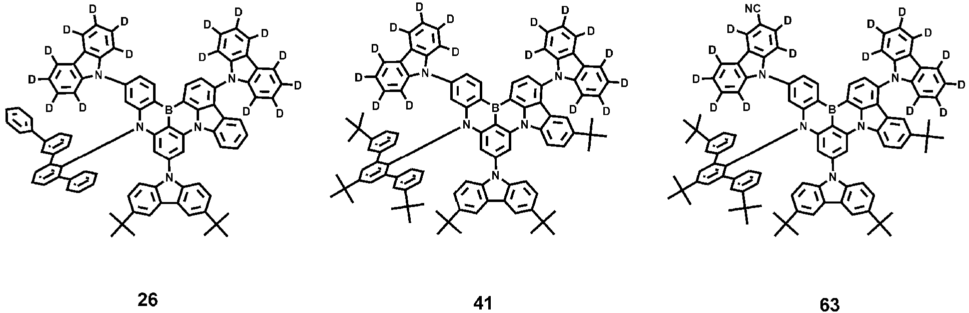

### Evaluation Example 1

Highest occupied molecular orbital (HOMO) and lowest occupied molecular orbital (LUMO) energy levels of each Compound was evaluated according to the method in Table 2. Results thereof are shown in Table 3. In addition, in Table 3, the HOMO energy level and the LUMO energy level were measured utilizing SmartManager software of ZIVE LAB's SP2 electrochemical workstation equipment. The λ_{Abs}, λₑₘᵢ, λ_{film}, photoluminescent quantum yield (PLQY), Stokes-shift, and full-width quarter maximum (FWQM) were measured by utilizing Labsolution UV-Vis software with UV-1800 UV/Visible Scanning Spectrophotometer available from SHIMADZU equipped with deuterium/tungsten-halogen light source and silicon photodiode. The Stoke-shift of a compound represents the difference between the maximum wavelength when absorbing energy and the maximum wavelength when emitting energy.

**Table 2**

| | |
|---|---|
| HOMO energy level evaluation method | A potential (V)-current (A) graph of each compound was obtained by utilizing cyclic voltammetry (CV) (electrolyte: 0.1 M Bu₄NPF₆/ solvent: dimethyl formamide (DMF)/ electrode: 3 electrode system (working electrode: glassy carbon (GC), reference electrode: Ag/AgCl, auxiliary electrode: Pt)), and then, from oxidation onset of the graph, a HOMO energy level of the compound was calculated. |
| LUMO energy level evaluation method | A potential (V)-current (A) graph of each compound was obtained by utilizing cyclic voltammetry (CV) (electrolyte: 0.1 M Bu₄NPF₆/ solvent: dimethyl formamide (DMF)/ electrode: 3 electrode system (working electrode: GC, reference electrode: Ag/AgCl, auxiliary electrode: Pt)), and then, from reduction onset of the graph, a LUMO energy level of the compound was calculated. |

**Table 3**

| | Dopant | HOMO (eV) | LUMO (eV) | S1 (eV) | T1 (eV) | ΔE_{ST} (eV) | PLQY (%) | λ_{Abs} (nm) | λₑₘᵢ (nm) | λ_{film} (nm) | Stokes-shift | FWQM (nm) |
|---|---|---|---|---|---|---|---|---|---|---|---|---|
| Example 1 | Compound 1 | -5.28 | -2.34 | 2.68 | 2.53 | 0.15 | 94 | 448 | 462 | 466 | 14 | 36 |
| Example 2 | Compound 17 | -5.29 | -2.33 | 2.69 | 2.56 | 0.13 | 95 | 448 | 460 | 462 | 12 | 32 |
| Example 3 | Compound 23 | -5.28 | -2.29 | 2.69 | 2.57 | 0.12 | 97 | 448 | 460 | 462 | 12 | 32 |
| Example 4 | Compound 26 | -5.27 | -2.26 | 2.70 | 2.59 | 0.11 | 92 | 447 | 459 | 463 | 12 | 33 |
| Example 5 | Compound 41 | -5.30 | -2.33 | 2.79 | 2.57 | 0.12 | 93 | 449 | 460 | 461 | 11 | 30 |
| Example 6 | Compound 63 | -5.38 | -2.23 | 2.79 | 2.56 | 0.13 | 90 | 448 | 461 | 462 | 13 | 31 |
| Comparative example 1 | Compound A | -5.40 | -2.16 | 2.61 | 2.40 | 0.21 | 81 | 457 | 475 | 481 | 18 | 42 |
| Comparative example 2 | Compound B | -5.22 | -2.01 | 2.76 | 2.66 | 0.20 | 82 | 433 | 449 | 456 | 16 | 43 |
| Comparative example 3 | Compound C | -5.35 | -2.18 | 2.69 | 2.53 | 0.16 | 83 | 455 | 460 | 465 | 15 | 40 |
| Comparative example 4 | Compound D | -5.38 | -2.20 | 2.73 | 2.56 | 0.17 | 85 | 439 | 455 | 457 | 16 | 39 |
| Comparative example 5 | Compound E | -5.30 | -2.16 | 2.61 | 2.41 | 0.20 | 80 | 457 | 475 | 480 | 18 | 41 |

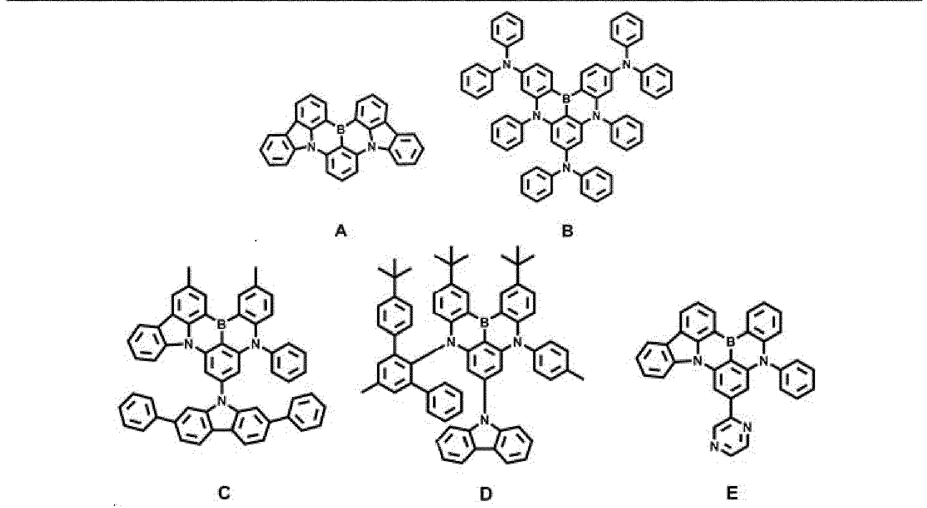

### Example 1

As an anode, a 15 Ohms per square centimeter (Ω/cm²) (1,200 Å) ITO glass substrate was cut to a size of 50 millimeters (mm) × 50 mm × 0.7 mm, sonicated in isopropyl alcohol and pure water for 5 minutes in each solvent, cleaned with ultraviolet rays for 30 minutes, and then ozone, and the substrate was mounted on a vacuum deposition apparatus.

NPD was vacuum-deposited on the ITO substrate to form a hole injection layer having a thickness of 300 Å, and then HT6 was vacuum-deposited on the hole injection layer to form a hole transport layer having a thickness of 200 Å.

A host compound in which a first host (ET1) and a second host (HT1) is mixed at weight ratio of 1:1, a phosphorescent sensitizer (PS1), and Compound 1 of Synthesis Example 1 were co-deposited at a weight ratio of 85:14:1 on the hole transport layer to form an emission layer having a thickness of 200 Å.

TSPO1 was deposited on the emission layer to form an electron transport layer having a thickness of 200 Å, and TPBI as a buffer electron transporting compound was deposited on the electron transport layer to form a buffer layer having a thickness of 300 Å.

LiF, i.e., halogenated alkali metal, was deposited on the buffer layer to form an electron injection layer having a thickness of 10 Å, and Al was vacuum-deposited on the electron injection layer to form a LiF/Al cathode having a thickness of 3,000 Å. HT28 was deposited on the cathode to form a capping layer having a thickness of 700 Å, thereby completing the manufacture of a light-emitting device.

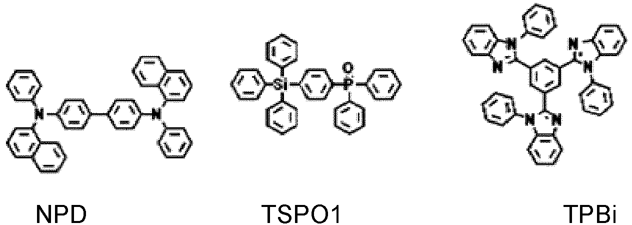

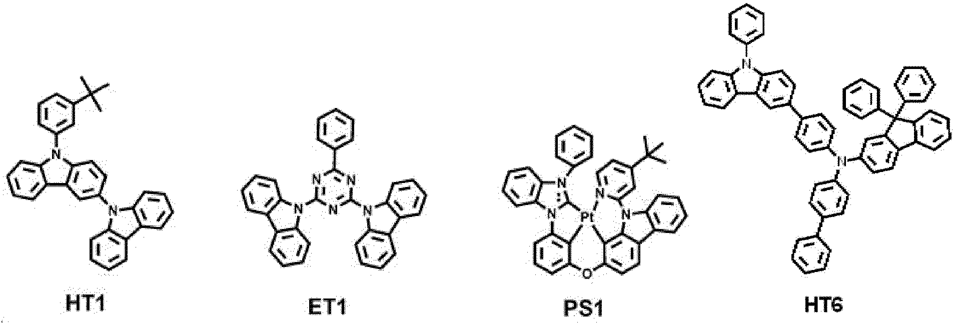

### Examples 2 to 6 and Comparative Examples 1 to 5

Examples 2 to 6 and Comparative Examples 1 to 5 were prepared in substantially the same manner as in Example 1, while varying the type or kind of dopant as shown in Table 4.

### Evaluation Example 2

The driving voltage (V), luminescence efficiency (cd/A), maximum emission wavelength (nm), and lifespan (T₉₅) of the light-emitting devices of Examples 1 to 6 and Comparative Examples 1 to 5 were measured at a current density of 10 mA/cm². Keithley source-measure unit (SMU) 236 and a luminance meter PR650 were utilized in measurement of the data. The results are shown in Table 4.

In Table 4, the lifespan ratio (T₉₅) indicates a relative rate of time required until the luminance of each light emitting device deteriorates to 95%, and the time for the light-emitting device of Comparative Example 1 to deteriorate to the 95% level was set to 1.

Table 4 shows measurement results of driving voltage (V), luminescence efficiency (Cd/A), maximum external quantum efficiency (%), lifespan, and emission color. The driving voltage (V), luminescence efficiency (cd/A), maximum external quantum efficiency (%), and emission color were measured by utilizing Keithley SMU 236 and a luminance meter PR650.

**Table 4**

| | Host (HT/ET) | Sensitizer | Dopant | Driving voltage (V) | Luminescence efficiency (cd/A) | Maximum emission wavelength (nm) | Full-width quarter maximum FWQM (nm) | Lifespan ratio (T95) | CIE (x,y) | Q.E (%) |
|---|---|---|---|---|---|---|---|---|---|---|
| Example 1 | HT1 /ET1 | PS1 | Compound 1 | 4.4 | 10.8 | 463 | 40 | 8.6 | 0.133, 0.061 | 10.2 |
| Example 2 | HT1/ET1 | PS1 | Compound 17 | 4.2 | 11.6 | 462 | 41 | 9.5 | 0.137, 0.065 | 13.0 |
| Example 3 | HT1/ET1 | PS1 | Compound 23 | 4.2 | 14.8 | 462 | 42 | 12.8 | 0.137, 0.053 | 15.4 |
| Example 4 | HT1/ET1 | PS1 | Compound 26 | 4.1 | 9.8 | 461 | 42 | 9.8 | 0.137, 0.052 | 10.3 |
| Example 5 | HT1/ET1 | PS1 | Compound 41 | 4.2 | 11.1 | 462 | 43 | 10.2 | 0.134, 0.056 | 9.8 |
| Example 6 | HT1/ET1 | PS1 | Compound 63 | 4.3 | 9.9 | 462 | 42 | 7.8 | 0.134, 0.055 | 9.1 |
| Comparative example 1 | HT1/ET1 | PS1 | Compound A | 5.5 | 1.3 | 476 | 48 | 1.0 | 0.130, 0.065 | 2.2 |
| Comparative example 2 | HT1/ET1 | PS1 | Compound B | 4.9 | 3.2 | 453 | 51 | 1.2 | 0.131, 0.038 | 4.5 |
| Comparative example 3 | HT1/ET1 | PS1 | Compound C | 4.5 | 4.1 | 463 | 48 | 1.7 | 0.133, 0.061 | 3.8 |
| Comparative example 4 | HT1/ET1 | PS1 | Compound D | 4.6 | 5.8 | 457 | 43 | 3.0 | 0.132, 0.041 | 4.2 |
| Comparative example 5 | HT1/ET1 | PS1 | Compound E | 5.0 | 3.1 | 476 | 48 | 2.0 | 0.130, 0.065 | 2.9 |

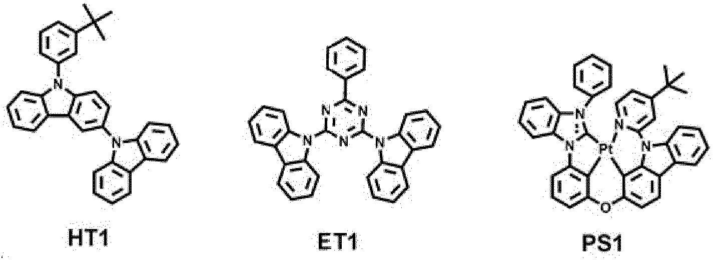

As apparent from the foregoing description, when the condensed cyclic compound is utilized, a light-emitting device and an electron apparatus including the light-emitting device may have a high efficiency and long lifespan.

In the present disclosure, singular expressions may include plural expressions unless the context clearly indicates otherwise. It will be further understood that the terms "comprise," "include," or "have" when utilized in the present disclosure, specify the presence of stated features, integers, steps, operations, elements, and/or components, but do not preclude the presence or addition of one or more other features, integers, steps, operations, elements, components, and/or groups thereof. The "/" utilized herein may be interpreted as "and" or as "or" depending on the situation.

Throughout the present disclosure, when a component such as a layer, a film, a region, or a plate is mentioned to be placed "on" another component, it will be understood that it may be directly on another component or that another component may be interposed therebetween. In some embodiments, "directly on" may refer to that there are no additional layers, films, regions, plates, etc., between a layer, a film, a region, a plate, etc. and the other part. For example, "directly on" may refer to two layers or two members are disposed without utilizing an additional member such as an adhesive member therebetween.

In the present disclosure, although the terms "first," "second," etc., may be utilized herein to describe one or more elements, components, regions, and/or layers, these elements, components, regions, and/or layers should not be limited by these terms. These terms are only utilized to distinguish one component from another component.

As utilized herein, the singular forms "a," "an," "one," and "the" are intended to include the plural forms as well, unless the context clearly indicates otherwise. Further, the use of "may" when describing embodiments of the present disclosure refers to "one or more embodiments of the present disclosure".

In the present disclosure, when particles are spherical, "diameter" indicates a particle diameter or an average particle diameter, and when the particles are non-spherical, the "diameter" indicates a major axis length or an average major axis length. The diameter (or size) of the particles may be measured utilizing a scanning electron microscope or a particle size analyzer. As the particle size analyzer, for example, HORIBA, LA-950 laser particle size analyzer, may be utilized. When the size of the particles is measured utilizing a particle size analyzer, the average particle diameter (or size) is referred to as D50. D50 refers to the average diameter (or size) of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size.

As utilized herein, the terms "substantially," "about," or similar terms are used as terms of approximation and not as terms of degree, and are intended to account for the inherent deviations in measured or calculated values that would be recognized by those of ordinary skill in the art. "About" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

The light-emitting device, the display device, the display apparatus, the electronic apparatus, the electronic device, or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the drawings, it will be understood by those of ordinary skill in the art that one or more suitable changes in form and details may be made therein without departing from the scope as defined by the following appended claims.

## Claims

1. A light-emitting device (10) comprising:
a first electrode (110);
a second electrode (150) facing the first electrode (110);
an interlayer (130) between the first electrode (110) and the second electrode (150), the interlayer (130) comprising an emission layer; and
a condensed cyclic compound represented by Formula 1: 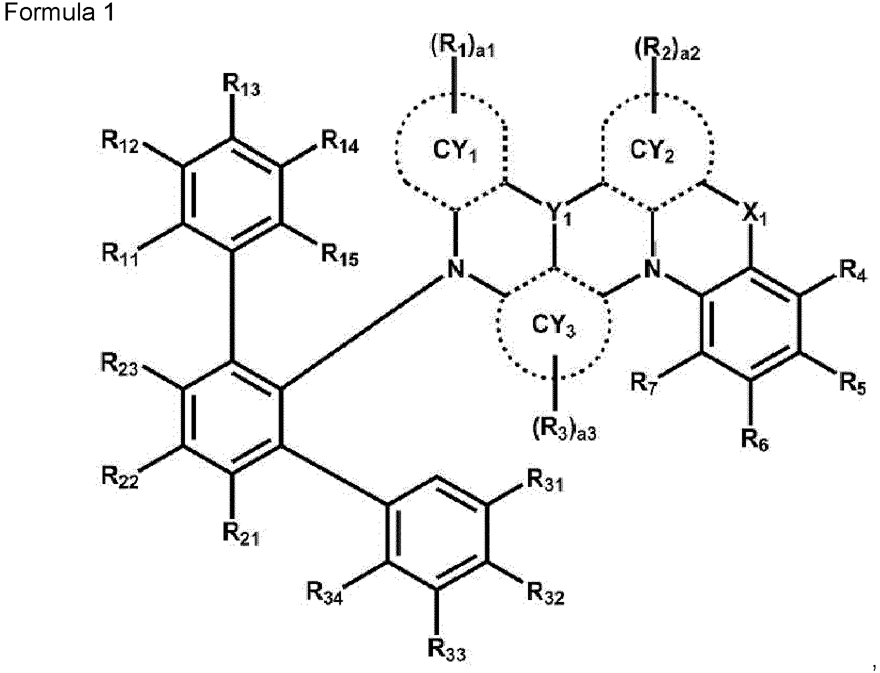
wherein, in Formula 1,
X₁ is a single bond
Y₁ is N, B, P(=O), or P(=S),
ring CY₁ to ring CY₃ are each independently a C₆-C₆₀ carbocyclic group or a C₂-C₆₀ heterocyclic group,
a1 to a3 are each independently an integer from 0 to 10,
R₁ to R₉, R₁₁ to R₁₅, R₂₁ to R₂₃, and R₃₁ to R₃₄ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
at least two groups, selected from R₁ to R₉, R₁₁ to R₁₅, R₂₁ to R₂₃, and R₃₁ to R₃₄, are optionally bound to each other to form a C₅-C₃₀ carbocyclic group unsubstituted or substituted with at least one R₁₀ₐ or a C₂-C₃₀ heterocyclic group unsubstituted or substituted with at least one R₁₀ₐ, wherein R₃ and R₇ are not bound to each other to form a C₅-C₃₀ carbocyclic group unsubstituted or substituted with at least one R₁₀ₐ or a C₂-C₃₀ heterocyclic group unsubstituted or substituted with at least one R₁₀ₐ, and
R₁₀ₐ is:
deuterium, -F, -Cl, -Br, -I, a hydroxyl group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -CI, - Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
wherein Q₁ to Q₃, Q₁₁ to Q₁₃, Q₂₁ to Q₂₃, and Q₃₁ to Q₃₃ are each independently:
hydrogen, deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, or a C₁-C₆₀ alkoxy group; or
a C₃-C₆₀ carbocyclic group, a C₁-C₆₀ heterocyclic group, a C₇-C₆₀ aryl alkyl group, or a C₂-C₆₀ heteroaryl alkyl group, each unsubstituted or substituted with deuterium, -F, a cyano group, a C₁-C₆₀ alkyl group, a C₁-C₆₀ alkoxy group, a phenyl group, a biphenyl group, or any combination thereof.

2. The light-emitting device (10) of claim 1, wherein the interlayer (130) comprises the condensed cyclic compound represented by Formula 1.

3. The light-emitting device (10) of claim 1, wherein the emission layer comprises the condensed cyclic compound represented by Formula 1.

4. The light-emitting device (10) of any one of claims 1 to 3, wherein the emission layer comprises a host and a dopant, and the dopant comprises the condensed cyclic compound, optionally wherein the host comprises a first host and a second host, and the first host is an electron transporting host, and the second host is a hole transporting host.

5. The light-emitting device (10) of any one of claims 1 to 4, wherein:
(i) the emission layer further comprises a sensitizer; and/or
(ii) the emission layer is configured to emit blue light having a maximum emission wavelength in a range of about 410 nanometers (nm) to about 490 nm; and/or
(iii) the first electrode (110) is an anode,
the second electrode (150) is a cathode,
the interlayer (130) further comprises a hole transport region between the first electrode (110) and the emission layer and an electron transport region between the emission layer and the second electrode (150),
the hole transport region comprises a hole injection layer, a hole transport layer, an emission auxiliary layer, an electron blocking layer, or any combination thereof, and
the electron transport region comprises a hole blocking layer, an electron transport layer, an electron injection layer, or any combination thereof.

6. An electronic apparatus comprising the light-emitting device (10) of any one of claims 1 to 5.

7. The electronic apparatus of claim 6, further comprising:
a thin-film transistor; and
a color filter, a color-conversion layer, a touchscreen layer, a polarizing layer, or any combination thereof,
wherein the thin-film transistor comprises a source electrode (260) and a drain electrode (270), and
the first electrode (110) of the light-emitting device (10) is electrically connected to the source electrode (260) or the drain electrode (270) of the thin-film transistor.

8. An electronic equipment comprising the light-emitting device (10) of any one of claims 1 to 7, wherein
the electronic equipment is at least one selected from a flat panel display, a curved display, a computer monitor, a medical monitor, a television, an advertisement board, an indoor or outdoor lighting, and/or signaling light, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a microdisplay, a 3D display, a virtual or augmented reality display, a vehicle, a video wall comprising multiple displays tiled together, a theater or stadium screen, a phototherapy device, and a signage.

9. A condensed cyclic compound represented by Formula 1: 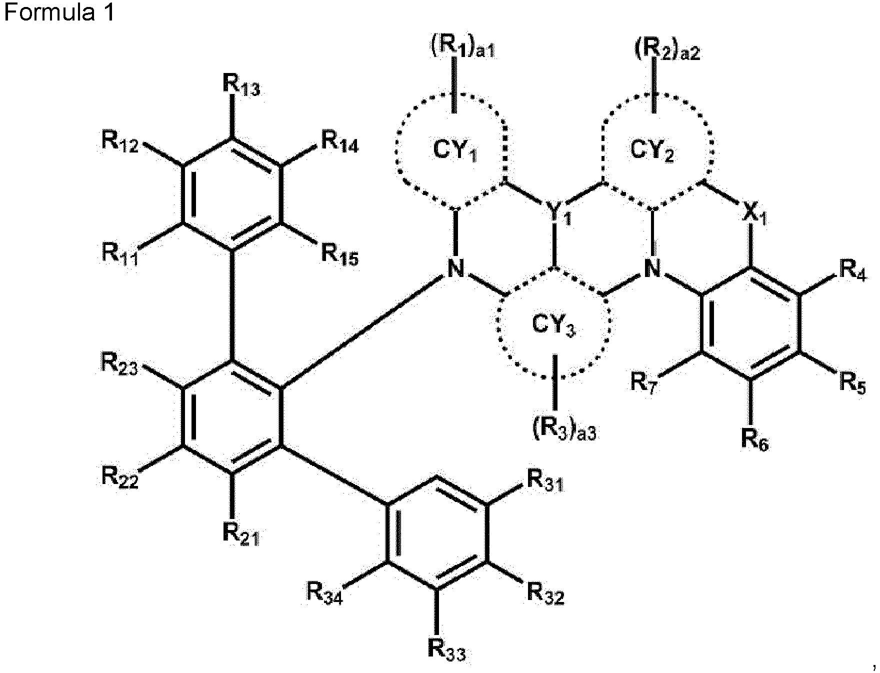 wherein, in Formula 1,
X₁ is a single bond,
Y₁ is N, B, P(=O), or P(=S),
ring CY₁ to ring CY₃ are each independently a C₆-C₆₀ carbocyclic group or a C₂-C₆₀ heterocyclic group,
a1 to a3 are each independently an integer from 0 to 10,
R₁ to R₉, R₁₁ to R₁₅, R₂₁ to R₂₃, and R₃₁ to R₃₄ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
at least two groups selected from R₁ to R₉, R₁₁ to R₁₅, R₂₁ to R₂₃, and R₃₁ to R₃₄ are optionally bound to each other to form a C₅-C₃₀ carbocyclic group unsubstituted or substituted with at least one R₁₀ₐ or a C₂-C₃₀ heterocyclic group unsubstituted or substituted with at least one R₁₀ₐ, wherein R₃ and R₇ are not bound to each other to form a C₅-C₃₀ carbocyclic group unsubstituted or substituted with at least one R₁₀ₐ or a C₂-C₃₀ heterocyclic group unsubstituted or substituted with at least one R₁₀ₐ, and
R₁₀ₐ is:
deuterium, -F, -Cl, -Br, -I, a hydroxyl group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -CI, - Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
wherein Q₁ to Q₃, Q₁₁ to Q₁₃, Q₂₁ to Q₂₃, and Q₃₁ to Q₃₃ are each independently:
hydrogen, deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, or a C₁-C₆₀ alkoxy group; or
a C₃-C₆₀ carbocyclic group, a C₁-C₆₀ heterocyclic group, a C₇-C₆₀ aryl alkyl group, or a C₂-C₆₀ heteroaryl alkyl group, each unsubstituted or substituted with deuterium, -F, a cyano group, a C₁-C₆₀ alkyl group, a C₁-C₆₀ alkoxy group, a phenyl group, a biphenyl group, or any combination thereof.

10. The condensed cyclic compound of claim 9, wherein:
Y₁ is B.

11. The condensed cyclic compound of claim 9 or claim 10, wherein:
(i) ring CY₁ is a group represented by Formula CY1-1: 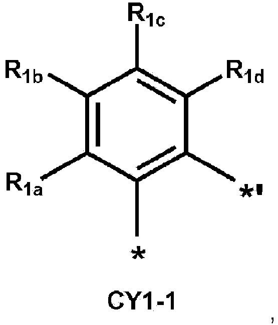 and
wherein, in Formula CY1-1,
* indicates a binding site to an adjacent N in Formula 1,
*' indicates a binding site to an adjacent Y₁ in Formula 1,
R₁ₐ to R_{1d} are each independently the same as described in Formula 1 with respect to R₁, and/or
(ii) ring CY₂ is a group represented by Formula CY2-1: 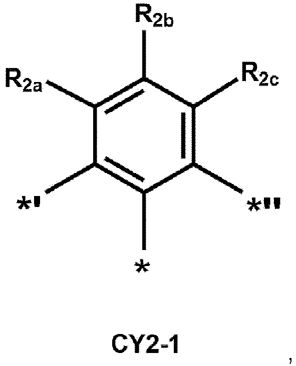 and
wherein, in Formula CY2-1,
* indicates a binding site to an adjacent N in Formula 1,
*' indicates a binding site to an adjacent Y₁ in Formula 1,
*" indicates a binding site to an adjacent X₁ in Formula 1,
R₂ₐ to R_{2c} are each independently the same as described in Formula 1 with respect to R₂ .

12. The condensed cyclic compound of any one of claims 9 to 11, wherein ring CY₃ is a group represented by Formula CY3-1: 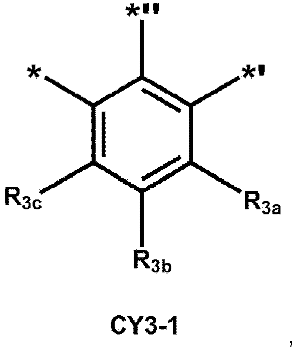 and
wherein, in Formula CY3-1,
* and *' are each independently a binding site to an adjacent N in Formula 1,
*" indicates a binding site to an adjacent Y₁ in Formula 1,
R₃ₐ to R_{3c} are each independently the same as described in Formula 1 with respect to R₃.

13. The condensed cyclic compound of any one of claims 9 to 12, wherein a sum of a1 to a3 is 1 or greater, and
at least one selected from among R₁ to R₃ is represented by one selected from Formulae 2-1 to 2-4: 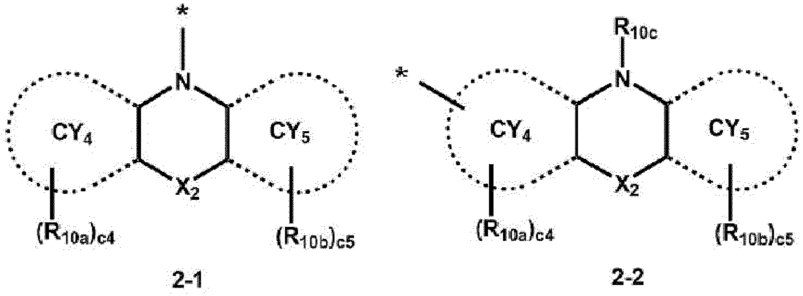 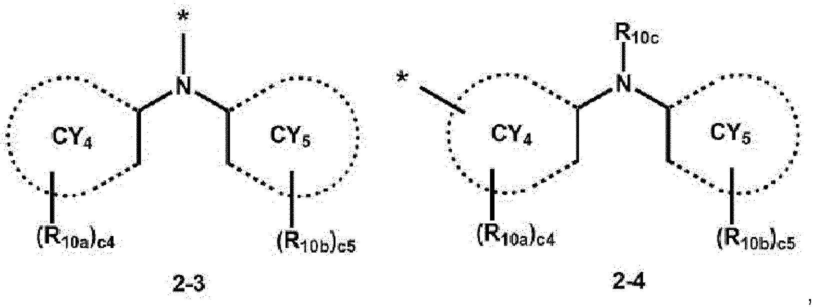 and
wherein, in Formulae 2-1 to 2-4,
X₂ is a single bond, O, S, Se, C(R₈)(R₉), Si(R₈)(R₉), or N(R₈),
CY₄ and CY₅ are each independently a C₅-C₃₀ carbocyclic group or a C₂-C₃₀ heterocyclic group,
c4 and c5 are each independently an integer from 0 to 10,
R_{10b} and R_{10c} are each independently the same as described in Formula 1 with respect to R₁₀ₐ,
* indicates a binding site to an adjacent atom.

14. The condensed cyclic compound of any one of claims 9 to 13, wherein R₁₁ to R₁₅, R₂₁ to R₂₃, and R₃₁ to R₃₄ are each independently:
hydrogen, deuterium, -F, a cyano group, a methyl group unsubstituted or substituted with at least one R₁₀ₐ, a cyclohexyl group unsubstituted or substituted with at least one R₁₀ₐ, a phenyl group unsubstituted or substituted with at least one R₁₀ₐ, - C(Q₁)(Q₂)(Q₃), or -Si(Q₁)(Q₂)(Q₃); or
a group represented by one of Formulae 3-1 to 3-12: 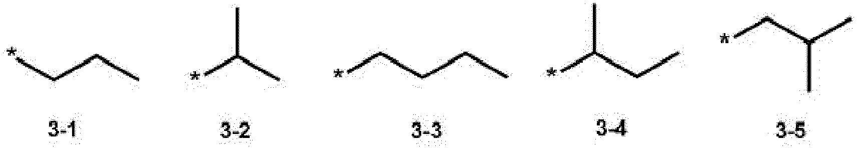 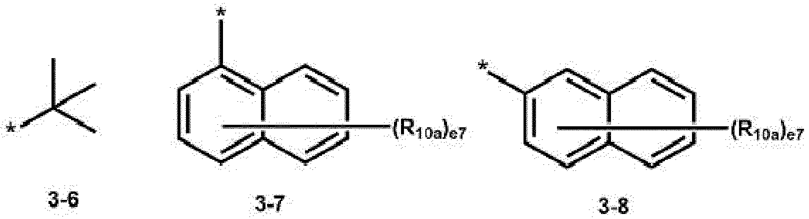 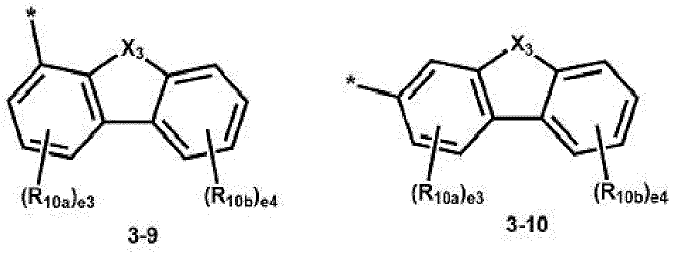 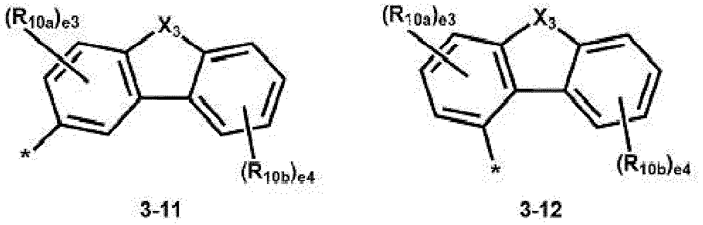 and
wherein, in Formulae 3-1 to 3-12,
X₃ is O or S,
e3 is an integer from 0 to 3,
e4 is an integer from 0 to 4,
e7 is an integer from 0 to 7,
R_{10b} is the same as described in Formula 1 with respect to R₁₀ₐ, and
* indicates a binding site to an adjacent atom.

15. The condensed cyclic compound of claim 9, wherein the condensed cyclic compound is one selected from among Compounds 1 to 68:

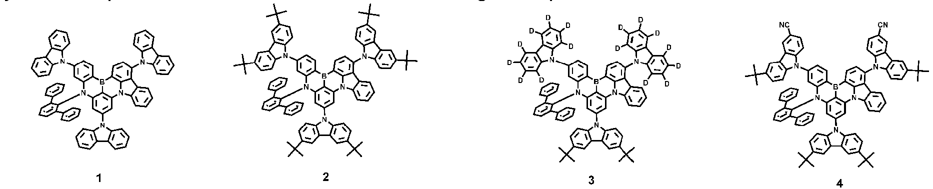

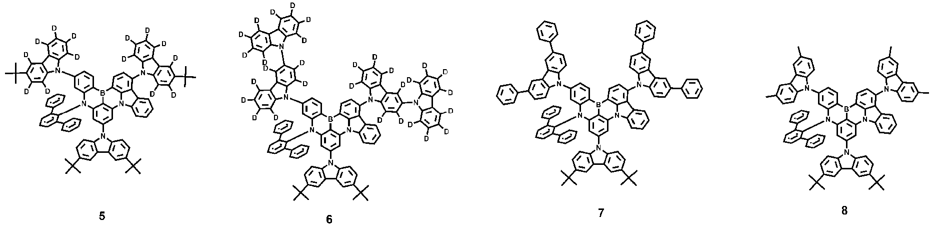

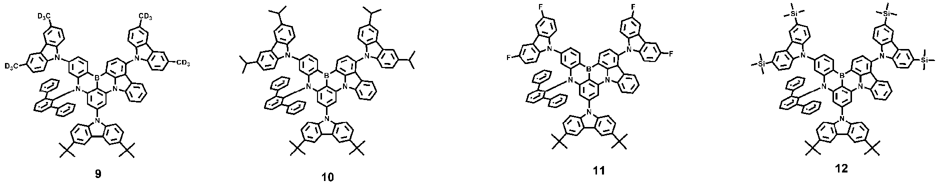

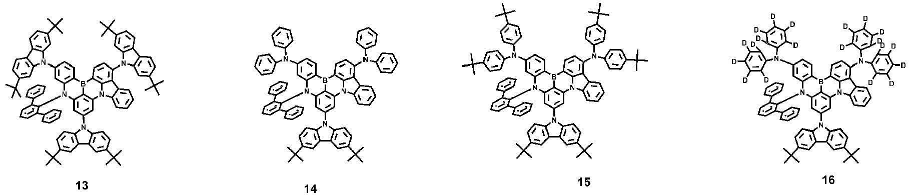

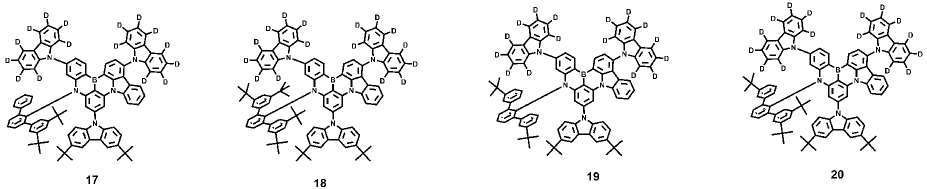

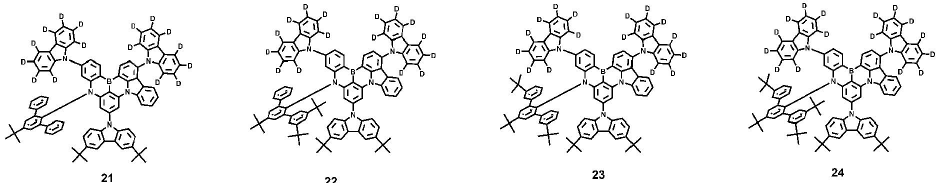

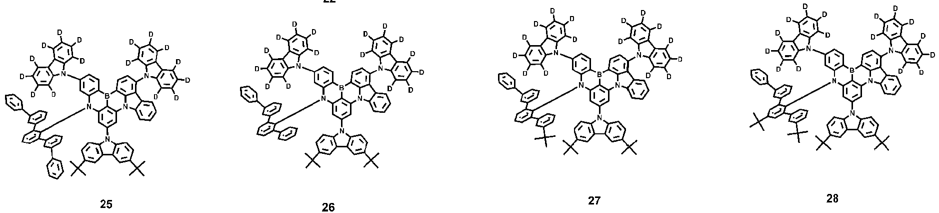

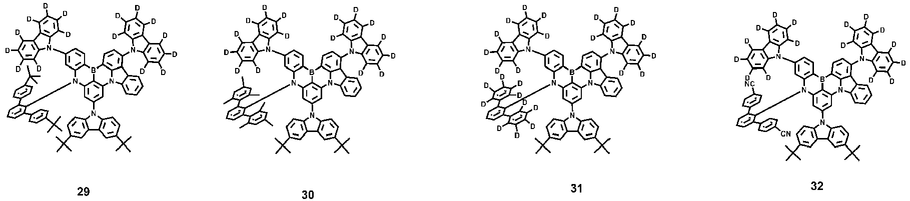

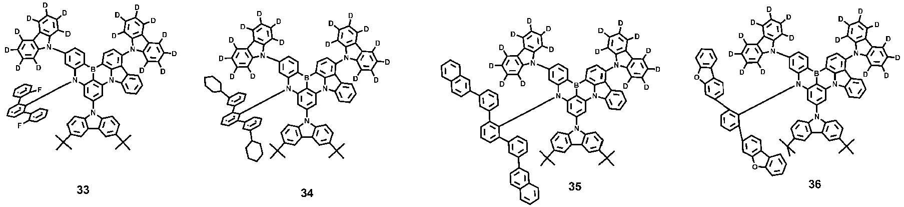

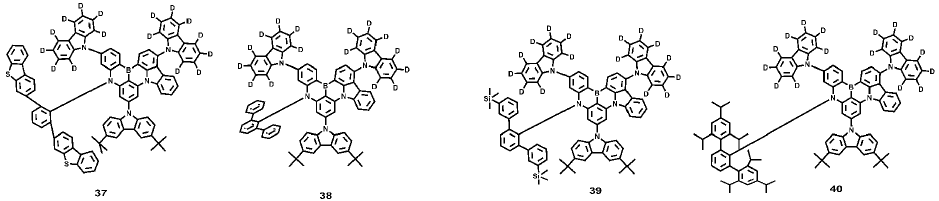

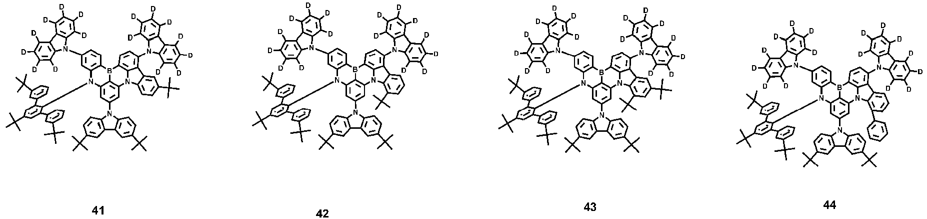

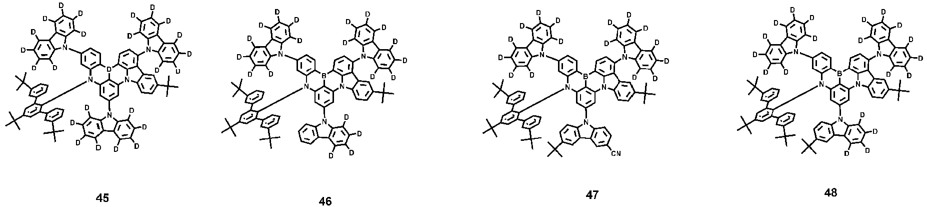

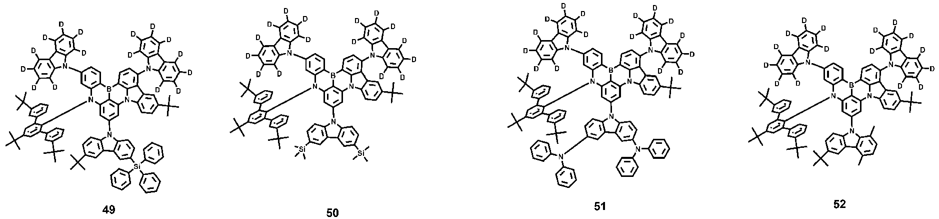

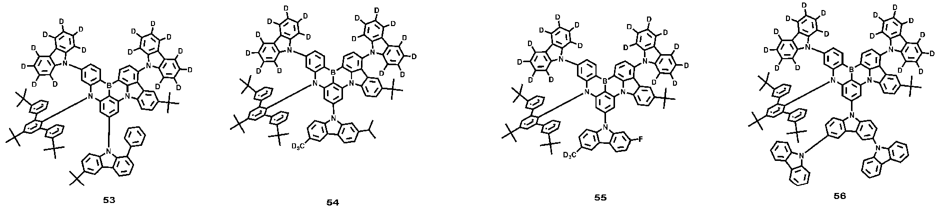

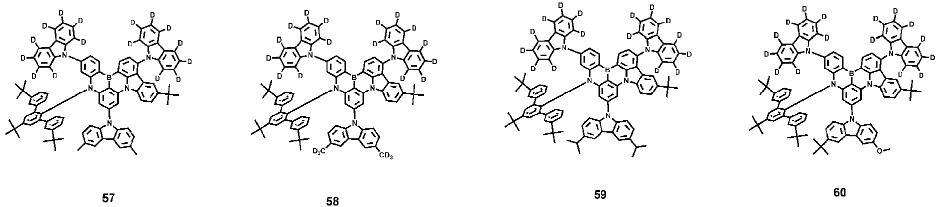

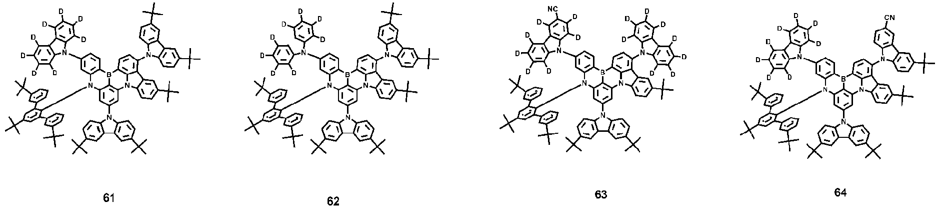

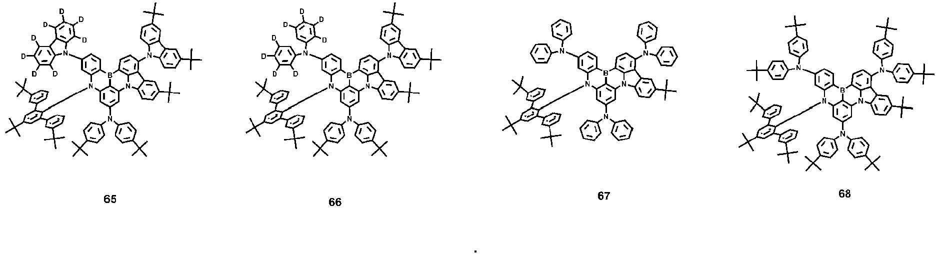

## Patentansprüche

1. Lichtemittierende Vorrichtung (10) umfassend:
eine erste Elektrode (110);
eine zweite Elektrode (150), die der ersten Elektrode (110) zugewandt ist;
eine Zwischenschicht (130) zwischen der ersten Elektrode (110) und der zweiten Elektrode (150), wobei die Zwischenschicht (130) eine Emissionsschicht umfasst; und
eine kondensierte cyclische Verbindung, dargestellt durch die Formel 1: 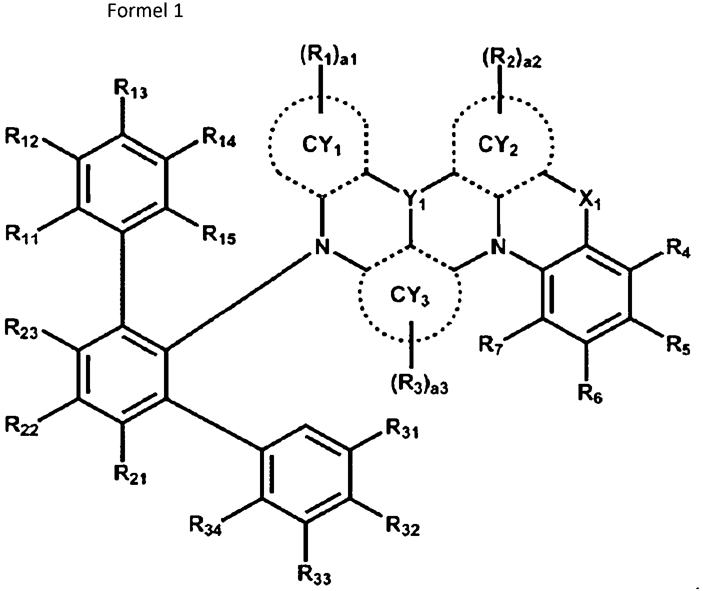
wobei in der Formel 1
X₁ eine Einfachbindung ist
Y₁ N, B, P(=O) oder P(=S) ist
Ring CY₁ bis Ring CY₃ jeweils unabhängig voneinander eine C₅-C₆₀ carbocyclische Gruppe oder eine C₂-C₆₀ heterocyclische Gruppe C₅-C₆₀ sind
a1 bis a3 jeweils unabhängig voneinander ganze Zahlen von 0 bis 10 sind,
R₁ bis R₉,R₁₁ bis R₁₅,R₂₁ bis R₂₃ und R₃₁ bis R₃₄ jeweils unabhängig voneinander Wasserstoff, Deuterium, -F, -Cl, -Br, -I, eine Hydroxylgruppe, eine Cyanogruppe, eine Nitrogruppe, eine C₁-C₆₀ Alkylgruppe, die unsubstituiert oder mit mindestens einem R₁₀ₐ substituiert ist, eine C₂-C₆₀ Alkenylgruppe, die unsubstituiert oder mit mindestens einem R₁₀ₐ substituiert ist, eine C₂-C₆, Alkinylgruppe, die unsubstituiert oder mit mindestens einem R₁₀ₐsubstituiert ist, eine C₁-C₆₀ Alkoxygruppe, die unsubstituiert oder mit mindestens einem R₁₀ₐ substituiert ist, eine C₁-C₆₀ Alkylthiogruppe, die unsubstituiert oder mit mindestens einem R₁₀ₐ substituiert ist, eine C₃-C₆₀ carbocyclische Gruppe, die unsubstituiert oder mit mindestens einem R₁₀ₐsubstituiert ist, eine C₁-C₆₀ heterocyclische Gruppe, die unsubstituiert oder mit mindestens einem R₁₀ₐsubstituiert ist, eine C₆-C₆₀ Aryloxygruppe, die unsubstituiert oder mit mindestens einem R₁₀ₐsubstituiert ist, eine C₆-C₆₀ Arylthiogruppe, die unsubstituiert oder mit mindestens einem R₁₀ₐ, -C(Q₁)(Q₂)(Q₃), - Si(Q₁)(Q₂)(Q₃), -N(Q₁)(Q₂), -B(Q₁)(Q₂), -C(=O)(Q₁), -S(=O)₂(Q₁) oder -P(=O)(Q₁)(Q₂) substituiert ist,
mindestens zwei Gruppen, ausgewählt aus R₁ bis R₉, R₁₁ bis R₁₅, R₂₁ bis R₂₃ und R₃₁ bis R₃₄ optional miteinander verbunden sind, um eine C₅-C₃₀ carbocyclische Gruppe, unsubstituiert oder substituiert mit mindestens einem R₁₀ₐ, oder eine C₂-C₃₀ heterocyclische Gruppe, unsubstituiert oder substituiert mit mindestens einem R₁₀ₐ, zu bilden, wobei R₃ und R₇ nicht miteinander verbunden sind, um eine C₅-C₃₀ carbocyclische Gruppe, unsubstituiert oder substituiert mit mindestens einem R₁₀ₐ, oder eine C₂-C₃₀ heterocyclische Gruppe, unsubstituiert oder substituiert mit mindestens einem R₁₀ₐ, zu bilden und
R₁₀ₐ ist:
Deuterium, -F, -Cl, -Br, -I, eine Hydroxylgruppe oder eine Nitrogruppe ist;
eine C₁-C₆₀ Alkylgruppe, eine C₂-C₆, Alkenylgruppe, eine C₂-C₆, Alkinylgruppe oder eine C₁-C₆₀ Alkoxygruppe, jeweils unsubstituiert oder substituiert mit Deuterium, - F, -Cl, -Br, -I, einer Hydroxylgruppe, einer Cyanogruppe, einer Nitrogruppe, einer C₃-C₆₀ carbocyclischen Gruppe, einer C₁-C₆₀ heterocyclischen Gruppe, einer C₆-C₆₀ Aryloxygruppe, einer C₆-C₆₀ Arylthiogruppe, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂) oder einer beliebigen Kombination davon ist;
eine C₃-C₆₀ carbocyclische Gruppe, eine C₁-C₆₀ heterocyclische Gruppe, eine C₆-C₆₀ Aryloxygruppe oder eine C₆-C₆₀ Arylthiogruppe, jeweils unsubstituiert oder substituiert mit Deuterium, - F, - Cl, - Br, - I, einer Hydroxylgruppe, einer Cyanogruppe, einer Nitrogruppe, einer C₁-C₆₀ Alkylgruppe, einer C₂-C₆₀ Alkenylgruppe, einer C₂-C₆₀ Alkinylgruppe, einer C₁-C₆₀ Alkoxygruppe, einer C₃-C₆₀ carbocyclischen Gruppe, einer C₁-C₆₀ heterocyclischen Gruppe, einer C₆-C₆₀ Aryloxygruppe, einer C₆-C₆₀ Arylthiogruppe, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(= O)(Q₂₁)(Q₂₂) oder einer beliebigen Kombination davon ist; oder
-Si(Q₃₁)(Q₃₂)(Q₃₃), -N(Q₃₁)(Q₃₂), -B(Q₃₁)(Q₃₂), -C(= O)(Q₃₁), -S(= O)₂(Q₃₁) oder -P(=O)(Q₃₁)(Q₃₂) und
wobei Q₁ bis Q₃, Q₁₁ bis Q₁₃,Q₂₁ bis Q₂₃ und Q₃₁ bis Q₃₃ jeweils unabhängig voneinander:
Wasserstoff, Deuterium, -F, -Cl, -Br, -I, eine Hydroxylgruppe, eine Cyanogruppe, eine Nitrogruppe, eine C₁-C₆₀ Alkylgruppe, eine C₂-C₆, Alkenylgruppe, eine C₂-C₆, Alkinylgruppe oder eine C₁-C₆₀ Alkoxygruppe sind; oder
eine C₃-C₆₀ carbocyclische Gruppe, eine C₁-C₆₀) heterocyclische Gruppe, eine C₇-C₆₀ Arylalkylgruppe oder eine C₂-C₆, Heteroarylalkylgruppe, jeweils unsubstituiert oder substituiert mit Deuterium, - F , einer Cyanogruppe, einer C₁-C₆₀ Alkylgruppe, einer C₁-C₆₀ Alkoxygruppe, einer Phenylgruppe, einer Biphenylgruppe oder einer beliebigen Kombination davon sind.

2. Lichtemittierende Vorrichtung (10) nach Anspruch 1, wobei die Zwischenschicht (130) die durch Formel 1 dargestellte kondensierte cyclische Verbindung umfasst.

3. Lichtemittierende Vorrichtung (10) nach Anspruch 1, wobei die Emissionsschicht die durch Formel 1 dargestellte kondensierte cyclische Verbindung umfasst.

4. Lichtemittierende Vorrichtung (10) nach einem der Ansprüche 1 bis 3, wobei die Emissionsschicht ein Wirtsmaterial und ein Dotierungsmittel umfasst und das Dotierungsmittel die kondensierte cyclische Verbindung umfasst, wobei das Wirtsmaterial optional ein erstes Wirtsmaterial und ein zweites Wirtsmaterial umfasst, wobei das erste Wirtsmaterial ein Elektronen transportierendes Wirtsmaterial und das zweite Wirtsmaterial ein Loch transportierendes Wirtsmaterial ist.

5. Lichtemittierende Vorrichtung (10) nach einem der Ansprüche 1 bis 4, wobei:
(i) die Emissionsschicht weiter einen Sensibilisator umfasst; und/oder
(ii) die Emissionsschicht so konfiguriert ist, dass sie blaues Licht emittiert, das eine maximale Emissionswellenlänge im Bereich von etwa 410 (nm) Nanometern bis etwa 490 nm aufweist; und/oder
(iii) die erste Elektrode (110) eine Anode ist,
die zweite Elektrode (150) eine Kathode ist,
die Zwischenschicht (130) weiter eine Lochtransportregion zwischen der ersten Elektrode (110) und der Emissionsschicht sowie eine Elektronentransportregion zwischen der Emissionsschicht und der zweiten Elektrode (150) umfasst,
die Lochtransportregion eine Lochinjektionsschicht, eine Lochtransportschicht, eine Emissionshilfsschicht, eine Elektronenblockierschicht oder eine beliebige Kombination davon umfasst und
die Elektronentransportregion eine Lochblockierschicht, eine Elektronentransportschicht, eine Elektroneninjektionsschicht oder eine beliebige Kombination davon umfasst.

6. Elektronische Einrichtung, umfassend die lichtemittierende Vorrichtung (10) nach einem der Ansprüche 1 bis 5.

7. Elektronische Einrichtung nach Anspruch 6, weiter umfassend:
einen Dünnschichttransistor; und
einen Farbfilter, eine Farbumwandlungsschicht, eine Touchscreen-Schicht, eine Polarisationsschicht oder eine beliebige Kombination davon,
wobei der Dünnschichttransistor eine Source-Elektrode (260) und eine Drain-Elektrode (270) umfasst und
die erste Elektrode (110) der lichtemittierenden Vorrichtung (10) elektrisch mit der Source-Elektrode (260) oder der Drain-Elektrode (270) des Dünnschichttransistors verbunden ist.

8. Elektronische Ausrüstung, umfassend die lichtemittierende Vorrichtung (10) nach einem der Ansprüche 1 bis 7, wobei
die elektronische Ausrüstung mindestens eines ist, ausgewählt aus einem Flachbildschirm, einem gebogenen Bildschirm, einem Computermonitor, einem medizinischen Monitor, einem Fernseher, einer Werbetafel, einer Innen- oder Außenbeleuchtung und/oder einer Signalleuchte, einem Head-up-Display, einer vollständig oder teilweise transparenten Anzeige, einer flexiblen Anzeige, einer aufrollbaren Anzeige, einer faltbaren Anzeige, einer dehnbaren Anzeige, einem Laserdrucker, einem Telefon, einem Mobiltelefon, einem Tablet, einem Phablet, einem persönlichen digitalem Assistenten (PDA), einer tragbaren Vorrichtung, einem Laptop, einer Digitalkamera, einem Camcorder, einem Sucher, einer Mikroanzeige, einer 3D-Anzeige, einer Virtual-Reality- oder Augmented-Reality-Anzeige, einem Fahrzeug, einer Videowand aus mehreren zusammengefügten Anzeigen, einer Theater- oder Stadionleinwand, einer Phototherapie-Vorrichtung und einer Beschilderung.

9. Kondensierte cyclische Verbindung, dargestellt durch die Formel 1: 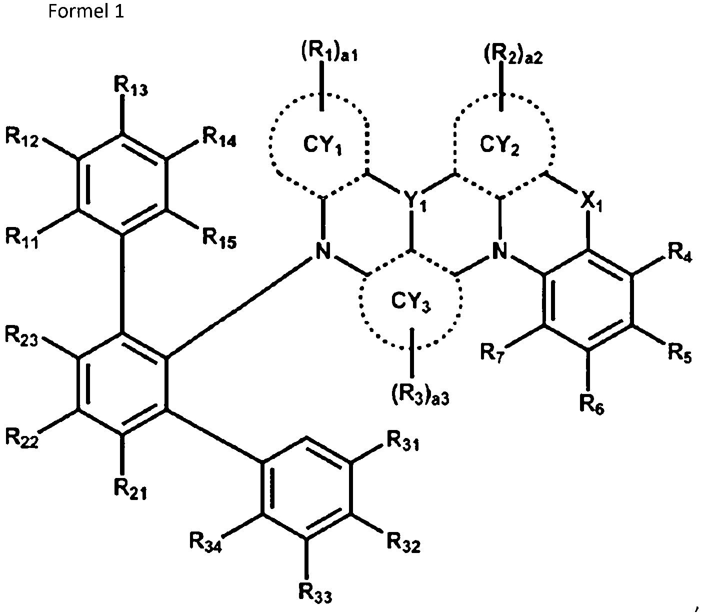
wobei in der Formel 1
X₁ eine Einfachbindung ist,
Y₁ N, B, P(=O) oder P(=S) ist,
Ring CY₁ bis Ring CY₃ jeweils unabhängig voneinander eine C₅-C₆₀ carbocyclische Gruppe oder eine C₂-C₆₀ heterocyclische Gruppe sind,
a1 bis a3 jeweils unabhängig voneinander ganze Zahlen von 0 bis 10 sind,
R₁ bis R₉,R₁₁ bis R₁₅,R₂₁ bis R₂₃und R₃₁ bis R₃₄ jeweils unabhängig voneinander Wasserstoff, Deuterium, -F, -Cl, -Br, -I, eine Hydroxylgruppe, eine Cyanogruppe, eine Nitrogruppe, eine C₁-C₆₀ Alkylgruppe, die unsubstituiert oder mit mindestens einem R₁₀ₐsubstituiert ist, eine C₂-C₆₀ Alkenylgruppe, die unsubstituiert oder mit mindestens einem R₁₀ₐsubstituiert ist, eine C₂-C₆₀ Alkinylgruppe, die unsubstituiert oder mit mindestens einem R₁₀ₐsubstituiert ist, eine C₁-C₆₀ Alkoxygruppe, die unsubstituiert oder mit mindestens einem R₁₀ₐsubstituiert ist, eine C₁-C₆₀ Alkylthiogruppe, die unsubstituiert oder mit mindestens einem R₁₀ₐsubstituiert ist, eine C₃-C₆₀ carbocyclische Gruppe, die unsubstituiert oder mit mindestens einem R₁₀ₐsubstituiert ist, eine C₁-C₆₀ heterocyclische Gruppe, die unsubstituiert oder mit mindestens einem R₁₀ₐsubstituiert ist, eine C₆-C₆₀ Aryloxygruppe, die unsubstituiert oder mit mindestens einem R₁₀ₐsubstituiert ist, eine C₆-C₆₀ Arylthiogruppe, die unsubstituiert oder mit mindestens einem R₁₀ₐ, C(Q₁)(Q₂)(Q₃), -Si(Q₁)(Q₂)(Q₃)oder -N(Q₁)(Q₂), -B(Q₁)(Q₂), -C(=O)(Q₁), -S(=O)₂(Q₁) -P(=O)(Q₁)(O₂) substituiert ist,
mindestens zwei Gruppen, ausgewählt aus R₁ bis R₉, R₁₁ bis R₁₅, R₂₁ bis R₂₃und R₃₁ bis R₃₄ optional miteinander verbunden sind, um eine C₅-C₆₀ carbocyclische Gruppe, unsubstituiert oder substituiert mit mindestens einem R₁₀ₐ, oder eine C₂-C₃₀ heterocyclische Gruppe, unsubstituiert oder substituiert mit mindestens einem R₁₀ₐ, zu bilden, wobei R₃ und R₇ nicht miteinander verbunden sind, um eine C₅-C₃₀ carbocyclische Gruppe, unsubstituiert oder substituiert mit mindestens einem R₁₀ₐ, oder eine C₂-C₃₀ heterocyclische Gruppe, unsubstituiert oder substituiert mit mindestens einem R₁₀ₐ, zu bilden und
R₁₀ₐ ist:
Deuterium, -F, -Cl, -Br, -I, eine Hydroxylgruppe oder eine Nitrogruppe ist;
eine C₁-C₆₀ Alkylgruppe, eine C₂-C₆₀ Alkenylgruppe, eine C₂-C₆₀ Alkinylgruppe oder eine C₁-C₆₀Alkoxygruppe, jeweils unsubstituiert oder substituiert mit Deuterium, - F, -Cl, -Br, -I, a Hydroxylgruppe, einer Cyanogruppe, einer Nitrogruppe, einer C₃-C₆₀ carbocyclischen Gruppe, einer C₁-C₆₀ heterocyclischen Gruppe, einer C₆-C₆₀ Aryloxygruppe, einer C₆-C₆₀ Arylthiogruppe, - Si(Q₁₁)(Q₁₂)(Q₁₃),-N(Q₁₁)(Q₁₂), -B(Q₁₁)(Q₁₂), -C(=O)(Q₁₁), -S(=O)₂(Q₁₁)oder -, P(=O)(Q₁₁)(Q₁₂) oder einer beliebigen Kombination davon ist;
eine C₃-C₆₀ carbocyclische Gruppe, eine C₁-C₆₀ heterocyclische Gruppe, eine C₆-C₆₀ Aryloxygruppe oder eine C₆-C₆₀ Arylthiogruppe, jeweils unsubstituiert oder mit Deuterium substituiert, -F, -Cl, -Br, -I, eine Hydroxylgruppe, eine Cyanogruppe, eine Nitrogruppe, eine C₁-C₆₀ Alkylgruppe, eine C₂-C₆₀ Alkenylgruppe, eine C₂-C₆₀ Alkinylgruppe, eine C₁-C₆₀ Alkoxygruppe, eine C₃-C₆₀ carbocyclische Gruppe, eine C₁-C₆₀ heterocyclische Gruppe, eine C₆-C₆₀ Aryloxygruppe, eine C₆-C₆₀ Arylthiogruppe, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) oder -P(=O)(Q₂₁)(O₂₂) oder eine beliebige Kombination davon ist; oder
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) oder -P(=O)(Q₃₁)(Q₃₂) ist und
wobei Q₁ bis Q₃,Q₁₁ bis Q₁₃,Q₂₁ bis Q₂₃und Q₃₁ bis Q₃₃ jeweils unabhängig voneinander:
Wasserstoff, Deuterium, -F, -Cl, -Br, -I, eine Hydroxylgruppe, eine Cyanogruppe, eine Nitrogruppe, eine C₁-C₆₀ Alkylgruppe, eine C₂-C₆₀ Alkenylgruppe, eine C₂-C₆₀ Alkinylgruppe oder eine C₁-C₆₀ Alkoxygruppe sind; oder
eine C₃-C₆₀ carbocyclische Gruppe, eine C₁-C₆₀ heterocyclische Gruppe, eine C₇-C₆₀ Arylalkylgruppe oder eine C₂-C₆₀ Heteroarylalkylgruppe, jeweils unsubstituiert oder substituiert mit Deuterium, - F , einer Cyanogruppe, einer C₁-C₆₀ Alkylgruppe, einer C₁-C₆₀ Alkoxygruppe, einer Phenylgruppe, einer Biphenylgruppe oder einer beliebigen Kombination davon sind.

10. Kondensierte cyclische Verbindung nach Anspruch 9, wobei:
Y₁ B ist.

11. Kondensierte cyclische Verbindung nach Anspruch 9 oder Anspruch 10, wobei:
(i) Ring CY₁ eine Gruppe ist, die durch die Formel CY1-1 dargestellt wird: 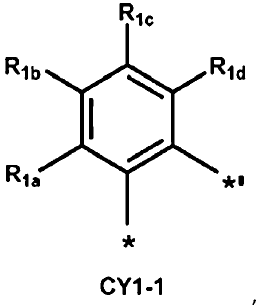 und
wobei in Formel CY1-1,
*eine Bindungsstelle an ein benachbartes N in Formel 1 angibt,
^{*'} eine Bindungsstelle zu einem benachbarten Y₁ in Formel 1 angibt,
R₁ₐ bis R_{1d} jeweils unabhängig voneinander gleich wie in Formel 1 in Bezug auf R₁ beschrieben sind; und/oder
(ii) Ring CY₂ eine Gruppe ist, die durch die Formel CY2-1 dargestellt wird: 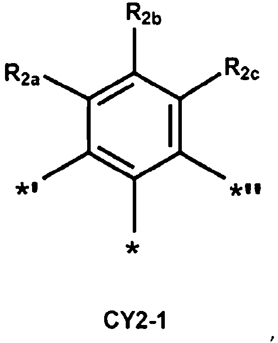 und
wobei in Formel CY2-1
*eine Bindungsstelle an ein benachbartes N in Formel 1 angibt,
^{*'} eine Bindungsstelle zu einem benachbarten Y₁ in Formel 1 angibt,
*" eine Bindungsstelle an ein benachbartes X₁ in Formel 1 angibt,
R₂ₐ bis R_{2c} jeweils unabhängig voneinander gleich wie in Formel 1 in Bezug auf R₂ beschrieben sind.

12. Kondensierte cyclische Verbindung nach einem der Ansprüche 9 bis 11, wobei Ring CY₃ eine Gruppe der Formel CY3-1 ist: 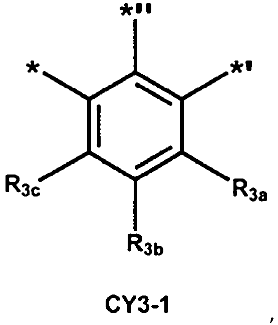 und
wobei in Formel CY3-1
* und *' jeweils unabhängig eine Bindungsstelle für ein benachbartes N in Formel 1 sind,
*" eine Bindungsstelle an ein benachbartes Y₁ in Formel 1 angibt,
R₃ₐ bis R_{3c} jeweils unabhängig voneinander gleich wie in Formel 1 in Bezug auf R₃ beschrieben sind.

13. Kondensierte cyclische Verbindung nach einem der Ansprüche 9 bis 12, wobei eine Summe von a1 bis a3 gleich 1 oder größer ist, und
mindestens eines, ausgewählt aus R₁ bis R₃, durch eine ausgewählte Formel von 2-1 bis 2-4 dargestellt wird: 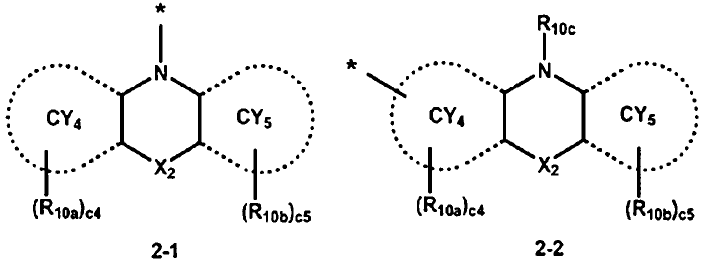 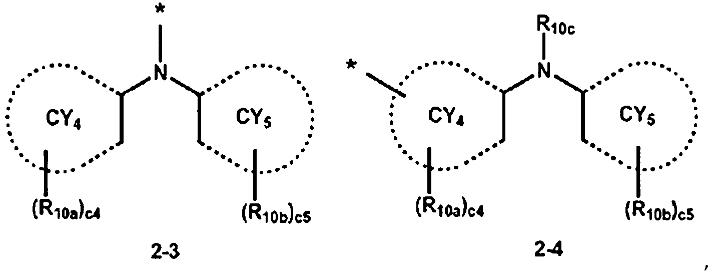 und
wobei in den Formeln 2-1 bis 2-4
X₂ eine Einfachbindung, O, S, Se, C(R₈)(R₉), Si(R₈)(R₉) oder N(R₈) ist,
CY₄ und CY₅ jeweils unabhängig voneinander eine C₅-C₃₀ carbocyclische Gruppe oder eine C₂-C₃₀ heterocyclische Gruppe sind,
c4 und c5 jeweils unabhängig voneinander ganze Zahlen von 0 bis 10 sind,
R_{10b} und R_{10c} jeweils unabhängig voneinander gleich wie in Formel 1 in Bezug auf R₁₀ₐ beschrieben sind,
* eine Bindungsstelle zu einem benachbarten Atom angibt.

14. Kondensierte cyclische Verbindung nach einem der Ansprüche 9 bis 13, wobei R₁₁ bis R₁₅, R₂₁ bis R₂₃ und R₃₁ bis R₃₄ jeweils unabhängig voneinander Folgendes sind:
Wasserstoff, Deuterium, -F, eine Cyanogruppe, eine Methylgruppe, unsubstituiert oder substituiert mit mindestens einem R₁₀ₐR₁₀ₐ, eine Cyclohexylgruppe, unsubstituiert oder substituiert mit mindestens einem R₁₀ₐ, C(Q₁)(Q₂)(Q₃) oder -Si(Q₁)(Q₂)(Q₃ oder
eine Gruppe ist, die durch eine der Formeln 3-1 bis 3-12 dargestellt wird: 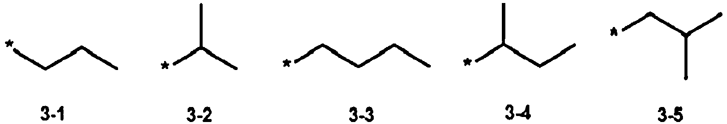 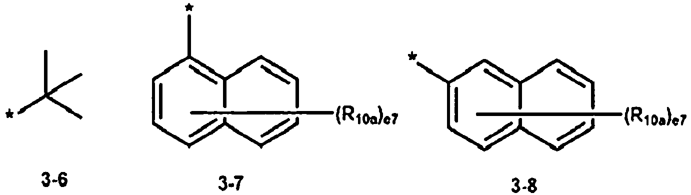 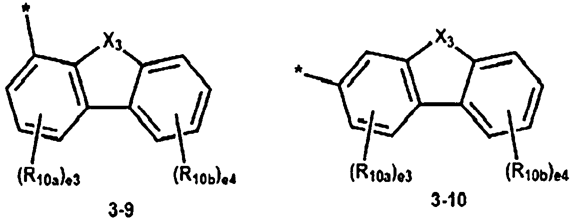 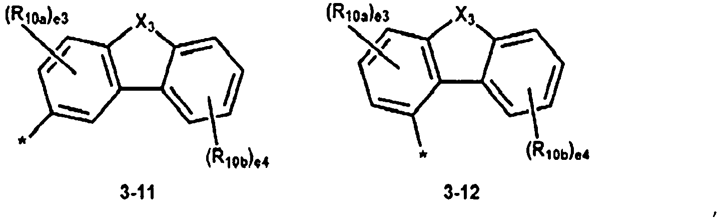 und
wobei in den Formeln 3-1 bis 3-12,
X₃ O oder S ist,
e3 eine ganze Zahl von 0 bis 3 ist,
e4 eine ganze Zahl von 0 bis 4 ist,
e7 eine ganze Zahl von 0 bis 7 ist,
R_{10b} gleich wie in Formel 1 in Bezug auf R₁₀ₐ beschrieben ist und
eine Bindungsstelle zu einem benachbarten Atom angibt.

15. Kondensierte cyclische Verbindung nach Anspruch 9, wobei es sich bei der kondensierten cyclischen Verbindung um eine der Verbindungen 1 bis 68 handelt:

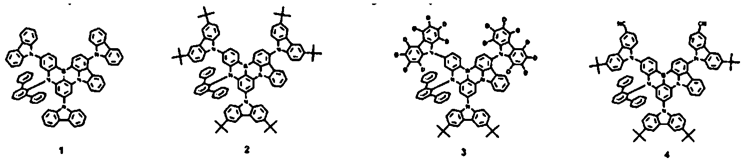

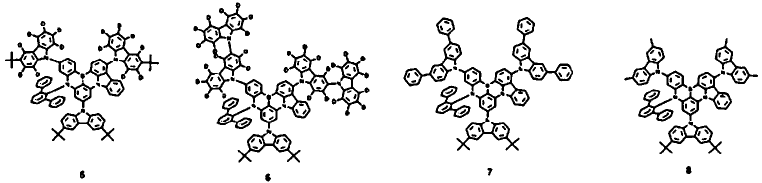

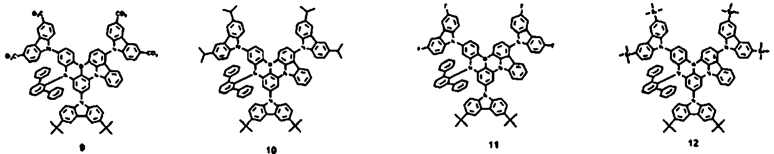

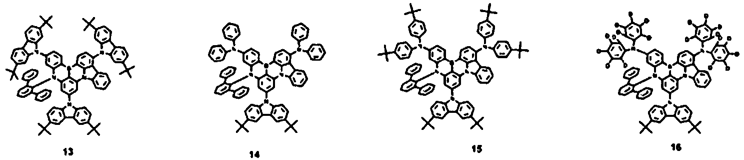

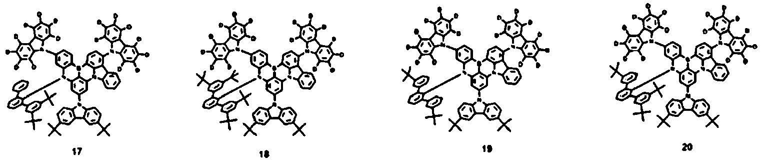

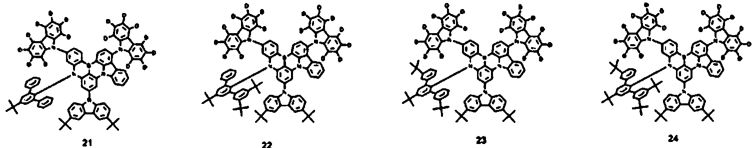

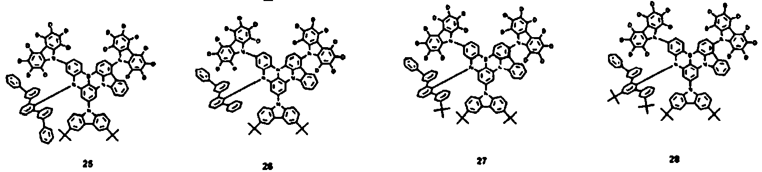

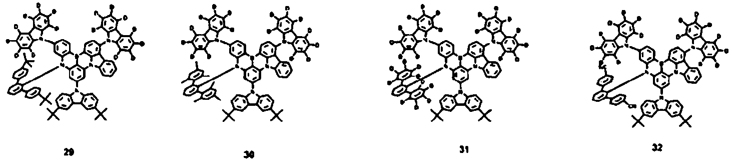

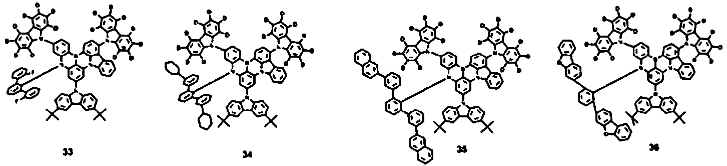

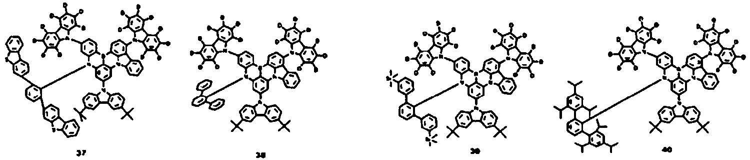

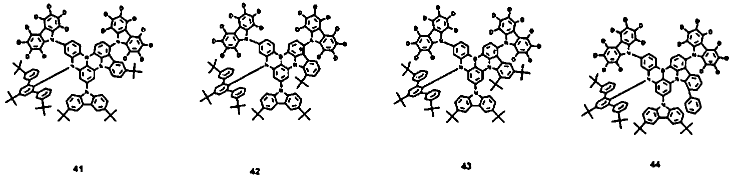

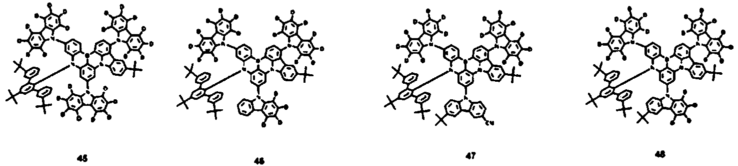

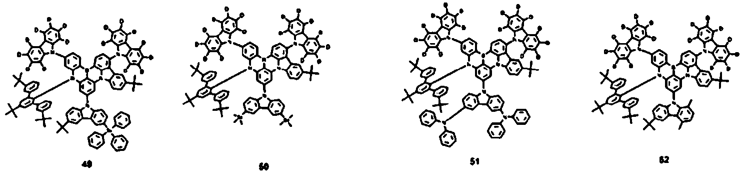

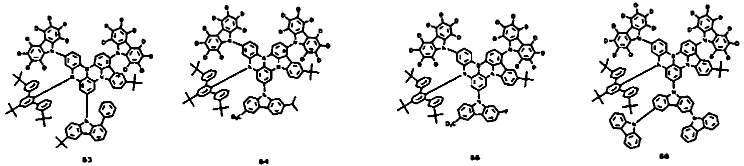

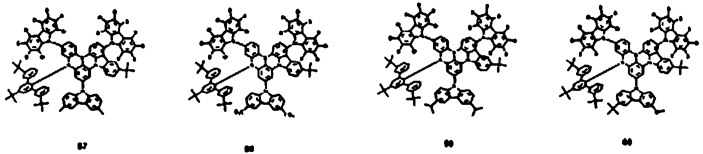

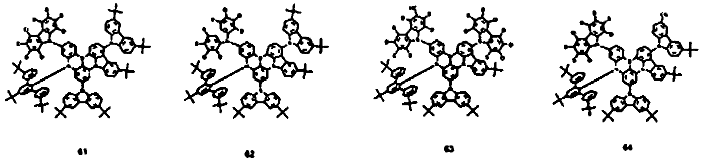

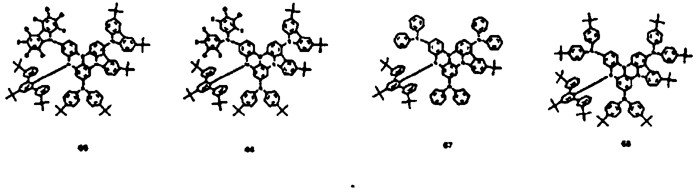

## Revendications

1. Dispositif électroluminescent (10) comprenant :
une première électrode (110) ;
une deuxième électrode (150) face à la première électrode (110) ;
une couche intermédiaire (130) entre la première électrode (110) et la deuxième électrode (150), la couche intermédiaire (130) comprenant une couche émissive ; et
un composé cyclique condensé représenté par la Formule 1 : 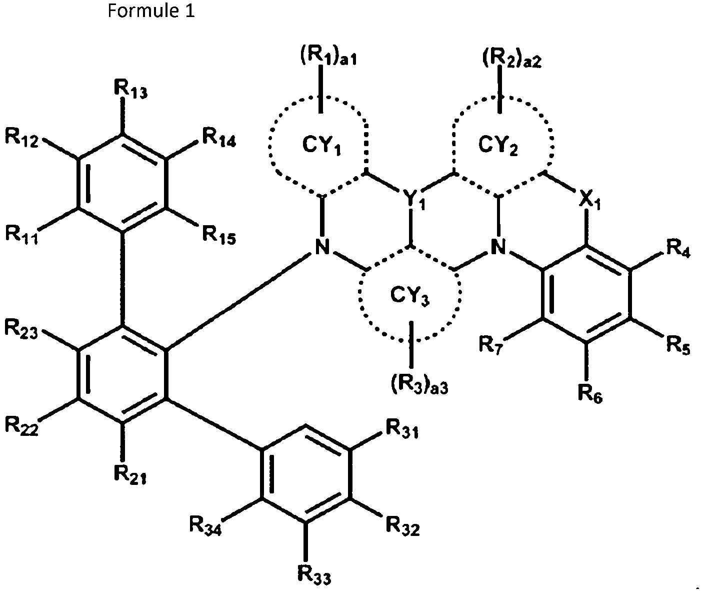
dans lequel, dans la Formule 1,
X₁ est une liaison simple
Y₁ est N, B, P(=O), ou P(=S)
cycle CY₁ à cycle CY₃ sont chacun indépendamment un groupe carbocyclique C₅-C₆₀ ou un groupe hétérocyclique C₂-C₆₀, C₅-C₆₀
a1 à a3 sont chacun indépendamment un entier de 0 à 10,
Les groupes R₁ à R₉, R₁₁ à R₁₅, R₂₁ à R₂₃ et R₃₁ à R₃₄ représentent chacun indépendamment un atome d'hydrogène, un deutérium, -F, -Cl, -Br, -I, un groupe hydroxyle, un groupe cyano, un groupe nitro, un groupe alkyle C₁-C₆₀ non substitué ou substitué par au moins un groupe R₁₀ₐ, un groupe alcényle C₂-C₆₀ non substitué ou substitué par au moins un groupe R₁₀ₐ, un groupe alcynyle C₂-C₆₀ non substitué ou substitué par au moins un groupe R₁₀ₐ, un groupe alcoxy C₁-C₆₀ non substitué ou substitué par au moins un groupe R₁₀ₐ, un groupe alkylthio C₁-C₆₀ non substitué ou substitué par au moins un groupe R₁₀ₐ, un groupe carbocyclique C₃-C₆₀ non substitué ou substitué par au moins un groupe R₁₀ₐ, un groupe hétérocyclique C₁-C₆₀ non substitué ou substitué par au moins un groupe R₁₀ₐ, un groupe aryloxy C₆-C₆₀ non substitué ou substitué. avec au moins un R₁₀ₐ, un groupe arylthio C₆-C₆₀ non substitué ou substitué avec au moins un R₁₀ₐ, -C(Q₁)(Q₂)(Q₃), - Si(Q₁)(Q₂)(Q₃), -N(Q₁)(Q₂), -B(Q₁)(Q₂), -C(=O)(Q₁), -S(=O)₂(Q₁), ou -P(=O)(Q₁)(Q₂),
au moins deux groupes, choisis parmi R₁ à R₉, R₁₁ à R₁₅, R₂₁ à R₂₃ et R₃₁ à R₃₄, sont éventuellement liés l'un à l'autre pour former un groupe carbocyclique C₅-C₃₀ non substitué ou substitué par au moins un R₁₀ₐ ou un groupe hétérocyclique C₂-C₃₀ non substitué ou substitué par au moins un R₁₀ₐ, dans lequel R₃ et R₇ ne sont pas liés l'un à l'autre pour former un groupe carbocyclique C₅-C₃₀ non substitué ou substitué par au moins un R₁₀ₐ ou un groupe hétérocyclique C₂-C₃₀ non substitué ou substitué par au moins un R₁₀ₐ et
R₁₀ₐ est :
un deutérium, -F, -Cl, -Br, -I, un groupe hydroxyle ou un groupe nitro ;
un groupe alkyle C₁-C₆₀, un groupe alcényle C₂-C₆₀, un groupe alcynyle C₂-C₆₀ ou un groupe alcoxy C₁-C₆₀, chacun non substitué ou substitué avec du deutérium, - F, -Cl, -Br, -I, un groupe hydroxyle, un groupe cyano, un groupe nitro, un groupe carbocyclique C₃-C₆₀, un groupe hétérocyclique C₁-C₆₀, un groupe aryloxy C₆-C₆₀, un groupe arylthio C₆-C₆₀, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂) ou toute combinaison de ceux-ci ;
un groupe carbocyclique C₃-C₆₀, un groupe hétérocyclique C₁-C₆₀, un groupe aryloxy C₆-C₆₀ ou un groupe arylthio C₆-C₆₀, chacun non substitué ou substitué par du deutérium, -F, -Cl, -Br, -I, un groupe hydroxyle, un groupe cyano, un groupe nitro, un groupe alkyle C₁-C₆₀, un groupe alcényle C₂-C₆₀, un groupe alcynyle C₂-C₆₀, un groupe alcoxy C₁-C₆₀, un groupe carbocyclique C₃-C₆₀, un groupe hétérocyclique C₁-C₆₀, un groupe aryloxy C₆-C₆₀, un groupe arylthio C₆-C₆₀, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(= O)(Q₂₁)(Q₂₂), ou toute combinaison de ceux-ci ; ou
-Si(Q₃₁)(Q₃₂)(Q₃₃), -N(Q₃₁)(Q₃₂), -B(Q₃₁)(Q₃₂), -C(= O)(Q₃₁), -S(= O)₂(Q₃₁), ou -P(=O)(Q₃₁)(Q₃₂), et
dans lequel Q₁ à Q₃, Q₁₁ à Q₁₃, Q₂₁ à Q₂₃, et Q₃₁ à Q₃₃ sont chacun indépendamment :
un hydrogène, deutérium, -F, -Cl, -Br, -I, un groupe hydroxyle, un groupe cyano, un groupe nitro, un groupe alkyle C₁-C₆₀, un groupe alcényle C₂-C₆₀, un groupe alcynyle C₂-C₆₀ ou un groupe alcoxy C₁-C₆₀ ; ou
un groupe carbocyclique C₃-C₆₀, un groupe hétérocyclique C₁-C₆₀, un groupe arylalkyle C₇-C₆₀ ou un groupe hétéroarylalkyle C₂-C₆₀, chacun non substitué ou substitué avec du deutérium, - F , un groupe cyano, un groupe alkyle C₁-C₆₀, un groupe alcoxy C₁-C₆₀, un groupe phényle, un groupe biphényle ou toute combinaison de ceux-ci.

2. Dispositif électroluminescent (10) selon la revendication 1, dans lequel la couche intermédiaire (130) comprend le composé cyclique condensé représenté par la formule 1.

3. Dispositif électroluminescent (10) selon la revendication 1, dans lequel la couche d'émission comprend le composé cyclique condensé représenté par la formule 1.

4. Dispositif électroluminescent (10) selon l'une quelconque des revendications 1 à 3, dans lequel la couche d'émission comprend un hôte et un dopant, et le dopant comprend le composé cyclique condensé, en option dans lequel l'hôte comprend un premier hôte et un deuxième hôte, et le premier hôte est un hôte de transport d'électrons, et le deuxième hôte est un hôte de transport de trous.

5. Dispositif électroluminescent (10) selon l'une quelconque des revendications 1 à 4, dans lequel :
(i) la couche d'émission comprend en outre un sensibilisateur ; et/ou
(ii) la couche d'émission est configurée pour émettre une lumière bleue présentant une longueur d'onde d'émission maximale dans une plage d'environ 410 nanomètres (nm) à environ 490 nm ; et/ou
(iii) la première électrode (110) est une anode,
la deuxième électrode (150) est une cathode,
la couche intermédiaire (130) comprend en outre une région de transport de trous entre la première électrode (110) et la couche d'émission et une région de transport d'électrons entre la couche d'émission et la deuxième électrode (150),
la région de transport des trous comprend une couche d'injection de trous, une couche de transport de trous, une couche auxiliaire d'émission, une couche de blocage d'électrons, ou toute combinaison de celles-ci, et
la région de transport d'électrons comprend une couche de blocage des trous, une couche de transport d'électrons, une couche d'injection d'électrons, ou toute combinaison de celles-ci.

6. Appareil électronique comprenant le dispositif électroluminescent (10) selon l'une quelconque des revendications 1 à 5.

7. Appareil électronique selon la revendication 6, comprenant en outre :
un transistor à couche mince ; et
un filtre de couleur, une couche de conversion de couleur, une couche tactile, une couche polarisante, ou toute combinaison de ces éléments,
dans lequel le transistor à couche mince comprend une électrode source (260) et une électrode drain (270), et
la première électrode (110) du dispositif électroluminescent (10) est connectée électriquement à l'électrode source (260) ou à l'électrode drain (270) du transistor à couche mince.

8. Équipement électronique comprenant le dispositif électroluminescent (10) selon l'une quelconque des revendications 1 à 7, dans lequel
l'équipement électronique est au moins un élément choisi parmi un écran plat, un écran incurvé, un moniteur d'ordinateur, un moniteur médical, un téléviseur, un panneau publicitaire, un système d'éclairage intérieur ou extérieur, et/ou un feu de signalisation, un affichage tête haute, un écran entièrement ou partiellement transparent, un écran flexible, un écran enroulable, un écran pliable, un écran extensible, une imprimante laser, un téléphone, un téléphone portable, une tablette, une phablette, un assistant numérique personnel (PDA), un appareil portable, un ordinateur portable, un appareil photo numérique, un caméscope, un viseur, un micro-écran, un écran 3D, un écran de réalité virtuelle ou augmentée, un véhicule, un mur vidéo composé de plusieurs écrans assemblés, un écran de théâtre ou de stade, un appareil de photothérapie et une signalétique.

9. Composé cyclique condensé représenté par la formule 1 : 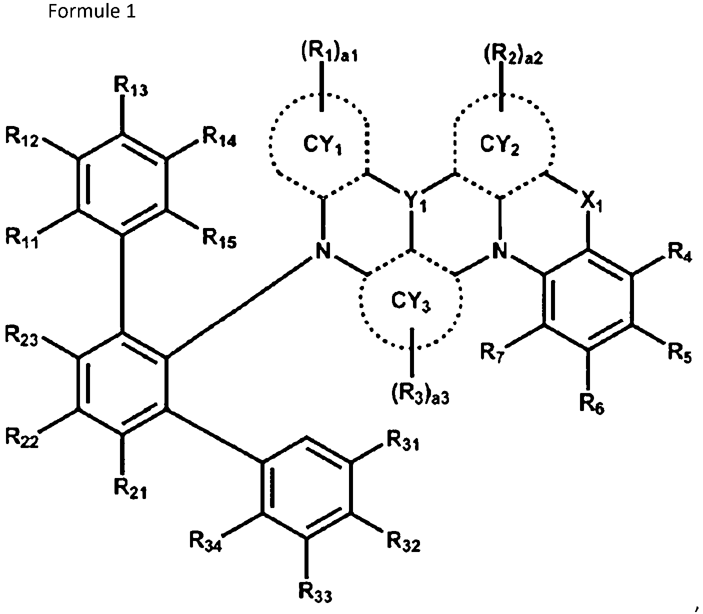
dans lequel, dans la Formule 1,
X₁ est une liaison simple,
Y₁ est N, B, P(=0), ou P(=S),
cycle CY₁ à cycle CY₃ sont chacun indépendamment un groupe carbocyclique C₅-C₆₀ ou un groupe hétérocyclique C₂-C₆₀,
a1 à a3 sont chacun indépendamment un entier de 0 à 10,
R₁ à R₉, R₁₁ à R₁₅, R₂₁ à R₂₃ et R₃₁ à R₃₄ représentent chacun indépendamment un atome d'hydrogène, un deutérium, -F, -Cl, -Br, -I, un groupe hydroxyle, un groupe cyano, un groupe nitro, un groupe alkyle C₁-C₆₀ non substitué ou substitué par au moins un R₁₀ₐ, un groupe alcényle C₂-C₆₀ non substitué ou substitué par au moins un R₁₀ₐ, un groupe alcynyle C₂-C₆₀ non substitué ou substitué par au moins un R₁₀ₐ, un groupe alcoxy C₁-C₆₀ non substitué ou substitué par au moins un R₁₀ₐ, un groupe alkylthio C₁-C₆₀ non substitué ou substitué par au moins un R₁₀ₐ, un groupe carbocyclique C₃-C₆₀ non substitué ou substitué par au moins un R₁₀ₐ, un groupe hétérocyclique C₁-C₆₀ non substitué ou substitué par au moins un R₁₀ₐ, un groupe aryloxy C₆-C₆₀ non substitué ou substitué par au moins un R₁₀ₐ, un groupe arylthio C₆-C₆₀ non substitué ou substitué par au moins un R₁₀ₐ,C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), ou -P(=O)(Q₁)(Q₂),
au moins deux groupes sélectionnés parmi R₁ à R₉, R₁₁ à R₁₅, R₂₁ à R₂₃ et R₃₁ à R₃₄ sont éventuellement liés l'un à l'autre pour former un groupe carbocyclique C₅-C₆₀ non substitué ou substitué par au moins un R₁₀ₐ ou un groupe hétérocyclique C₂-C₃₀ non substitué ou substitué par au moins un R₁₀ₐ, dans lequel R₃ et R₇ ne sont pas liés l'un à l'autre pour former un groupe carbocyclique C₅-C₃₀ non substitué ou substitué par au moins un R₁₀ₐ ou un groupe hétérocyclique C₂-C₃₀ non substitué ou substitué par au moins un R₁₀ₐ, et
R₁₀ₐ est :
un deutérium, -F, -Cl, -Br, -I, un groupe hydroxyle ou un groupe nitro ;
un groupe alkyle C₁-C₆₀, un groupe alcényle C₂-C₆₀, un groupe alcynyle C₂-C₆₀ ou un groupe alcoxy C₁-C₆₀, chacun non substitué ou substitué par du deutérium, -F, -Cl, -Br, -I, un groupe hydroxyle, a, un groupe cyano, un groupe nitro, un groupe carbocyclique C₃-C₆₀, un groupe hétérocyclique C₁-C₆₀, un groupe aryloxy C₆-C₆₀, un groupe arylthio C₆-C₆₀, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) ou -P(=O)(Q₁₁)(Q₁₂), ou toute combinaison de ceux-ci ;
un groupe carbocyclique C₃-C₆₀, un groupe hétérocyclique C₁-C₆₀, un groupe aryloxy C₆-C₆₀ ou un groupe arylthio C₆-C₆₀, chacun non substitué ou substitué par du deutérium, -F, -Cl, -Br, -I, un groupe hydroxyle, un groupe cyano, un groupe nitro, un groupe alkyle C₁-C₆₀, un groupe alcényle C₂-C₆₀, un groupe alcynyle C₂-C₆₀, un groupe alcoxy C₁-C₆₀, un groupe carbocyclique C₃-C₆₀, un groupe hétérocyclique C₁-C₆₀, un groupe aryloxy C₆-C₆₀, un groupe arylthio C₆-C₆₀, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) ou -P(=O)(Q₂₁) (Q₂₂), ou toute combinaison de ceux-ci ; ou
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) ou -P(=O)(Q₃₁)(Q₃₂), et
dans lequel Q₁ à Q₃, Q₁₁ à Q₁₃,Q₂₁ à Q₂₃, et Q₃₁ à Q₃₃ sont chacun indépendamment :
un hydrogène, deutérium, -F, -Cl, -Br, -I, un groupe hydroxyle, un groupe cyano, un groupe nitro, un groupe alkyle C₁-C₆₀, un groupe alcényle C₂-C₆₀, un groupe alcynyle C₂-C₆₀ ou un groupe alcoxy C₁-C₆₀ ; ou
un groupe carbocyclique C₃-C₆₀, un groupe hétérocyclique C₁-C₆₀, un groupe arylalkyle C₇-C₆₀, ou un groupe hétéroarylalkyle C₂-C₆₀, chacun non substitué ou substitué avec du deutérium, - F, un groupe cyano, un groupe alkyle C₁-C₆₀, un groupe alcoxy C₁-C₆₀, un groupe phényle, un groupe biphényle, ou toute combinaison de ceux-ci.

10. Composé cyclique condensé selon la revendication 9, dans lequel :
Y₁ est B.

11. Composé cyclique condensé selon la revendication 9 ou la revendication 10, dans lequel :
(i) le cycle CY₁ est un groupe représenté par la formule CY1-1 : 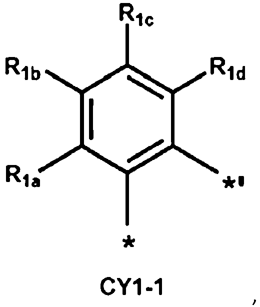 et
dans lequel, dans la formule CY1-1,
* indique un site de liaison à un N adjacent dans la formule 1,
*' indique un site de liaison à un Y₁ adjacent dans la formule 1,
R₁ₐ à R_{1d} sont chacun indépendamment identiques à ce qui est décrit dans la Formule 1 par rapport à R₁ ; et/ou
(ii) le cycle CY₂ est un groupe représenté par la formule CY2-1 : 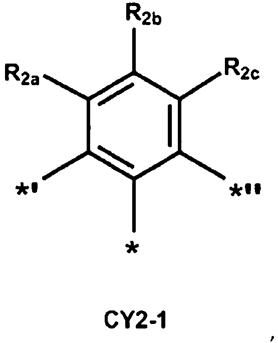 et
dans lequel, dans la formule CY2-1,
* indique un site de liaison à un N adjacent dans la formule 1,
*' indique un site de liaison à un Y₁ adjacent dans la formule 1,
*" indique un site de liaison à un X₁ adjacent dans la formule 1,
R₂ₐ à R_{2c} sont chacun indépendamment identiques à ce qui est décrit dans la formule 1 par rapport à R₂.

12. Composé cyclique condensé selon l'une quelconque des revendications 9 à 11, dans lequel le cycle CY₃ est un groupe représenté par la formule CY3-1 : 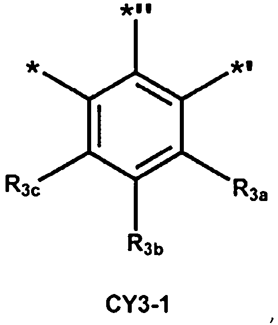 et
dans lequel, dans la formule CY3-1,
* et *' sont chacun indépendamment un site de liaison à un N adjacent dans la formule 1,
*" indique un site de liaison à un Y₁ adjacent dans la formule 1,
R₃ₐ à R_{3c} sont chacun indépendamment identiques à ce qui est décrit dans la formule 1 par rapport à R₃.

13. Composé cyclique condensé selon l'une quelconque des revendications 9 à 12, dans lequel la somme de a1 à a3 est égale ou supérieure à 1, et
au moins une sélectionnée parmi R₁ à R₃ est représentée par une sélectionnée parmi les formules 2-1 à 2-4 : 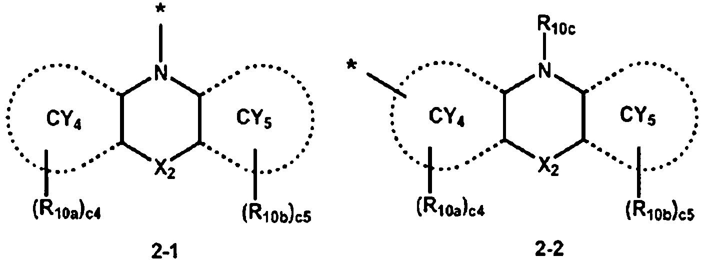 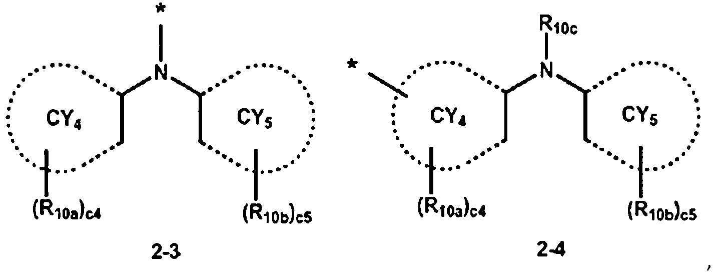 et
dans lequel, dans les formules 2-1 à 2-4,
X₂ est une liaison simple, O, S, Se, C(R₈)(R₉), Si(R₈)(R₉), ou N(R₈),
CY₄ et CY₅ sont chacun indépendamment un groupe carbocyclique C₅-C₃₀ ou un groupe hétérocyclique C₂-C₃₀,
c4 et c5 sont chacun indépendamment un entier compris entre 0 et 10,
R_{10b} et R_{10c} sont chacun indépendamment identiques à ce qui est décrit dans la formule 1 par rapport à R₁₀ₐ,
*indique un site de liaison à un atome adjacent.

14. Composé cyclique condensé selon l'une quelconque des revendications 9 à 13, dans lequel R₁₁ à R₁₅, R₂₁ à R₂₃, et R₃₁ à R₃₄ sont chacun indépendamment :
hydrogène, deutérium, -F, un groupe cyano, un groupe méthyle non substitué ou substitué par au moins un R₁₀ₐ, un groupe cyclohexyle non substitué ou substitué par au moins un R₁₀ₐ, un groupe phényle non substitué ou substitué par au moins un R₁₀ₐ, C(Q₁)(Q₂)(Q₃), ou -Si(Q₁)Q₂)Q₃) ; ou
un groupe représenté par l'une des formules 3-1 à 3-12 : 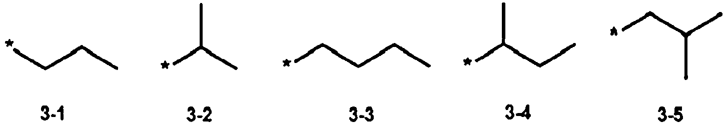 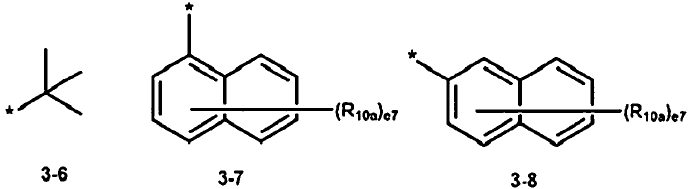 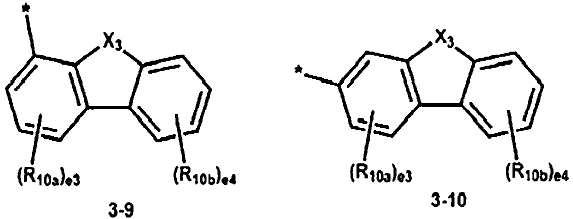 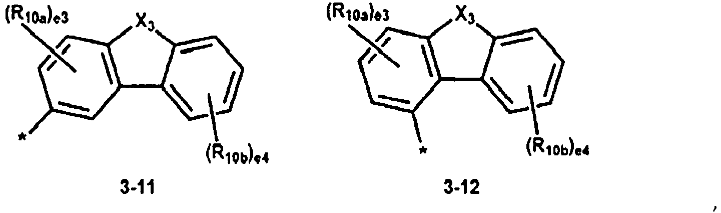 et
dans lequel, dans les formules 3-1 à 3-12,
X₃ est O ou S,
e3 est un entier compris entre 0 et 3,
e4 est un entier compris entre 0 et 4.
e7 est un entier compris entre 0 et 7,
R_{10b} est identique à ce qui est décrit dans la Formule 1 par rapport à R₁₀ₐ, et
indique un site de liaison avec un atome adjacent.

15. Composé cyclique condensé selon la revendication 9, dans lequel le composé cyclique condensé est choisi parmi les composés 1 à 68 :
